(19) Europäisches Patentamt / European Patent Office / Office européen des brevets

(11) EP 3 432 375 B1

(12) **EUROPEAN PATENT SPECIFICATION**

(45) Date of publication and mention of the grant of the patent:
**29.12.2021 Bulletin 2021/52**

(21) Application number: **17766700.3**

(22) Date of filing: **14.03.2017**

(51) Int Cl.:
***H01L 51/30*** *(2006.01)* ***C08G 61/12*** *(2006.01)*

(86) International application number:
**PCT/JP2017/010282**

(87) International publication number:
**WO 2017/159703 (21.09.2017 Gazette 2017/38)**

(54) **ORGANIC SEMICONDUCTOR COMPOSITION, METHOD FOR MANUFACTURING ORGANIC THIN FILM TRANSISTOR, AND ORGANIC THIN FILM TRANSISTOR**

ORGANISCHE HALBLEITERZUSAMMENSETZUNG, VERFAHREN ZUR HERSTELLUNG EINES ORGANISCHEN DÜNNSCHICHTTRANSISTORS UND ORGANISCHER DÜNNSCHICHTTRANSISTOR

COMPOSITION SEMI-CONDUCTRICE ORGANIQUE, PROCÉDÉ DE FABRICATION DE TRANSISTOR À COUCHE MINCE ORGANIQUE, ET TRANSISTOR À COUCHE MINCE ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **16.03.2016 JP 2016052066**

(43) Date of publication of application:
**23.01.2019 Bulletin 2019/04**

(73) Proprietor: **FUJIFILM Corporation**
**Tokyo 106-8620 (JP)**

(72) Inventors:
- **GOTO, Takashi**
  **Ashigarakami-gun**
  **Kanagawa 258-8577 (JP)**
- **YAMAMOTO, Yosuke**
  **Ashigarakami-gun**
  **Kanagawa 258-8577 (JP)**
- **WATANABE, Tetsuya**
  **Ashigarakami-gun**
  **Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:
**EP-A1- 2 109 161**
**WO-A1-2006/019133**
**WO-A1-2011/161078**
**WO-A1-2016/148169**
**JP-A- 2007 335 840**
**JP-A- 2009 177 135**
**JP-A- 2015 050 231**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 432 375 B1

## Description

### BACKGROUND OF THE INVENTION

1. Field of the Invention

The present invention relates to an organic semiconductor composition, a method of manufacturing an organic thin film transistor, and an organic thin film transistor.

2. Description of the Related Art

A minute transistor is integrated as a switching element in a display such as a liquid crystal display and an organic electroluminescent display, and a logic circuit such as a radio frequency identifier (RFID: RF tags) and a memory. An organic thin film transistor (field effect transistor) using an organic semiconductor compound in a semiconductor layer may be light-weight, the cost may be reduced due to the application of a printing process to the manufacturing thereof, and flexibility is also excellent. Therefore, the organic thin film transistor is attracting attention as a next-generation transistor in place of a transistor having a silicon-based semiconductor layer and has been developed.

Improvement of carrier mobility becomes an important factor in an increase in the performance of the organic thin film transistor. In a case where the carrier mobility is increased, switching may be performed in an electric field in a small area at a high speed, and thus it becomes possible to realize the improvement of the processing speed and lower power consumption. In order to realize the improvement in mobility, the chemical structure of the organic semiconductor used for the organic semiconductor layer has been studied. For example, JP2013-181071A discloses that an organic thin film transistor having the high carrier mobility may be obtained by using a polymer compound having at least two repeating units which includes an aromatic ring having a specific condensed polycyclic structure in a semiconductor active layer.

EP 2 109 161 A1 describes thin film transistors having a semiconducting that comprises a semiconducting polymer and insulating polymer, along with methods for forming and using such thin-film transistors.

WO 2011/161078 Aldescribes a semiconductor device, e.g. an organic field effect transistor, comprising a layer comprising a polymer comprising repeating units having a diketopyrrolopyrrole skeleton (DPP polymer) and an acceptor compound having an electron affinity in vacuum of 4.6 eV, or more.

### SUMMARY OF THE INVENTION

However, recently, further improvement of the carrier mobility is required according to the high resolution of a display and the high speed of a logic circuit.

An object of the present invention is to provide an organic semiconductor composition in which by being used in the forming of an organic semiconductor layer (semiconductor active layer) of an organic thin film transistor, the carrier mobility of the obtained organic thin film transistor may be increased to a desired level. Another object of the present invention is to provide an organic thin film transistor having excellent carrier mobility and a manufacturing method thereof.

In view of the above, the present inventors diligently conducted research and have found that, in a case where an organic semiconductor layer of an organic thin film transistor is formed with an organic semiconductor polymer having a specific structure, an insulating polymer of which a molecular weight has a specific relationship with a molecular weight of the organic semiconductor polymer is caused to be copresent at a specific ratio with respect to an amount of this organic semiconductor polymer, such that the carrier mobility of the obtained organic thin film transistor may be effectively increased, and performances of the transistor may be increased. In view of the above, the present inventors are further conducted research so as to complete the present invention.

The above objects of the present invention have been achieved by the following means.

[1] An organic semiconductor composition comprising the following (a) to (c):

(a) an organic semiconductor polymer having a weight-average molecular weight of 2,000 or more;
(b) an insulating polymer having a weight-average molecular weight of 2,000 or more; and
(c) a solvent,

in which a weight-average molecular weight Mw1 of the organic semiconductor polymer and a weight-average molecular weight Mw2 of the insulating polymer satisfy a relational expression below,

$$0.1 \leq Mw1 / Mw2 \leq 10$$

a content C1 mass% of the organic semiconductor polymer and a content C2 mass% of the insulating polymer in the organic semiconductor composition satisfy a relational expression below, and

$$0.1 \leq C1 / C2 \leq 10$$

the organic semiconductor polymer has a structural unit represented by Formula (1), and preferably has a structural unit represented by any one of Formula (2) to (5),

$$-(D-A)- \qquad (1)$$

in Formula (1), D represents a group having an aromatic heterocyclic ring having a monocyclic structure or a condensed polycyclic structure which has at least one atom selected from a nitrogen atom, an oxygen atom, a sulfur atom, and a selenium atom as a ring-constituting atom or a group having a condensed polycyclic aromatic hydrocarbon ring, and preferably represents a group represented by Formula (D-1),

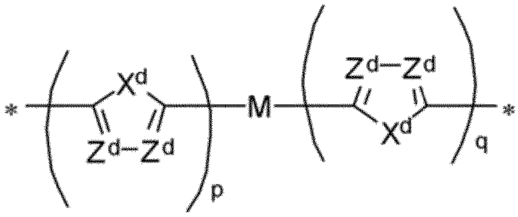

(D-1)

in Formula (D-1),

$X^d$ represents an oxygen atom, a sulfur atom, a selenium atom, or $NR^{D1}$, and $R^{D1}$ represents an organic group,
$Z^d$ represents a nitrogen atom or $CR^{D2}$, and $R^{D2}$ represents a hydrogen atom or an organic group,
M is a single bond or represents an aromatic heterocyclic group, an aromatic hydrocarbon group, an alkenylene group, an alkynylene group, or a divalent group obtained by combining two or more of these groups,
p and q each represent an integer of 0 to 4, and
* represents a bonding site to be incorporated into the structural unit represented by Formula (1), and

A represents a group having a structure represented by any one of Formulae (A-1) to (A-12),

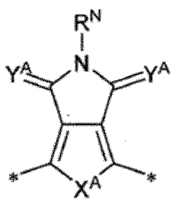

(A-1)

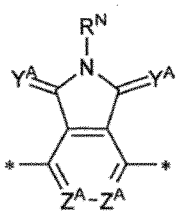

(A-2)

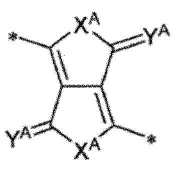

(A-3)

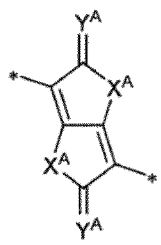

(A-4)

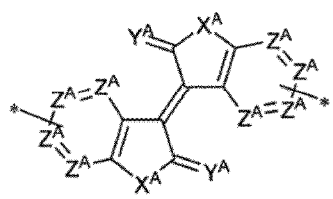

(A-5)

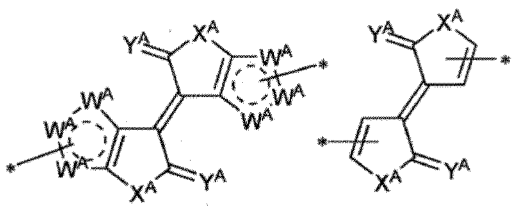

(A-6) (A-7)

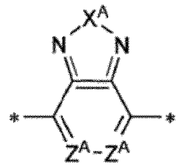

(A-8)

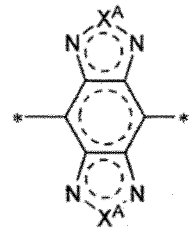

(A-9)

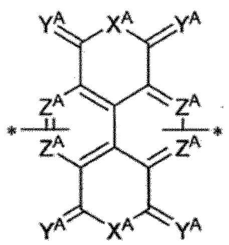

(A-10)

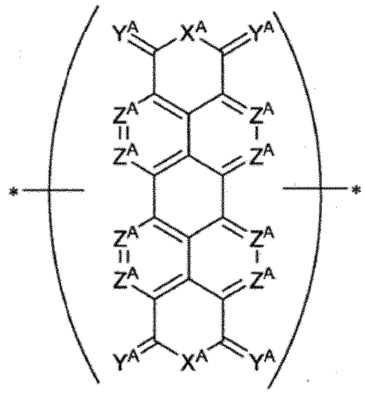

(A-11)

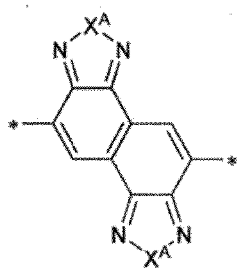

(A-12)

in Formulae (A-1) to (A-12),

$X^A$ represents an oxygen atom, a sulfur atom, a selenium atom, or $NR^X$, and $R^N$ and $R^X$ each represent an alkyl group that may include at least one of -O-, -S-, or -$NR^{A3}$- in a carbon chain or a group represented by Formula (1-1),
$Y^A$ represents an oxygen atom or a sulfur atom,
$Z^A$ represents $CR^{A2}$ or a nitrogen atom,
$W^A$ represents $C(R^{A2})_2$, $NR^{A1}$, a nitrogen atom, $CR^{A2}$, an oxygen atom, a sulfur atom, or a selenium atom, $R^{A1}$ represents an alkyl group that may include at least one of -O-, -S-, or -$NR^{A3}$- in a carbon chain, a group represented by Formula (1-1), or a single bond, $R^{A2}$ represents a hydrogen atom, a halogen atom, an alkyl group that may include at least one of -O-, -S-, or -$NR^{A3}$- in a carbon chain, or a single bond, and $R^{A3}$ represents a hydrogen atom or a substituent, and

* represents a bonding site to be incorporated into A of Formula (1),

$$* — L_a — Ar \left( L_b \right)_l \qquad (1\text{-}1)$$

in Formula (1-1),

$L_a$ represents an alkylene group having 1 to 20 carbon atoms that may include at least one of -O-, -S-, or -$NR^{1S}$- in a carbon chain,
Ar represents an aromatic heterocyclic group or an aromatic hydrocarbon group having 6 to 18 carbon atoms,
$L_b$ represents an alkyl group having 1 to 100 carbon atoms that may include at least one of -O-, -S-, or -$NR^{2s}$- in the carbon chain,
$R^{1S}$ and $R^{2S}$ represent a hydrogen atom or a substituent,
1 is an integer of 1 to 5, and
* represents a bonding site,

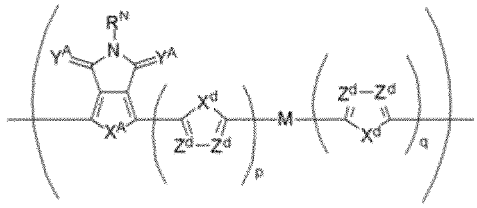 (2)

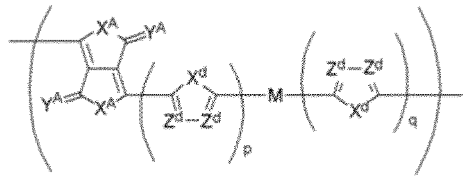 (3)

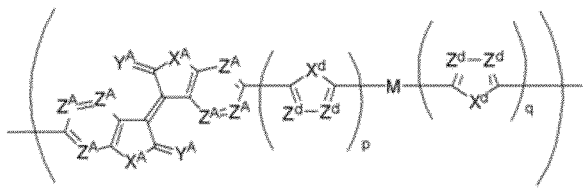 (4)

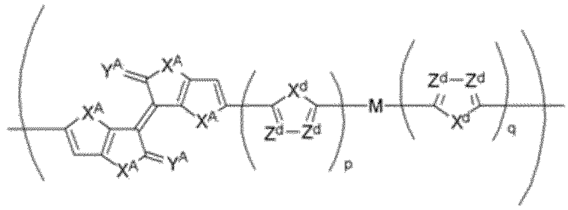 (5)

in Formulae (2) to (5),

$R^N$, $X^A$, $Y^A$, and $Z^A$ respectively have the same meaning as $R^N$, $X^A$, $Y^A$, and $Z^A$ described in Formulae (A-1) to (A-12), and
$X^d$, $Z^d$, M, p, and q respectively have the same meaning as $X^d$, $Z^d$, M, p, and q described in Formula (D-1).

[2] The organic semiconductor composition according to [1], in which the insulating polymer has a structural unit represented by Formula (I-1),

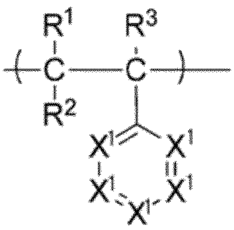 (I-1)

in Formula (I-1),

$R^1$ to $R^3$ each represent a hydrogen atom or a substituent,
$X^1$ represents $CR^{A4}$ or a nitrogen atom, and
$R^{A4}$ represents a hydrogen atom or a substituent.

[3] The organic semiconductor composition according to [2], in which a portion or all of the structural unit represented by Formula (I-1) included in the insulating polymer is a structural unit represented by Formula (1-2),

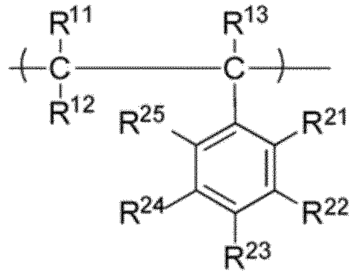

(I-2)

in Formula (I-2),

$R^{11}$ to $R^{13}$ each represent a hydrogen atom or an alkyl group, and
$R^{21}$ to $R^{25}$ each represent a hydrogen atom, a hydroxy group, an alkyl group, an alkenyl group, an alkynyl group, a cycloalkyl group, an aryl group, an aralkyl group, or a fluorine atom.

[4] The organic semiconductor composition according to [2] or [3], in which an absolute value of a difference between a solubility parameter of the structural unit represented by Formula (1) and a solubility parameter of a structural unit represented by Formula (I-1) is 5.0 $MPa^{1/2}$ or less.
[5] The organic semiconductor composition according to any one of [1] to [4], in which a solubility parameter of the solvent in the organic semiconductor composition is 15.0 to 30.0 $MPa^{1/2}$.
[6] The organic semiconductor composition according to any one of [1] to [5], in which in a case where a viscosity of the organic semiconductor composition is set as p1, a viscosity of the composition having the composition excluding the insulating polymer from the organic semiconductor composition is set as p2, p1 / p2 < 5 is satisfied.
[7] A method of manufacturing an organic thin film transistor, comprising: forming an organic semiconductor layer by using the organic semiconductor composition according to any one of [1] to [6], and preferably comprising exposing a film formed by using the organic semiconductor composition according to any one of claims 1 to 6 to a temperature higher than a glass transition temperature of the insulating polymer in the composition so as to form the organic semiconductor layer.
[8] The method of manufacturing an organic thin film transistor according to [7], in which the organic semiconductor layer is formed on a gate insulating layer having a surface energy of 50 mN/m to 75 mN/m.
[9] A bottom gate-type organic thin film transistor,

in which an organic semiconductor layer of the organic thin film transistor contains the following (a) and (b):

(a) an organic semiconductor polymer having a weight-average molecular weight of 2,000 or more; and
(b) an insulating polymer having a weight-average molecular weight of 2,000 or more, and

a weight-average molecular weight Mw1 of the organic semiconductor polymer and a weight-average molecular weight Mw2 of the insulating polymer satisfy a relational expression below,

$$0.1 \leq Mw1 / Mw2 \leq 10$$

a content C3 mass% of the organic semiconductor polymer and a content C4 mass% of the insulating polymer in the organic semiconductor layer satisfy a relational expression below, and

$$0.1 \leq C3 / C4 \leq 10$$

the organic semiconductor polymer has a structural unit represented by Formula (1), and preferably has a structural unit represented by any one of Formula (2) to (5),

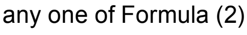

(1)

in Formula (1), D represents a group having an aromatic heterocyclic ring having a monocyclic structure or a condensed polycyclic structure which has at least one atom selected from N, O, S, and Se as a ring-constituting atom or a group having a condensed polycyclic aromatic hydrocarbon ring, and preferably represents a group represented by Formula (D-1),

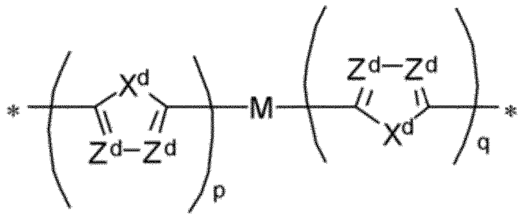 (D-1)

in Formula (D-1),

$X^d$ represents an oxygen atom, a sulfur atom, a selenium atom, or $NR^{D1}$, and $R^{D1}$ represents an organic group,
$Z^d$ represents a nitrogen atom or $CR^{D2}$, and $R^{D2}$ represents a hydrogen atom or an organic group,
M is a single bond or represents an aromatic heterocyclic group, an aromatic hydrocarbon group, an alkenylene group, an alkynylene group, or a divalent group obtained by combining two or more of these groups,
p and q each represent an integer of 0 to 4, and
* represents a bonding site to be incorporated into the structural unit represented by Formula (1), and
A represents a group having a structure represented by any one of Formulae (A-1) to (A-12),

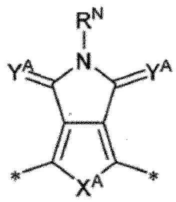
(A-1)

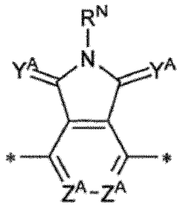
(A-2)

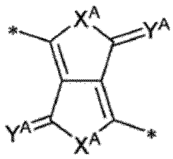
(A-3)

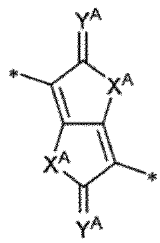
(A-4)

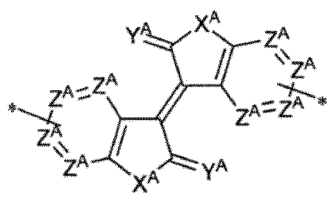
(A-5)

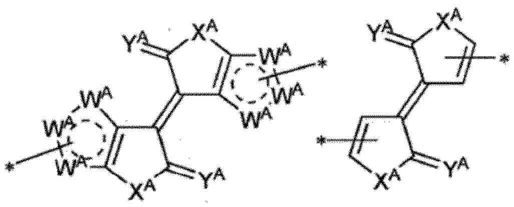
(A-6) (A-7)

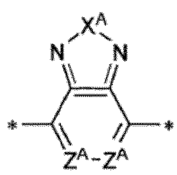
(A-8)

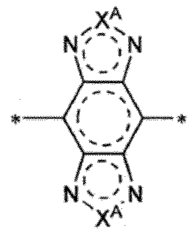
(A-9)

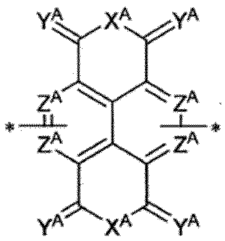

(A-10)

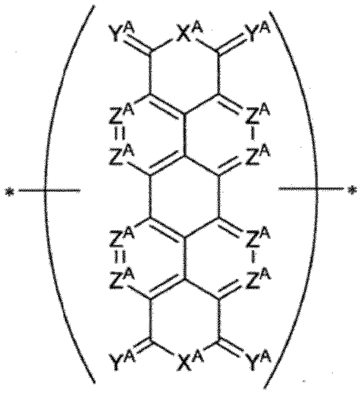

(A-11)

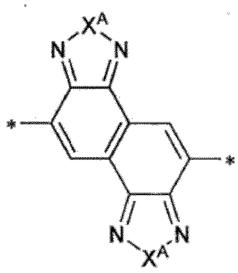

(A-12)

in Formulae (A-1) to (A-12),

$X^A$ represents an oxygen atom, a sulfur atom, a selenium atom, or $NR^X$, and $R^N$ and $R^X$ each represent an alkyl group that may include at least one of -O-, -S-, or $-NR^{A3}-$ in a carbon chain or a group represented by Formula (1-1),
$Y^A$ represents an oxygen atom or a sulfur atom,
$Z^A$ represents $CR^{A2}$ or a nitrogen atom,
$W^A$ represents $C(R^{A2})_2$, $NR^{A1}$, a nitrogen atom, $CR^{A2}$, an oxygen atom, a sulfur atom, or a selenium atom, $R^{A1}$ represents an alkyl group that may include at least one of -O-, -S-, or $-NR^{A3}-$ in a carbon chain, a group represented by Formula (1-1), or a single bond, $R^{A2}$ represents a hydrogen atom, a halogen atom, an alkyl group that may include at least one of -O-, -S-, or $-NR^{A3}-$ in a carbon chain, or a single bond, and $R^{A3}$ represents a hydrogen atom or a substituent, and

* represents a bonding site to be incorporated into A of Formula (1),

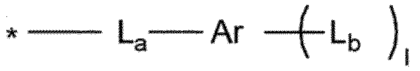

(1-1)

in Formula (1-1),

$L_a$ represents an alkylene group having 1 to 20 carbon atoms that may include at least one of -O-, -S-, or $-NR^{1S}-$ in a carbon chain,
Ar represents an aromatic heterocyclic group or an aromatic hydrocarbon group having 6 to 18 carbon atoms,
$L_b$ represents an alkyl group having 1 to 100 carbon atoms that may include at least one of -O-, -S-, or $-NR^{2S}-$ in a carbon chain,
1 is an integer of 1 to 5, and
* represents a bonding site,

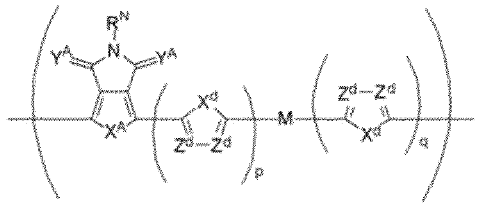

(2)

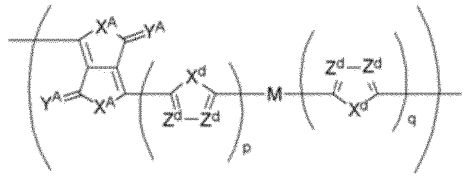

(3)

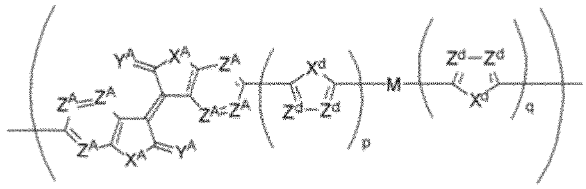

(4)

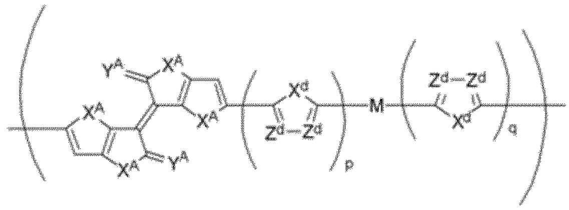

(5)

in Formulae (2) to (5),

$R^N$, $X^A$, $Y^A$, and $Z^A$ respectively have the same meaning as $R^N$, $X^A$, $Y^A$, and $Z^A$ described in Formulae (A-1) to (A-12), and

$X^d$, $Z^d$, M, p, and q respectively have the same meaning as $X^d$, $Z^d$, M, p, and q described in Formula (D-1).

[10] The bottom gate-type organic thin film transistor according to [9], in which the insulating polymer has a structural unit represented by Formula (I-1),

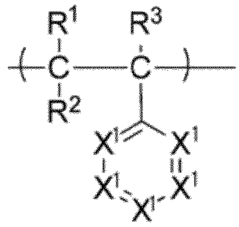

(I-1)

in Formula (I-1),

$R^1$ to $R^3$ each represent a hydrogen atom or a substituent,
$X^1$ represents $CR^{A4}$ or a nitrogen atom, and
$R^{A4}$ represents a hydrogen atom or a substituent.

[11] The bottom gate-type organic thin film transistor according to [10], in which a portion or all of the structural unit represented by Formula (I-1) included in the insulating polymer is a structural unit represented by Formula (I-2),

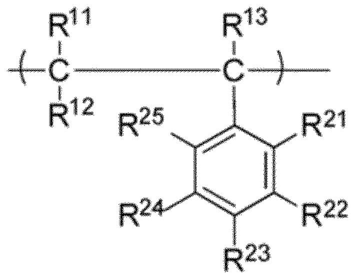

(I-2)

in Formula (1-2),

$R^{11}$ to $R^{13}$ each represent a hydrogen atom or an alkyl group, and
$R^{21}$ to $R^{25}$ each represent a hydrogen atom, a hydroxy group, an alkyl group, an alkenyl group, an alkynyl group, a cycloalkyl group, an aryl group, an aralkyl group, or a fluorine atom.

[12] The bottom gate-type organic thin film transistor according to [10] or [11], in which an absolute value of a difference between a solubility parameter of the structural unit represented by Formula (1) and a solubility parameter of a structural unit represented by Formula (I-1) is 5.0 $MPa^{1/2}$ or less.
[13] The bottom gate-type organic thin film transistor according to any one of [9] to [12], in which in a case where a surface free energy of the organic semiconductor polymer is set as $\gamma 1$ and a surface free energy of the insulating polymer is set as $\gamma 2$, $\gamma 1 \leq \gamma 2$ is satisfied.
[14] The bottom gate-type organic thin film transistor according to any one of [9] to [13], in which, in a case where, at an upper half of the organic semiconductor layer, a content of the organic semiconductor polymer is set as UC1 mass% and a content of the insulating polymer is set as UC2 mass%, and
at a lower half of the organic semiconductor layer, a content of the organic semiconductor polymer is set as LC1 mass% and a content of the insulating polymer is set as LC2 mass%, UC1, UC2, LC1, and LC2 satisfy (UC1 / UC2) > (LC1 / LC2).
[15] The bottom gate-type organic thin film transistor according to any one of [9] to [14], in which a surface energy of a gate insulating layer of the bottom gate-type organic thin film transistor is 50 mN/m to 75 mN/m.

With respect to the organic semiconductor composition of the present invention, by being used in the forming of the organic semiconductor layer of the organic thin film transistor, the carrier mobility of the obtained organic thin film transistor may be effectively increased. The organic thin film transistor of the present invention has excellent carrier mobility. According to the method of manufacturing the organic thin film transistor of the present invention, it is possible to obtain an organic thin film transistor of which carrier mobility is effectively increased.
The above and other characteristics and advantages of the present invention may become more clear from the following description appropriately referring to the accompanying drawings.

## BRIEF DESCRIPTION OF THE DRAWINGS

Fig. 1 is a schematic cross-sectional view illustrating an aspect of a bottom gate-bottom contact-type organic thin film transistor element which is an example of a semiconductor element of the present invention.
Fig. 2 is a schematic cross-sectional view illustrating an aspect of a bottom gate-top contact-type organic thin film transistor element which is an example of the semiconductor element of the present invention.
Fig. 3 is a schematic cross-sectional view illustrating another aspect of the bottom gate-top contact-type organic thin film transistor element which is an example of the semiconductor element of the present invention.
Fig. 4 is a schematic cross-sectional view illustrating another aspect of the bottom gate-bottom contact-type organic thin film transistor element which is an example of the semiconductor element of the present invention.

## DESCRIPTION OF THE PREFERRED EMBODIMENTS

In the present specification, the numerical range expressed by using "to" means a range including numerical values described before and after "to" as a lower limit value and an upper limit value.
In the present specification, the expression of a compound includes the compound itself, a salt thereof, and an ion thereof A portion of the structure may be changed without deteriorating the desired effect.

A compound which is not explicitly described as substituted or unsubstituted includes those having a random substituent without deteriorating the desired effect. The same is also applied to a substituent, a linking group, and the like (hereinafter, referred to as a substituent and the like).
In the present specification, in a case where there are a plurality of substituents or the like represented by a specific symbol, or in a case where a plurality of substituents and the like are simultaneously defined, unless described otherwise, respective substituents and the like may be identical to or different from each other. The same is also applied to the definition of the number of substituents or the like. In a case where a plurality of substituents and the like are near (particularly, adjacent to each other), unless described otherwise, the substituents and the like may be connected to each other to form a ring.
In the present specification, in a case where a plurality of structural units represented by the same indication in the polymer are present, the respective structural units present in the polymer may be identical to or different from each other.
In a case where the number (also referred to as a carbon number) of carbon atoms of the group is limited, the number of the carbon atoms of the group means the total number of carbon atoms including the substituent, unless described otherwise.
In the present invention, in the case where the group can form an acyclic skeleton and a cyclic skeleton, unless described otherwise, the group includes an acyclic skeleton group and a cyclic skeleton group. For example, the alkyl group includes a linear alkyl group, a branched alkyl group, and a cyclic (cyclo) alkyl group. In a case where the group can form a cyclic skeleton, the lower limit of the number of atoms of the group forming the cyclic skeleton is 3 or more and preferably 5 or more, regardless of the lower limit of the number of atoms specifically described for this group.
The preferable embodiment of the present invention is described below.

[Organic semiconductor composition]

An organic semiconductor composition (hereinafter, simply referred to as a "composition of the present invention") of the present invention contains (a) to (c) below. In addition to (a) to (c) below, the composition of the present invention may contain various additives.

(a) Organic semiconductor polymer having a weight-average molecular weight of 2,000 or more
(b) Insulating polymer having a weight-average molecular weight of 2,000 or more
(c) Solvent

With respect to the organic semiconductor polymer (a) and the insulating polymer (b), molecular weights thereof and the contents thereof in the composition have specific relationships described below.
The components (a) to (c) are described in order.

<(a) Organic semiconductor polymer having weight-average molecular weight of 2,000 or more>

The organic semiconductor polymer of the component (a) has a structural unit represented by Formula (1).

$$-\left( D-A \right)- \qquad (1)$$

In Formula (1), D represents a group having an aromatic heterocyclic ring having a monocyclic structure or a condensed polycyclic structure which has at least one atom selected from N, O, S, or Se as a ring-constituting atom or a group having a condensed polycyclic aromatic hydrocarbon ring. D preferably has a donor structural unit (electron donor unit) as a relationship with A. In contrast, A is preferably an acceptor structural unit (electron acceptor unit) as a relationship with D.
Hereinafter, an aromatic heterocyclic ring having a monocyclic structure may also be referred to as a "monocyclic aromatic heterocyclic ring". An aromatic heterocyclic ring having the condensed polycyclic structure may be also referred to as a "condensed polycyclic aromatic heterocyclic ring".
In a case where D is a group having an aromatic heterocyclic ring, this aromatic heterocyclic ring preferably has at least one S as a ring-constituting atom. In a case where D has an aromatic heterocyclic ring, D is preferably a group obtained by linking a monocyclic aromatic heterocyclic ring via a single bond or a divalent linking group or a group obtained by linking a monocyclic aromatic heterocyclic ring and a condensed polycyclic aromatic heterocyclic ring via a single bond or a divalent linking group. The divalent linking group is preferably a conjugated chain, more preferably an ethenylene group, an arylene group, or a heteroarylene group, or a combination of two or more of these groups. In a case where the divalent linking group is a combination of two or more selected from an ethenylene group, an arylene

group, and a heteroarylene group, a combination of an arylene group (preferably a phenylene group or a naphthylene group) and ethenylene is preferable. The number (the number of aromatic heterocyclic rings of condensed polycyclic aromatic heterocyclic rings is 1) of the aromatic heterocyclic rings forming D is preferably 2 or more, more preferably 2 to 6, and even more preferably 2 to 4. In a case where the number of the aromatic heterocyclic rings forming D is 1, the aromatic heterocyclic ring is preferably a condensed polycyclic aromatic heterocyclic ring.

In a case where the aromatic heterocyclic ring forming D is a monocyclic aromatic heterocyclic ring, the aromatic heterocyclic ring is preferably a 5-membered ring or a 6-membered ring, more preferably a 5-membered ring, even more preferably a thiophene ring or a furan ring, and particularly preferably a thiophene ring. In a case where the aromatic heterocyclic ring forming D is a condensed polycyclic aromatic heterocyclic ring, the monocyclic structure forming this condensed polycyclic aromatic heterocyclic ring is preferably a 5-membered ring or a 6-membered ring and more preferably a 5-membered ring. In a case where the aromatic heterocyclic ring forming D is a condensed polycyclic aromatic heterocyclic ring, a bicyclic aromatic heterocyclic ring is preferable.

The aromatic heterocyclic ring forming D may be an aspect having a substituent, and examples of the substituent (hereinafter, referred to as a "substituent $D^{S1}$") includes an alkyl group, an alkenyl group, an alkynyl group, an aromatic hydrocarbon group, an aromatic heterocyclic group, a halogen atom, and a group represented by Formula (1-1).

The alkyl group employed as the substituent $D^{S1}$ may be linear, branched, or cyclic. The number of carbon atoms of this alkyl group is preferably 1 to 30 and more preferably 1 to 20. This alkyl group may be combined with a group selected from -O-, -S-, and $-NR^{D3}-$ in a carbon chain of the alkyl group and may be combined with -O-, -S-, and $-NR^{D3}-$ to a terminal on a bonding site side of the alkyl group. $R^{D3}$ has the same meaning as $R^{1S}$ described below, and the preferable aspect thereof is also the same.

The alkenyl group or the alkynyl group employed as the substituent $D^{S1}$ may be linear or branched. The number of carbon atoms of this alkenyl group is preferably 2 to 30 and more preferably 2 to 20.

The number of carbon atoms of the aromatic hydrocarbon group employed as the substituent $D^{S1}$ is preferably 6 to 30.

The aromatic heterocyclic group employed as the substituent $D^{S1}$ is preferably a monocyclic aromatic heterocyclic group and more preferably a monocyclic aromatic heterocyclic group of a 5 to 7-membered ring. This aromatic heterocyclic group preferably has a heteroatom selected from O, N, S, and Se as a ring-constituting heteroatom.

The halogen atom employed as the substituent $D^{S1}$ is F, Cl, Br, or I, more preferably F or Cl, and particularly preferably F.

The group represented by Formula (1-1) employed as the substituent $D^{S1}$ is a group having a structure below.

$$* \text{—} L_a \text{—} Ar \text{—}\left( L_b \right)_l \qquad (1\text{-}1)$$

In Formula (1-1), $L_a$ represents an alkylene group. This alkylene group represents an alkylene group having 1 to 20 carbon atoms that may include at least one of -O-, -S-, or $-NR^{1S}-$in the carbon chain.

According to the present invention, the expression "the alkylene group includes -O- in a carbon chain" means that an aspect in which -O- is introduced in the middle of a carbon-carbon bond of the alkylene group, an aspect in which -O- is introduced to one end or both ends of the alkylene group, and an aspect in which -O- is introduced in the middle of a carbon-carbon bond of the alkylene group and to one end or both ends of the alkylene group. A case of including -S- or $-NR^{1S}-$ in the alkylene group has the same meaning. In a case where the alkylene group includes -O-, -S-, and $-NR^{1S}-$, the sum of these numbers is at least one, and the upper limit thereof is not particularly limited but is 5.

The alkylene group employed as $L_a$ may be linear, branched, or cyclic, but is preferably a linear or branched alkylene group. In view of the carrier mobility, the number of carbon atoms of this alkylene group is preferably 1 to 15 and more preferably 1 to 10.

In a case where the alkylene group employed as $L_a$ is branched, the number of carbon atoms of the branched portion includes the number of carbon atoms of the alkylene group represented by $L_a$. Here, $L_a$ includes $-NR^{1S}-$, and in a case where this $R^{1S}$ includes a carbon atom, the number of carbon atoms of $R^{1S}$ does not include the number of carbon atoms of the alkylene group employed as $L_a$.

Ar represents an aromatic heterocyclic group or an aromatic hydrocarbon group having 6 to 18 carbon atoms.

The aromatic heterocyclic group employed as Ar may be a monocyclic group or may be a group of a condensed ring of two or more rings and is preferably a monocyclic ring in view of carrier mobility. In a case of a monocyclic group, the number of the ring members is preferably 5 to 7 members. The ring-constituting heteroatom included in the aromatic heterocyclic group is preferably a nitrogen atom, an oxygen atom, a sulfur atom, or a selenium atom and more preferably a sulfur atom.

The aromatic hydrocarbon group having 6 to 18 carbon atoms employed as Ar is not particularly limited, and examples thereof include a benzene ring group, a naphthalene ring group, or a group obtained by removing two or more

hydrogen atoms from aromatic hydrocarbon (for example, a fluorene ring) condensed with three or more rings. Among these groups, in view of excellent carrier mobility, a benzene ring group or a naphthalene ring group is preferable, and a benzene ring group is preferable.

$L_b$ represents an alkyl group. This alkyl group may include at least one -O-, -S-, or -$NR^{2S}$- in the carbon chain.

In the present invention, the expression "the alkyl group includes -O- in a carbon chain" means an aspect in which -O- is introduced in the middle of a carbon-carbon bond of the alkyl group, an aspect in which -O- is introduced at a terminal of the alkyl group on a bonding site side, and an aspect in which -O- is introduced in the middle of a carbon-carbon bond of the alkyl group and at a terminal of the alkyl group on a bonding site side. A case of including -S- or -$NR^{2S}$- in the alkyl group has the same meaning. In a case where the alkyl group includes -O-, -S-, and -$NR^{2S}$-, the number thereof is at least one, and the upper limit is not particularly limited but is 5.

The alkyl group employed as $L_b$ may be linear, branched, or cyclic. However, in view of carrier mobility, the alkyl group is preferably a linear or branched alkyl group and more preferably a branched alkyl group. This alkyl group may be a halogenated alkyl group having a halogen atom (preferably a fluorine atom, a chlorine atom, a bromine atom, or an iodine atom, more preferably a fluorine atom) as a substituent.

The number of carbon atoms of the alkyl group employed as $L_b$ is 1 to 100 and preferably 9 to 100.

In a case where the group represented by Formula (1-1) has a plurality of $L_b$'s, in view of carrier mobility, at least one $L_b$ is preferably the alkyl group having 9 to 100 carbon atoms, more preferably the alkyl group having 20 to 100 carbon atoms, and even more preferably the alkyl group having 20 to 40 carbon atoms.

In a case where the alkyl group employed as $L_b$ is branched, the number of carbon atoms of the branched portion is included in the number of carbon atoms of the alkyl group employed as $L_b$. Here, $L_b$ includes -$NR^{2S}$-, and this $R^{2S}$ includes a carbon atom, the number of carbon atoms of $R^{2S}$ is not included in the number of carbon atoms of the alkyl group employed as $L_b$.

$R^{1S}$ and $R^{2S}$ represent a hydrogen atom or a substituent. The substituent employed as $R^{1S}$ and $R^{2S}$ is not particularly limited, and examples thereof include an alkyl group (preferably a linear or branched alkyl group having 1 to 10 carbon atoms), a halogen atom (a fluorine atom, a chlorine atom, a bromine atom, or an iodine atom), or an aryl group (preferably an aryl group having 6 to 20 carbon atoms). Among these, $R^{1S}$ and $R^{2S}$ are preferably a hydrogen atom or an alkyl group and more preferably an alkyl group.

The position of Ar (a ring-constituting atom) to which $L_b$ is bonded is not particularly limited. For example, with respect to Ar, 2 to 4-positions (in a case where a ring-constituting atom to which $L_a$ is bonded is a 1-position) to $L_a$ are preferable, and it is more preferable that at least one $L_b$ is bonded to a 4-position.

1 is an integer of 1 to 5 and preferably 1 or 2. In a case where 1 is 2 or more, a plurality of $L_b$'s may be identical to or different from each other.

In Formula (1-1), * represents a bonding site.

In a case where D in Formula (1) is a group having a condensed polycyclic aromatic hydrocarbon ring, the number of carbon atoms of this condensed polycyclic aromatic hydrocarbon ring is preferably 10 to 20. Preferable examples of the condensed polycyclic aromatic hydrocarbon ring include a fluorene ring, a naphthalene ring, or a tricyclic or tetracyclic condensed polycyclic aromatic hydrocarbon ring, and among these, a fluorene ring, a naphthalene ring, an anthracene ring, a phenanthrene ring, a chrysene ring, or a pyrene ring is preferable.

In a case where D is a group having a condensed polycyclic aromatic hydrocarbon ring, the number of condensed polycyclic aromatic hydrocarbon rings in D is preferably 1 to 6, more preferably 1 to 4, even more preferably is 1 or 2, and particularly preferably 1.

D is even more preferably a group consisting of the condensed polycyclic aromatic hydrocarbon ring (that is, a condensed polycyclic aromatic hydrocarbon group).

The aromatic hydrocarbon group may be an aspect having a substituent and examples of the substituent (hereinafter, referred to as a "substituent $D^{S2}$") includes an alkyl group, a halogen atom, and a group represented by Formula (1-1). Preferable aspects of the alkyl group, the halogen atom, and the group represented by Formula (1-1) which are employed as the substituent $D^{S2}$ are respectively the same as the preferable aspects of the alkyl group, the halogen atom, and the group represented by Formula (1-1) which are employed as the substituent $D^{S1}$.

D in Formula (1) is more preferably a group represented by Formula (D-1).

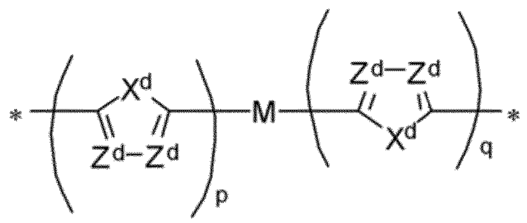

(D-1)

In Formula (D-1), * represents a bonding site to be incorporated into the structural unit of Formula (1). $X^d$ represents O, S, Se, or $NR^{D1}$, preferably represents O, S, or Se, and more preferably S.

$R^{D1}$ represents an organic group. This organic group is preferably a group represented by Formula (1-1). $R^{D1}$ is more preferably an alkyl group (this alkyl group may include at least one of -O-, -S-, or $-NR^{D3}-$ ($R^{D3}$ is the same as $R^{1S}$ above, and the preferable aspect thereof is also the same) in a carbon chain; the number of carbon atoms of this alkyl group is preferably 1 to 30 and more preferably 1 to 20), an alkynyl group (the number of carbon atoms thereof is preferably 1 to 30) an alkenyl group (the number of carbon atoms thereof is preferably 2 to 30), an aromatic hydrocarbon group (the number of carbon atoms thereof is preferably 6 to 30), an aromatic heterocyclic group (a 5 to 7-membered ring is preferable; the ring-constituting heteroatom is preferably O, N, S, or Se), a halogen atom (F, Cl, Br, or I, more preferably F or Cl, and particularly preferably F), or a group represented by Formula (1-1), and more preferably an alkyl group, a halogen atom, or a group represented by Formula (1-1).

$Z^d$ represents a nitrogen atom or $CR^{D2}$, and preferably $CR^{D2}$. $R^{D2}$ represents a hydrogen atom or an organic group. This organic group is also preferably a group represented by Formula (1-1). $R^{D2}$ is more preferably a hydrogen atom, an alkyl group (this alkyl group may include at least one of -O-, -S-, or $-NR^{D3}-$ ($R^{D3}$ is the same as $R^{1S}$, and the preferable aspect thereof is also the same) in a carbon chain; the number of carbon atoms of this alkyl group is preferably 1 to 30 and more preferably 1 to 20), an alkynyl group (the number of carbon atoms thereof is preferably 2 to 30), an alkenyl group (the number of carbon atoms thereof is preferably 2 to 30), an aromatic hydrocarbon group (the number of carbon atoms thereof is preferably 6 to 30), an aromatic heterocyclic group (a 5 to 7-membered ring is preferable; the ring-constituting heteroatom is preferably O, N, S, or Se), a halogen atom (F, Cl, Br, or I, more preferably F or Cl, and particularly preferably F), or a group represented by Formula (1-1), and more preferably a hydrogen atom, an alkyl group, a halogen atom, or a group represented by Formula (1-1).

M is a single bond or represents an aromatic heterocyclic group, an aromatic hydrocarbon group, an alkenylene group, an alkynylene group, or a divalent group obtained by combining these groups.

In Formula (D-1), the structural unit in parenthesis and M above are rotatably bonded to each other about the bonding axis.

The aromatic heterocyclic group employed as M may be monocyclic or polycyclic. Examples of the aromatic heterocyclic ring forming the aromatic heterocyclic group include a group consisting of a monocyclic aromatic heterocyclic ring or a condensed polycyclic aromatic heterocyclic ring forming D above.

The aromatic hydrocarbon group employed as M is preferably an aromatic hydrocarbon group having 6 to 20 carbon atoms. The aromatic hydrocarbon ring forming the aromatic hydrocarbon group is more preferably an aromatic hydrocarbon ring condensed with three or four rings of a benzene ring, a biphenylene ring, a fluorene ring, a naphthalene ring, or other rings, and even more preferably a fluorene ring, a naphthalene ring, an anthracene ring, a phenanthrene ring, a chrysene ring, or a pyrene ring.

The aromatic heterocyclic group or aromatic hydrocarbon group employed as M may be an aspect having a substituent, and examples of the substituent include an alkyl group (this alkyl group may include at least one of -O-, -S-, or $-NR^{D3}-$ ($R^{D3}$ is the same as $R^{1S}$, and the preferable aspect thereof is also the same) in a carbon chain), a halogen atom (F, Cl, Br, or I, more preferably F or Cl, and particularly preferably F), and a group represented by Formula (1-1).

An alkenylene group employed as M is preferably an alkenylene group having 2 to 10 carbon atoms, more preferably an alkenylene group having 2 to 4 carbon atoms, and even more preferably an ethenylene group.

An alkynylene group employed as M is preferably an alkynylene group having 2 to 10 carbon atoms, more preferably an alkynylene group having 2 to 4 carbon atoms, and even more preferably an ethynylene group.

p and q are each an integer of 0 to 4, preferably an integer of 1 to 3, and more preferably an integer of 1 to 2. It is preferable that p and q have the same value. It is preferable that p + q is 2 to 4.

In a case where p + q is 0, M has a monocyclic or polycyclic aromatic heterocyclic ring which has at least one heteroatom selected from N, O, S, and Se as a ring-constituting atom or preferably has a condensed polycyclic aromatic hydrocarbon ring.

Examples of the structure of D forming the structural unit of Formula (1) are provided below, but the present invention is not limited to the following examples. In the structural formula, a hydrogen atom may be substituted with an alkyl group (this alkyl group may include at least one -O-, -S-, or $-NR^{D3}-$in the carbon chain; $R^{D3}$ has the same meaning as $R^{1S}$ described above, and the preferable aspect thereof is also the same; the number of carbon atoms of this alkyl group is preferably 1 to 30 and more preferably 1 to 20), an alkenyl group, an alkynyl group, an aromatic hydrocarbon group, an aromatic heterocyclic group, a halogen atom, or a group represented by Formula (1-1). * represents a bonding site to be incorporated into the structural unit of Formula (1).

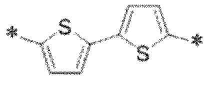 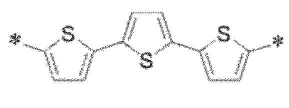 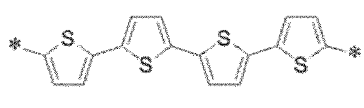

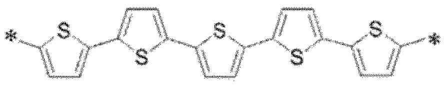
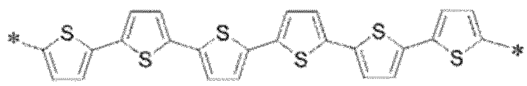

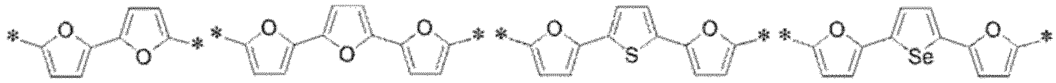

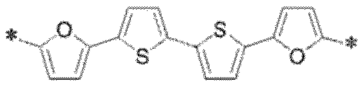
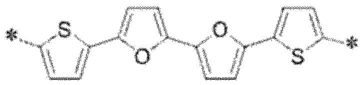

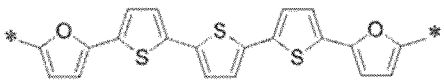
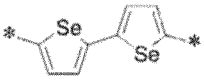
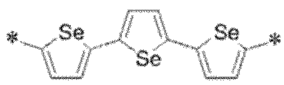

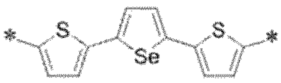
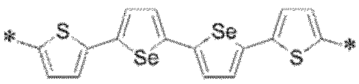
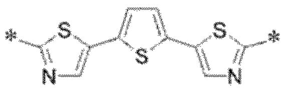

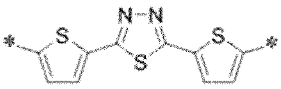
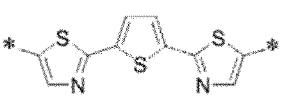
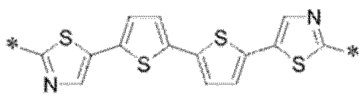

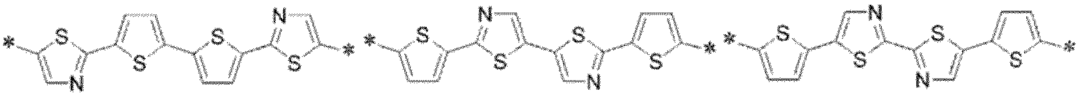

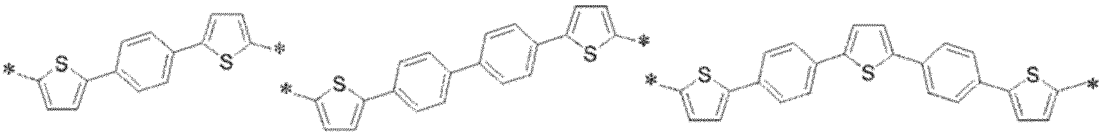

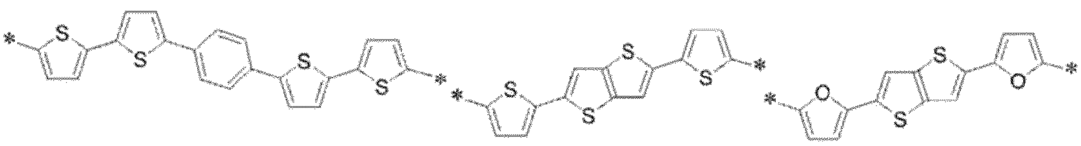

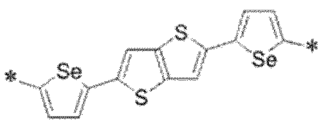
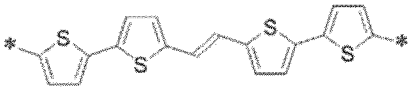

A in Formula (1) represents an aromatic heterocyclic group represented by any one of Formulae (A-1) to (A-12). In respective formulae below, * represents a bonding site to another group forming a structural unit represented by Formula (1).

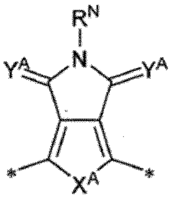

(A-1)

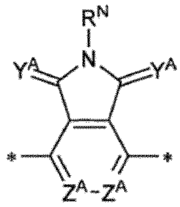

(A-2)

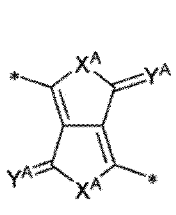

(A-3)

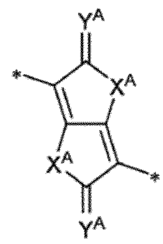

(A-4)

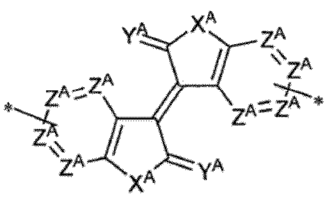

(A-5)

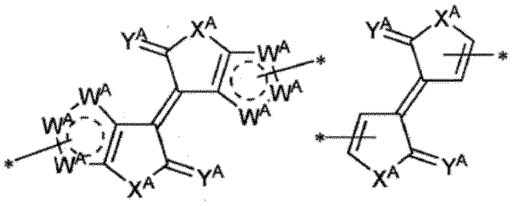

(A-6)

(A-7)

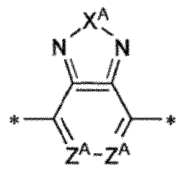

(A-8)

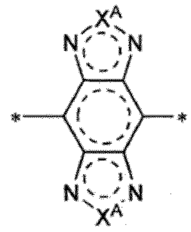

(A-9)

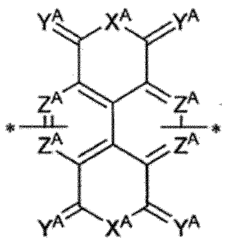

(A-10)

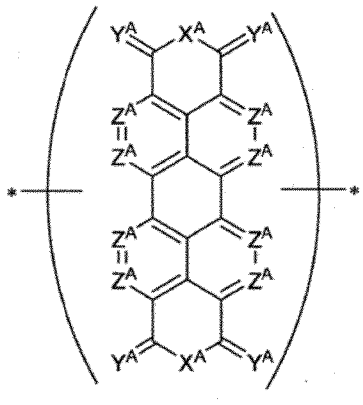

(A-11)

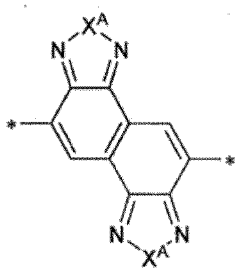

(A-12)

In Formulae (A-6) and (A-9), a round broken line in the 5-membered ring indicates that the 5-membered ring is an aromatic ring.

In Formulae (A-1) to (A-12), $X^A$ represents an oxygen atom, a sulfur atom, a selenium atom, or $NR^X$, and a sulfur atom or $NR^X$ is preferable.

$R^N$ and $R^X$ each represent an alkyl group or a group represented by Formula (1-1). The alkyl group employed as $R^N$ and $R^X$ has the same meaning as the alkyl group employed as $R^{A1}$ below, and the preferable range is also the same. The alkyl group employed as $R^N$ and $R^X$ may include at least one of -O-, -S-, or $-NR^{A3}-$, in the carbon chain in the same manner as $R^{A1}$ below.

$Y^A$ represents an oxygen atom or a sulfur atom, and is preferably an oxygen atom.

$Z^A$ represents $CR^{A2}$ or a nitrogen atom, and $CR^{A2}$ is preferable.

$R^{A2}$ represents a hydrogen atom, a halogen atom, an alkyl group (this alkyl group may include at least one of -O-, -S-, or $-NR^{A3}-$ in a carbon chain), or a single bond. The expression "$R^{A2}$ is a single bond" means that $R^{A2}$ becomes a bonding site of another structure.

$R^{A2}$ is preferably a hydrogen atom or a single bond.

In a case where $R^{A2}$ is a halogen atom, $R^{A2}$ is a fluorine atom, a chlorine atom, a bromine atom, or an iodine atom, and a fluorine atom is preferable. In a case where $R^{A2}$ is the alkyl group, an alkyl group having 2 to 35 carbon atoms is preferable, an alkyl group having 8 to 25 carbon atoms is more preferable. The alkyl group may be linear or branched. $R^{A3}$ represents a hydrogen atom or a substituent. The substituent employed as $R^{A3}$ is not particularly limited, and has the same meaning as the substituent in $R^{1S}$ and $R^{2S}$ above, and the preferable range is also the same.

In $CR^{A2}$, in a case where $R^{A2}$ is a single bond, a C atom of $CR^{A2}$ is a bonding site (represented by * in each formula) in Formulae (A-5), (A-10), and (A-11).

Specifically, in Formulae (A-5) and (A-10), in a ring structure including $Z^A$, one $Z^A$ is $CR^{A2}$, and $R^{A2}$ thereof

becomes a single bond. $CR^{A2}$ (carbon atom) having this single bond becomes a bonding site represented by * in each formula. In Formula (A-11), two of eight $Z^{A'}{}_S$ are $CR^{A2}$, and $R^{A2}$ thereof becomes a single bond. $CR^{A2}$ (carbon atom) having the single bond becomes a bonding site represented by * in Formula (A-11).

$W^A$'s each independently and preferably represent $C(R^{A2})_2$, $NR^{A1}$, a nitrogen atom, $CR^{A2}$, an oxygen atom, a sulfur atom, or a selenium atom, $C(R^{A2})_2$, $CR^{A2}$, or a sulfur atom, and more preferably $CR^{A2}$ or a sulfur atom.

$R^{A1}$ represents an alkyl group (this alkyl group may include at least one of -O-, -S-, or $-NR^{A3}-$ in a carbon chain), a group represented by Formula (1-1), or a single bond. $R^{A1}$ is preferably an alkyl group or a group represented by Formula (1-1).

The alkyl group employed as $R^{A1}$ may be linear or branched. The number of carbon atoms of the alkyl group is preferably 2 to 35 and more preferably 8 to 25.

$R^{A2}$ and $R^{A3}$ in $W^A$ are the same as $R^{A2}$ and $R^{A3}$ in $Z^A$, respectively, and preferable examples thereof are also the same.

In Formula (A-6), in each of the two ring structures including $W^A$, one $W^A$ is any one aspect of Aspects 1 to 3 below, and is preferably Aspect 1.

Aspect 1: $W^A$ is $CR^{A2}$, and $R^{A2}$ thereof is a single bond.
Aspect 2: $W^A$ is $NR^{A1}$, and $R^{A1}$ thereof is a single bond.
Aspect 3: $W^A$ is $C(R^{A2})_2$, and any one of $R^{A2}$ thereof is a single bond, and the other is a hydrogen atom, a halogen atom, or the alkyl group.

In each form, $CR^{A2}$ (carbon atom), $NR^{A1}$ (nitrogen atom), or $C(R^{A2})_2$ (carbon atom) becomes a bonding site (represented by * in the formula) in Formula (A-6) having a single bond.

A is preferably an aromatic heterocyclic group represented by Formulae (A-1) to (A-6), (A-8) to (A-10), or (A-12) among Formulae (A-1) to (A-12), more preferably an aromatic heterocyclic group represented by Formulae (A-1), (A-3), (A-4), (A-6), or (A-8), and even more preferably an aromatic heterocyclic group represented by Formula (A-3).

Examples of the aromatic heterocyclic group represented by any one of Formulae (A-1) to (A-12) are provided below, but the present invention is not limited thereto. In the aromatic heterocyclic group below, $R^N$, $R^X$, and * are as described above.

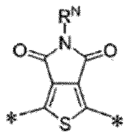
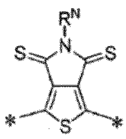
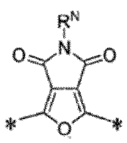
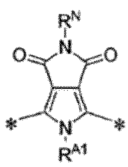
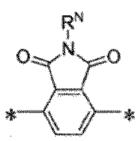
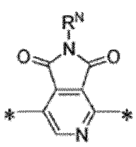
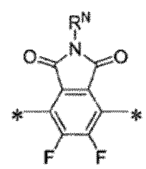

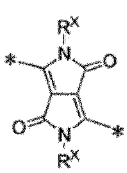
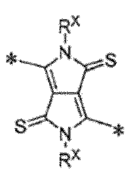
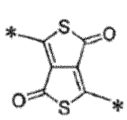
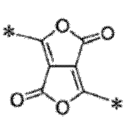
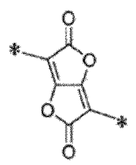
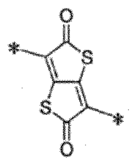
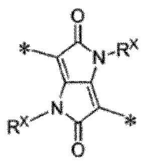

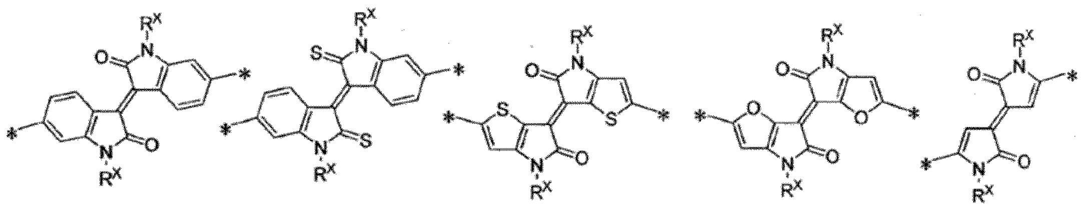

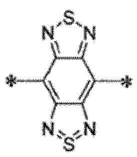

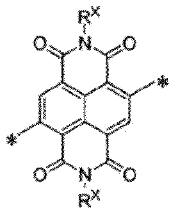

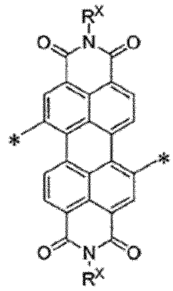

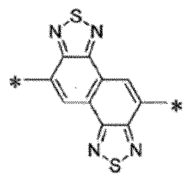

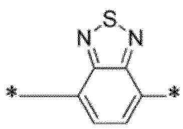

The structural unit represented by Formula (1) is preferably a structural unit represented by any one of Formulae (2) to (5).

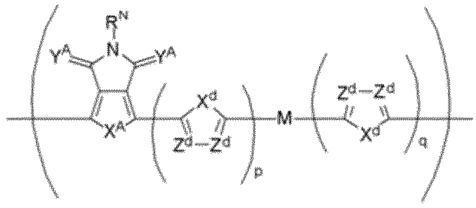
(2)

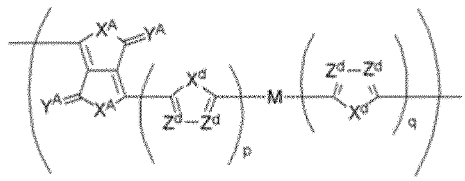
(3)

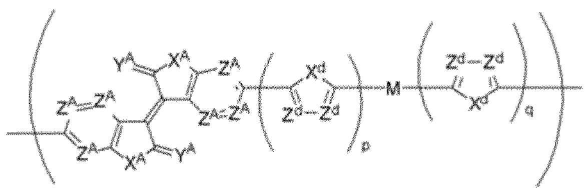
(4)

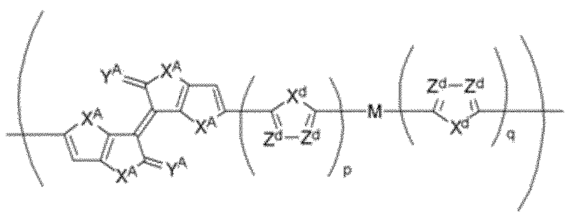
(5)

In Formulae (2) to (5),

$R^N$, $X^A$, $Y^A$, and $Z^A$ respectively have the same meaning as $R^N$, $X^A$, $Y^A$, and $Z^A$ described in Formulae (A-1) to (A-12). $X^d$, $Z^d$, M, p, and q respectively have the same meaning as $X^d$, $Z^d$, M, p, and q described in Formula (D-1).

Specific examples of the structural unit represented by Formula (1) are provided below and in examples, but the present invention is not limited thereto.

m : n in the example compound represents a molar ratio of a repeating unit.

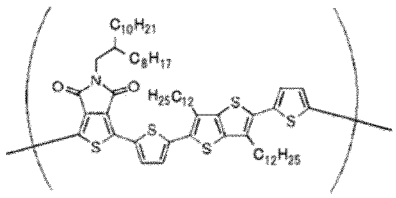

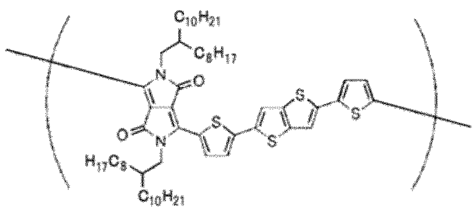

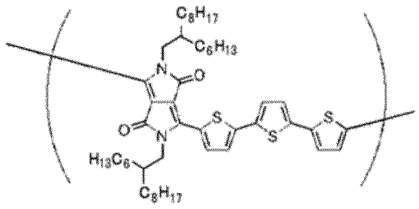

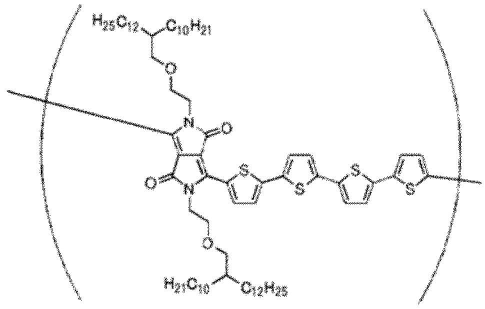

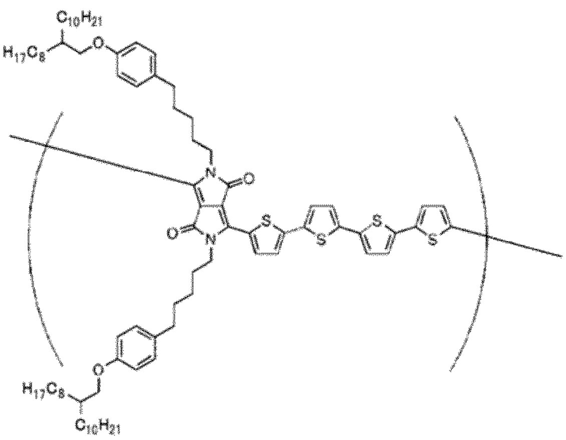

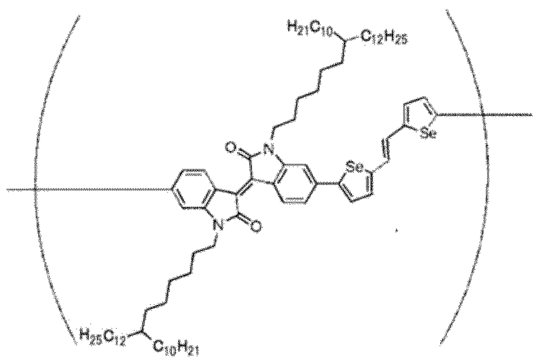

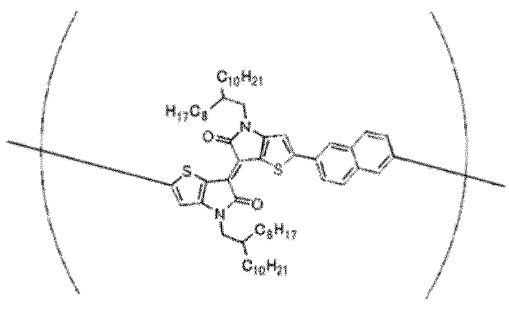

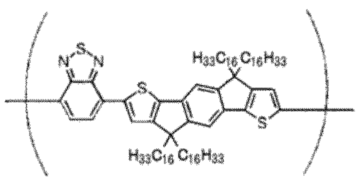

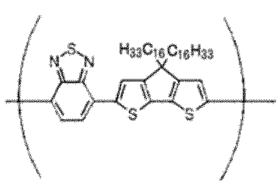

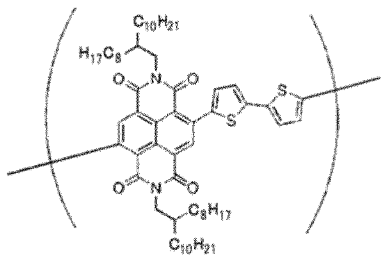

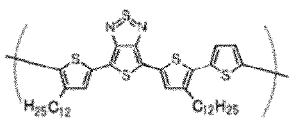
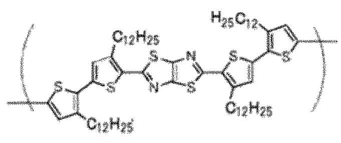
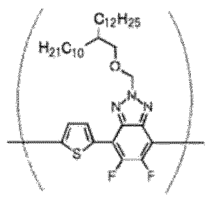

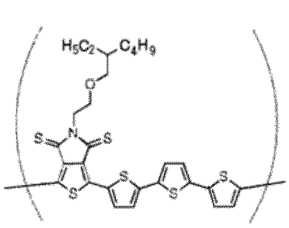
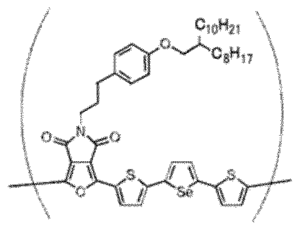
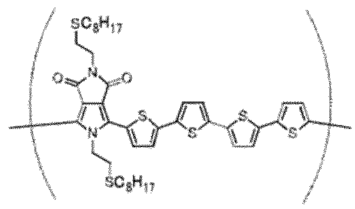

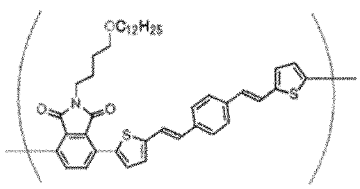
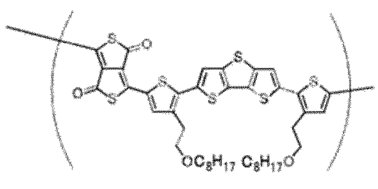
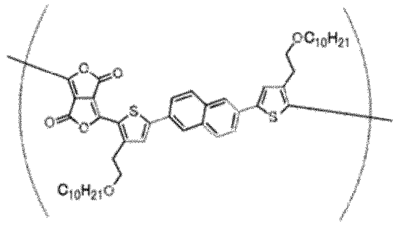

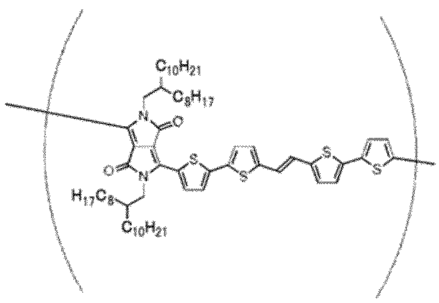
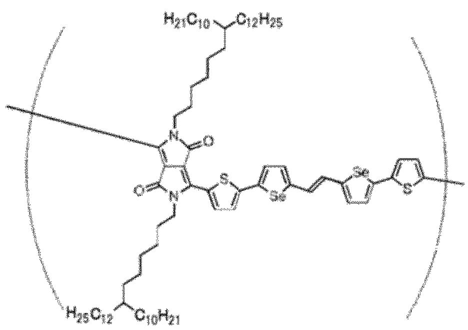

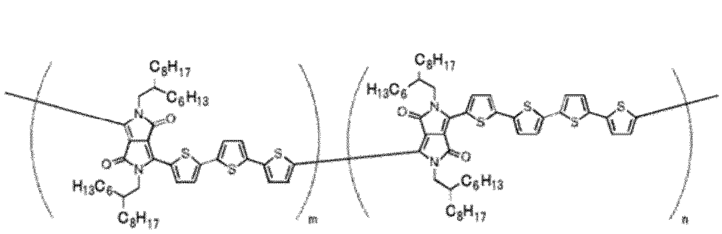

m : n=0.2 : 0.8
random copolymer

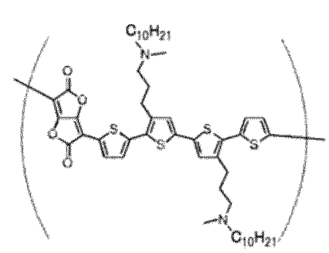

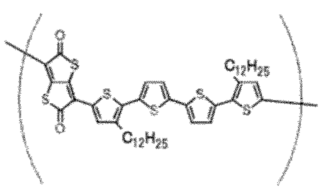
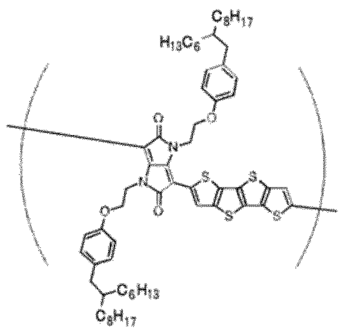
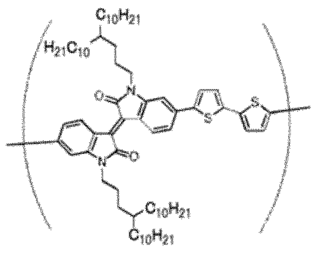
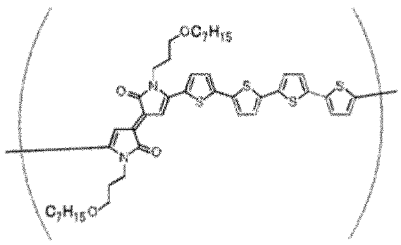
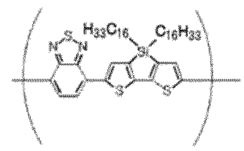
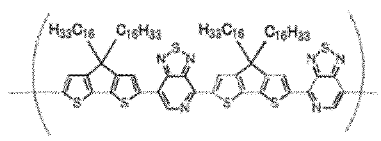
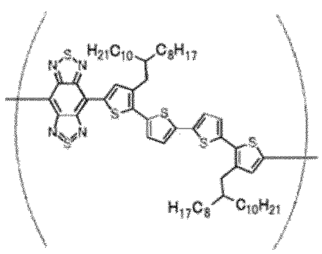
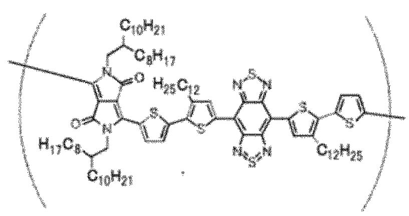
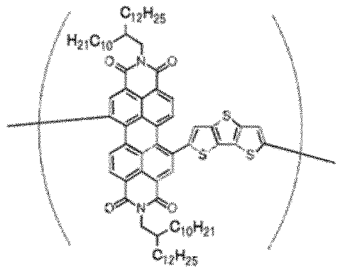

The organic semiconductor polymer of the component (a) may include one structural unit represented by Formula (1) singly, and two or more thereof may be included.

The organic semiconductor polymer of the component (a) has two or more repeating units represented by Formula (1). The organic semiconductor polymer of the component (a) may be a random copolymer or a block copolymer. The organic semiconductor polymer of the component (a) may be an oligomer having a repeating unit number (degree of polymerization) n of 2 to 9 or a polymer compound having the repeating unit number n of 10 or more. Among these, a polymer compound is preferable, in view of carrier mobility and physical properties of an obtained organic semiconductor layer.

A degree of polymerization n may be estimated from a weight-average molecular weight described below and a mass of each repeating unit.

The organic semiconductor polymer of the component (a) may have a structural unit other than the structural unit represented by Formula (1).

In the organic semiconductor polymer of the component (a), the content of the structural unit represented by Formula (1) is preferably 60 mass% or more, more preferably 80 mass% or more, and even more preferably 90 mass% or more. The organic semiconductor polymer of the component (a) is preferably a polymer consisting of the structural unit represented by Formula (1).

In view of the carrier mobility, a weight-average molecular weight of the organic semiconductor polymer of the component (a) is 2,000 or more, more preferably 10,000 or more, even more preferably 20,000 or more, particularly preferably 30,000 or more, and most preferably 45,000 or more. In view of solubility, the weight-average molecular weight is preferably 1,000,000 or less, more preferably 300,000 or less, even more preferably 200,000 or less, and particularly preferably 150,000 or less.

With respect to the organic semiconductor polymer of the component (a), the weight-average molecular weight thereof has a specific relationship with a weight-average molecular weight of an insulating polymer of a component (b) as described below.

In the present invention, the weight-average molecular weight and the number-average molecular weight are measured by a gel permeation chromatography (GPC) method and are calculated in terms of standard polystyrene. Specifically, for example, in GPC, HLC-8121 GPC (trade name, manufactured by Tosoh Corporation), is used, two units

of TSKgel $GMH_{HR}$-H (20) HT (trade name, manufactured by Tosoh Corporation, 7.8 mm ID × 30 cm) are used as columns, and 1,2,4-trichlorobenzene is used as an eluent. As the conditions, a sample concentration of 0.02 mass%, a flow rate of 1.0 mL/min, a sample injection amount of 300 μL, and a measurement temperature of 160°C are set, and an infrared (IR) detector is used, so as to perform the GPC. The calibration curve is manufactured by using 12 samples of "Standard sample TSK standard, polystyrene": "F-128", "F-80", "F-40", "F-20", "F-10", "F-4", "F-2", "F-1", "A-5000", "A-2500", "A-1000", and "A-500" (all are trade names).

The terminal structure of the organic semiconductor polymer of the component (a) is not particularly limited and do not uniformly determined, according to the presence or absence of other repeating units, the type of base material used in the synthesis, or the types of the quenching agent during synthesis (reaction stopping agent). Examples of the structure of the terminal include a hydrogen atom, a hydroxy group, a halogen atom, an ethylenically unsaturated group, an alkyl group, and an aromatic heterocyclic group (preferably a thienyl group), or an aromatic hydrocarbon group (preferably a phenyl group).

The method of synthesizing the organic semiconductor polymer of the component (a) is not particularly limited, and the organic semiconductor polymer may be synthesized with reference to a general method. For example, the organic semiconductor polymer may be synthesized by synthesizing a precursor compound guiding respective structural units forming a polymer, and performing cross-coupling reaction such as Suzuki coupling reaction or Stille coupling reaction on each precursor. In a case of synthesizing the organic semiconductor polymer of the component (a), for example, respective documents such as JP2010-527327A, JP2007-516315A, JP2014-515043A, JP2014-507488A, JP2011-501451A, JP2010-18790A, WO2012/174561A, JP2011-514399A, and JP2011-514913A may be referred to.

In the organic semiconductor composition of the present invention, the content of the organic semiconductor polymer of the component (a) is preferably 0.001 to 10 mass%, more preferably 0.01 to 5 mass%, and even more preferably 0.03 to 2 mass%.

<(b) Insulating polymer having weight-average molecular weight of 2,000 or more>

The insulating polymer of the component (b) may be used without particular limitation, as long as the insulating polymer has a weight-average molecular weight of 2,000 or more and exhibiting insulating properties. The "insulating polymer" of the present invention is a polymer having volume resistivity of $10^6$ Ωcm or more and different from the organic semiconductor polymer of the component (a). The volume resistivity may be measured by the method below.

-Method of measuring volume resistivity-

A clean glass substrate having squares of 50 mm is coated with the polymer, so as to obtain a polymer film having a thickness of 1 μm. The volume resistivity of the obtained film was measured by using LORESTA GP MCP-T 610 type (Trade name, manufactured by Mitsubishi Materials Corporation).

The insulating polymer of the component (b) is preferably a polymer obtained by polymerizing a monomer having an ethylenically unsaturated bond and more preferably a polymer having a structural unit represented by Formula (I-1).

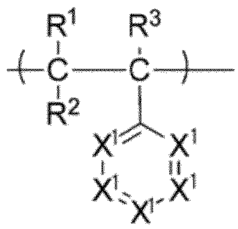

(I-1)

In Formula (I-1), $R^1$ to $R^3$ each represent a hydrogen atom or a substituent. In a case where $R^1$ to $R^3$ are substituents, the substituent is preferably an alkyl group (preferably an alkyl group having 1 to 10 carbon atoms, more preferably an alkyl group having 1 to 6 carbon atoms, and even more preferably an alkyl group having 1 to 4 carbon atoms, and even more preferably methyl or ethyl). $R^1$ to $R^3$ are more preferably a hydrogen atom or methyl, and an aspect in which $R^1$ and $R^2$ each are a hydrogen atom, and $R^3$ is a hydrogen atom or methyl is even more preferable.

$X^1$'s each independently represent $CR^{A4}$ or a nitrogen atom. $R^{A4}$ represents a hydrogen atom or a substituent. The substituent employed as $R^{A4}$ is preferably an alkyl group (preferably an alkyl group having 1 to 12 carbon atoms, more preferably having 2 to 9 carbon atoms, and even more preferably having 4 to 6 carbon atoms), a hydroxy group, an alkenyl group (an alkenyl group preferably having 2 to 12 carbon atoms, more preferably having 2 to 9 carbon atoms, and even more preferably having 4 to 6 carbon atoms), an alkynyl group (an alkynyl group preferably having 2 to 12

carbon atoms, more preferably having 2 to 9 carbon atoms, and even more preferably having 4 to 6 carbon atoms), a cycloalkyl group (a cycloalkyl group preferably having 3 to 12 carbon atoms, more preferably having 3 to 9 carbon atoms, and even more preferably having 4 to 6 carbon atoms, and this cycloalkyl group is preferably an unsubstituted aspect), an aryl group (an aryl group preferably having 6 to 12 carbon atoms, more preferably having 6 to 9 carbon atoms, and even more preferably having 6 to 12 carbon atoms, and this aryl group is preferably an unsubstituted aspect), an aralkyl group (an aralkyl group preferably having 7 to 12 carbon atoms and more preferably having 7 to 9 carbon atoms), a halogen atom (preferably a fluorine atom), and more preferably an alkyl group. $R^{A4}$ is more preferably a hydrogen atom, a hydroxy group, or an alkyl group.

In Formula (I-1), in a case where there are nitrogen atoms in five $X^1$'s, the number of the nitrogen atoms is preferably one. (That is, in a case where a ring structure in Formula (I-1) is a nitrogen-containing heterocyclic ring, a pyridine ring is preferable.)

A portion or all of the structural units represented by Formula (I-1) included in the insulating polymer of the component (b) are preferably structural units represented by Formula (I-2).

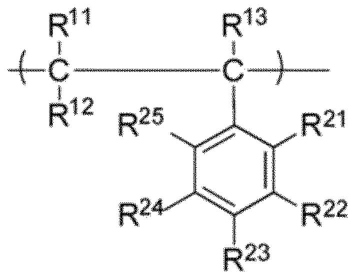

(I-2)

In Formula (I-2), $R^{11}$ to $R^{13}$ each represent a hydrogen atom or an alkyl group. The alkyl group employed as $R^{11}$ to $R^{13}$ preferably is an alkyl group having 1 to 10 carbon atoms, more preferably an alkyl group having 1 to 6 carbon atoms, even more preferably an alkyl group having 1 to 4 carbon atoms, and even more preferably methyl or ethyl. Among these, $R^{11}$ and $R^{12}$ each are a hydrogen atom, and $R^{13}$ is preferably a hydrogen atom or methyl.

$R^{21}$ to $R^{25}$ each represent a hydrogen atom, a hydroxy group, an alkyl group, an alkenyl group, an alkynyl group, a cycloalkyl group, an aryl group, an aralkyl group, or a fluorine atom. The preferable aspect of the alkyl group, the alkenyl group, the alkynyl group, the cycloalkyl group, the aryl group, and the aralkyl group employed as $R^{21}$ to $R^{25}$ are the same as the preferable aspect of the alkyl group, the alkenyl group, the alkynyl group, the cycloalkyl group, the aryl group, and the aralkyl group employed as $R^{A4}$.

$R^{22}$ and $R^{23}$ are linked to each other to form a ring. The formed ring is preferably a benzene ring. (That is, it is preferable that the entire condensed ring structure is a naphthalene ring.)

The alkyl group, the alkenyl group, the alkynyl group, the cycloalkyl group, the aryl group, or the aralkyl group employed by $R^{21}$ to $R^{25}$ may further have a substituent. Examples of the substituent include an alkoxy group (preferably an alkoxy group having 1 to 10 carbon atoms, more preferably an alkoxy group having 1 to 5 carbon atoms, and more preferably an ethoxy group or a methoxy group), a hydroxyl group, a halogen atom (a fluorine atom, a chlorine atom, and the like), a nitro group, an acyl group (an acyl group preferably having 2 to 10 carbon atoms, more preferably having 2 to 5 carbon atoms, and even more preferably having 2 or 3 carbon atoms), an acyloxy group (an acyloxy group preferably having 2 to 10 carbon atoms, more preferably having 2 to 5 carbon atoms, and even more preferably having 2 or 3 carbon atoms), an acylamino group (an acylamino group preferably having 2 to 10 carbon atoms, more preferably having 2 to 5 carbon atoms, and even more preferably having 2 or 3 carbon atoms), a sulfonylamino group, a dialkylamino group (preferably a dialkylamino group having 2 to 20 carbon atoms, more preferably a dialkylamino group having 2 to 10 carbon atoms, and even more preferably a diethylamino group or a dimethylamino group), an alkylthio group (preferably an alkylthio group having 1 to 10 carbon atoms, more preferably an alkylthio group having 1 to 5 carbon atoms, and more preferably an ethylthio group or a methylthio group), an arylthio group (preferably an arylthio group having 6 to 20 carbon atoms, more preferably an arylthio group having 6 to 15 carbon atoms, and even more preferably a phenylthio group or a naphthylthio group), an aralkylthio group (an aralkylthio group preferably having 7 to 20 carbon atoms and more preferably having 7 to 15 carbon atoms), a thienylcarbonyloxy group, a thienylmethylcarbonyloxy group, and a heterocyclic residue such as a pyrrolidone residue.

Specific examples of the structural unit forming the insulating polymer of the component (b) are provided below, but the present invention is not limited to these specific examples. The insulating polymer of (b) may be a random copolymer or a block copolymer.

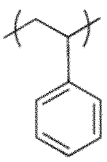 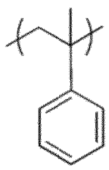 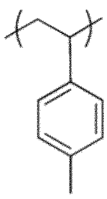 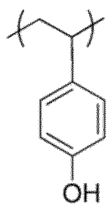 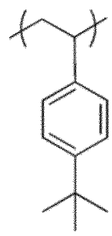 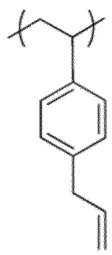 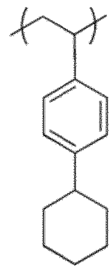

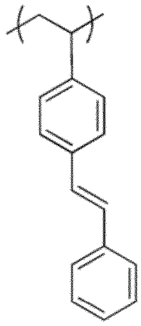 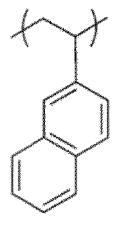 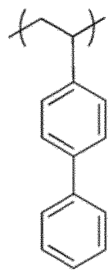 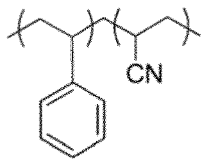 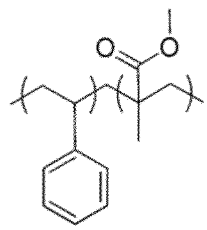

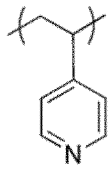 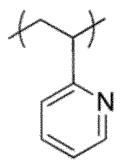 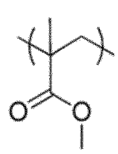 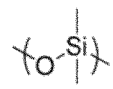

In view of solubility, the weight-average molecular weight of the insulating polymer of the component (b) is preferably 2,000 to 10,000,000, more preferably 2,000 to 2,000,000, and even more preferably 2,000 to 1,000,000.

With respect to the organic semiconductor polymer of the component (b), the weight-average molecular weight thereof has a specific relationship with the weight-average molecular weight of the organic semiconductor polymer of the component (a) as described below.

In a case where the insulating polymer of the component (b) has the structural unit represented by Formula (I-1), the insulating polymer may further have a structural unit in addition to the structural unit represented by Formula (I-1).

In the insulating polymer of the component (b), the content of the structural unit represented by Formula (I-1) is preferably 60 mass% or more, more preferably 80 mass% or more, and even more preferably 90 mass% or more. The insulating polymer of the component (b) is particularly preferably a polymer consisting of the structural unit represented by Formula (I-1).

The insulating polymer of the component (b) preferably consists of the structural unit represented by Formula (I-1).

(Relationship between organic semiconductor polymer of component (a) and insulating polymer of component (b))

A weight-average molecular weight Mw1 of the organic semiconductor polymer of the component (a) and the weight-average molecular weight Mw2 of the insulating polymer of the component (b) included in the composition of the present invention satisfy Relational expression (1a). Mw1 and Mw2 preferably satisfy Relational expression (2a) and more preferably satisfy Relational expression (3a).

Relational expression (1a) $$0.1 \leq Mw1 / Mw2 \leq 10$$

Relational expression (2a) $$0.5 \leq Mw1 / Mw2 \leq 7$$

Relational expression (3a) $$1 \leq Mw1 / Mw2 \leq 5$$

In a case where Mw1 and Mw2 are in the above relationships, the both polymers are appropriately compatible with each other, and array regularity of the organic semiconductor polymer in the organic semiconductor layer formed of the composition of the present invention may be further improved.

With respect to the composition of the present invention, a content C1 mass% of the organic semiconductor polymer of the component (a) and a content C2 mass% of the insulating polymer of the component (b) satisfy Relational expression (1b). C1 and C2 preferably satisfy Relational expression (2b) and more preferably satisfy Relational expression (3b).

$$\text{Relational expression (1b)} \qquad 0.1 \leq C1 / C2 \leq 10$$

$$\text{Relational expression (2b)} \qquad 0.5 \leq C1 / C2 \leq 5$$

$$\text{Relational expression (3b)} \qquad 1 \leq C1 / C2 \leq 3$$

In a case where C1 and C2 are in the above relationships, desired interaction occurs between the insulating polymer and the organic semiconductor polymer, and the hopping inhibition of the carrier is satisfactorily suppressed by the insulating polymer.

In the composition of the present invention, the content of the component (b) is preferably 0.001 to 10 mass%, more preferably 0.01 to 5 mass%, and even more preferably 0.03 to 2 mass%.

With respect to a solubility parameter (SP value) of the structural unit represented by Formula (1), which is included in the organic semiconductor polymer of the component (a) and an SP value of the structural unit represented by Formula (I-1), which is preferably included in the organic semiconductor polymer of the component (a), an absolute value of the difference between these values is preferably 7.5 $MPa^{1/2}$ or less, more preferably 5.0 $MPa^{1/2}$ or less, and even more preferably 2.5 $MPa^{1/2}$ or less.

According to the present invention, the "SP value" means a "value of the solubility parameter". The SP value according to the present invention is a Hansen solubility parameter according to a formula disclosed in Hansen solubility parameter: A User's Handbook, Second Edition, C. M. Hansen (2007), Taylor and Francis Group, LLC (HSPiP manual). Specifically, the SP value is calculated by the formula below by using "Hansen Solubility Parameters in Practice HSPiP 3rd edition" (software version 4.0.05).

$$(\text{SP value})^2 = (\delta Hd)^2 + (\delta Hp)^2 + (\delta Hh)^2$$

Hd : Dispersion contribution
Hp : Polarity contribution
Hh : Hydrogen bonding contribution

The organic semiconductor polymer of the component (a) and the insulating polymer of the component (b) preferably have a specific relationship in these characteristics. That is, in a case where a surface free energy of the organic semiconductor polymer of the component (a) is set as $\gamma 1$ and a surface free energy of the insulating polymer of the component (b) is set as $\gamma 2$, it is preferable that $\gamma 1 \leq \gamma 2$ is satisfied, and it is more preferable that $\gamma 1 < \gamma 2$ is satisfied. In a case where $\gamma 1$ and $\gamma 2$ are in the above relationship, while the compatibility between the organic semiconductor polymer and the insulating polymer in the organic semiconductor layer is maintained, both polymers may be moderately localized, such that the array regularity of the organic semiconductor polymer is effectively improved so as to further improve the carrier mobility.

The surface free energy of the polymer may be measured by a well-known method. That is, the contact angle of a film (thickness: 100 nm) consisting of this polymer is measured in both water and diiodomethane and is substituted into the Owens's Formula (the following is a formula in a case of using diiodomethane ($CH_2I_2$) in an organic solvent), so as to obtain the surface free energy.

Owens's Formula

$$1 + \cos \theta_{H2O} = 2(\gamma_S{}^{d})^{1/2} (\gamma_{H2O}{}^{d})^{1/2} / \gamma_{H2O,\ V} + 2(\gamma_S{}^{h})^{1/2} (\gamma_{H2O}{}^{h})^{1/2} / \gamma_{H2O,\ V}$$

$$1 + \cos \theta_{CH2I2} = 2(\gamma_S^d)^{1/2} (\gamma_{CH2I2}^d)^{1/2} / \gamma_{CH2I2, V} + 2 (\gamma_S^h)^{1/2} (\gamma_{CH2I2}^h)^{1/2} / \gamma_{CH2I2, V}$$

Here, $\gamma_{H2O}^d = 21.8$, $\gamma_{CH2I2}^d = 49.5$, $\gamma_{H2O}^h = 51.0$, $\gamma_{CH2I2}^h = 1.3$, $\gamma_{H2O, V} = 72.8$, $\gamma_{CH2I2, V} = 50.8$. In a case where a measured value of a contact angle of water is substituted with $\theta_{H2O}$, and a measured value of a contact angle of diiodomethane is substituted with $\theta_{CH2I2}$, a dispersion force component $\gamma_S^d$ and a polarity component $\gamma_S^h$ of the surface energy are respectively obtained, and the sum thereof $\gamma_S^{Vh} = \gamma_S^d + \gamma_S^h$ may be obtained as a surface free energy (mN/m).

The contact angles are measured by setting liquid droplet volumes of pure water and diiodomethane as 1 $\mu$L and reading contact angles after 10 seconds from dropwise addition. In this case, the measurement atmosphere is set as a temperature of 23°C and a relative humidity of 50%.

<(c) Solvent>

The solvent of the component (c) is not particularly limited, as long as the organic semiconductor polymer of the component (a) and the insulating polymer of the component (b) may be dissolved in the solvent at a predetermined concentration. Examples of the solvent include solvents below.

A hydrocarbon compound such as hexane, octane, decane, toluene, xylene, mesitylene, ethylbenzene, amylbenzene, decalin, 1-methoxytoluene, 1-methylnaphthalene, 1-ethylnaphthalene, 1,6-dimethylnaphthalene, and tetralin, a ketone compound such as acetone, methyl ethyl ketone, methyl isobutyl ketone, cyclohexanone, acetophenone, propiophenone, and butyrophenone, a halogenated hydrocarbon compound such as dichloromethane, chloroform, tetrachloromethane, dichloroethane, trichloroethane, tetrachloroethane, chlorobenzene, 1,2-dichlorobenzene, 1,2,4-trichlorobenzene, chlorotoluene, and 1-fluoronaphthalene, a heterocyclic compound such as pyridine, picoline, quinoline, thiophene, 3-butylthiophene, and thieno[2,3-b]thiophene, a halogenated heterocyclic compound such as 2-chlorothiophene, 3-chlorothiophene, 2,5-dichlorothiophene, 3,4-dichlorothiophene, 2-bromothiophene, 3-bromothiophene, 2,3-dibromothiophene, 2,4-dibromothiophene, 2,5-dibromothiophene, 3,4-dibromothiophene, and 3,4-dichloro-1,2,5-thiadiazole, an ester compound such as ethyl acetate, butyl acetate, amyl acetate, 2-ethylhexyl acetate, $\gamma$-butyrolactone, and phenyl acetate, an alcohol compound such as methanol, propanol, butanol, pentanol, hexanol, cyclohexanol, methyl cellosolve, ethyl cellosolve, and ethylene glycol, an ether compound such as dibutyl ether, tetrahydrofuran, dioxane, dimethoxyethane, anisole, ethoxybenzene, propoxybenzene, isopropoxybenzene, butoxybenzene, 2-methylanisole, 3-methylanisole, 4-methylanisole, 4-ethylanisole, dimethyl anisole (any one of 2,3-, 2,4-, 2,5-, 2,6-, 3,4-, 3,5-, and 3,6-), and 1,4-benzodioxane, an amide compound or an imide compound such as N,N-dimethylformamide, N,N-dimethylacetamide, 1-methyl-2-pyrrolidone, 1-methyl-2-imidazolidinone, and 1,3-dimethyl-2-imidazolidinone, a sulfoxide compound such as dimethylsulfoxide, a phosphoric acid ester compound such as trimethyl phosphate, a nitrile compound such as acetonitrile and benzonitrile, a nitro compound such as nitromethane and nitrobenzene, and/or water may be used. The solvent may be used singly or a plurality thereof may be used in combination. It is preferable that an appropriate solvent is selected according to the printing method. Among these, one or more selected from a hydrocarbon compound, a halogenated hydrocarbon compound, a heterocyclic compound, a halogenated heterocyclic compound, and an ether compound are preferable, one or more selected from toluene, xylene, mesitylene, amylbenzene, tetralin, acetophenone, propiophenone, butyrophenone, chlorobenzene, dichlorobenzene, anisole, ethoxybenzene, propoxybenzene, isopropoxybenzene, butoxybenzene, 2-methylanisole, 3-methylanisole, 4-methylanisole, 1-fluoronaphthalene, 3-chlorothiophene, and 2,5-dibromothiophene are more preferable, and one or more selected from toluene, xylene, tetralin, acetophenone, propiophenone, butyrophenone, anisole, ethoxybenzene, propoxybenzene, butoxybenzene, 2-methylanisole, 3-methylanisole, 4-methylanisole, 1-fluoronaphthalene, 3-chlorothiophene, and 2,5-dibromothiophene are particularly preferable.

With respect to the solvent of the component (c), the SP value is preferably 15.0 to 30.0 $MPa^{1/2}$ and more preferably 15.0 to 23.0 $MPa^{1/2}$. In a case of using the solvent of which the SP value is in the above range, it is possible to provide high solubility to the organic semiconductor polymer and the insulating polymer, and thus it is possible to prepare an ink composition at an appropriate concentration.

In the composition of the present invention, the content of the solvent of the component (c) is preferably 60 mass% or more, more preferably 80 mass% or more, and even more preferably 90 mass% or more. In the composition of the present invention, the content of the solvent of the component (c) is less than 100 mass%, and a portion or all of the remainder except for the solvent includes the components (a) and (b).

In the composition of the present invention, the component (b) preferably does not have a thickening effect. That is, the insulating polymer of the component (b) does not function as a binder added for the purpose of improving printability or the like. In a case where the viscosity of the composition of the present invention is set as p1, and the viscosity of the composition of the composition excluding the component (b) from this composition is set as p2, it is preferable that p1 / p2 < 5 is satisfied, it is more preferable that p1 / p2 < 3 is satisfied, and it is even more preferable that p1 / p2 < 2 is satisfied. p1 / p2 is generally 1 or more.

The viscosity is a value measured in conformity with JIS Z8803.

As described below, the composition of the present invention may effectively improve the carrier mobility of the obtained organic thin film transistor by being used in the forming of the organic semiconductor layer of the organic thin film transistor. Although this mechanism is uncertain, as described below, the effect of improving the printability by the insulating polymer of the component (b) which is considered as providing influence on the interactivity between the insulating polymer of the component (b) used in the present invention and the organic semiconductor polymer of the component (a) is not recognized in practice. The improvement of carrier mobility based on the interaction of the organic semiconductor polymer with the insulating polymer has not been known until now.

(Additive)

The composition of the present invention may contain various additives in addition to the components (a) to (c). As the additive, an additive that is generally used in the organic semiconductor composition may be used without limitation.

The content proportion of the additive in the organic semiconductor composition is preferably 10 mass% or less, preferably 5 mass% or less, and more preferably 1 mass% or less. In a case where the content proportion is in the above range, film forming properties become excellent. In a case where the organic semiconductor film of the organic thin film transistor element is formed by using the organic semiconductor composition in which the content proportion of the additive is in the above range, the film forming properties become excellent, and the carrier mobility and the heat resistance of the organic thin film transistor element are further improved.

<Preparation method>

The method of preparing the organic semiconductor composition is not particularly limited, and a general preparation method may be employed. For example, it is possible to prepare the organic semiconductor composition of the present invention by adding respective components in a predetermined amount to the solvent and appropriately performing a stirring treatment.

[Method of manufacturing organic thin film transistor]

The method (hereinafter, referred to as the manufacturing method of the present invention") of manufacturing the organic thin film transistor of the present invention includes forming the organic semiconductor layer with an organic semiconductor polymer determined in the component (a) and the insulating polymer determined in the component (b) in the step of manufacturing of the organic thin film transistor. In the manufacturing method, there are two embodiments of an aspect of using the composition of the present invention and an aspect of not using the composition of the present invention. These embodiments are described below. The structure of the entire organic thin film transistor is described below.

<Method of forming organic semiconductor layer by using composition of the present invention>

One embodiment of the manufacturing method of the present invention includes forming the organic semiconductor layer by using the composition of the present invention. It is more preferable to form an organic semiconductor layer by exposing a coating film formed by applying the composition of the present invention after drying if necessary, at a temperature (preferably higher than Tg and Tg + 200°C or less and more preferably Tg + 20°C to Tg + 100°C) higher than the glass transition temperature (Tg, °C) of the insulating polymer of the component (b) contained in the composition of the present invention. In this manner, it is possible to appropriately cause the organic semiconductor polymer and the insulating polymer to be compatible with each other. The exposure time at a temperature higher than the glass transition temperature (Tg) of the insulating polymer of the component (b) is preferably five minutes to three hours.

The respective steps may be performed in under an atmospheric atmosphere or an inert gas atmosphere and are preferably performed under an inert gas atmosphere (in an environment not substantially containing water or oxygen, for example, under a nitrogen atmosphere).

In the present invention, Tg is measured by using the differential scanning calorimeter (DSC). More specifically, a differential scanning calorimeter (X-DSC 7000 (trade name, manufactured by Hitachi High-Tech Science Corporation)) is used, 20 mg of an insulating polymer sample is introduced to a measuring pan, the temperature thereof is increased in a nitrogen stream at a speed of 10°C/min from 30°C to 120°C, maintained for 15 minutes, and is cooled to 30°C at -20°C/min. Thereafter, the temperature is increased again from 30°C to 250°C, and the temperature at which the baseline starts to change from the low temperature side is defined as the glass transition temperature Tg.

The layer (layer that is in contact with the organic semiconductor layer and becomes a base of the organic semiconductor layer) provided with the organic semiconductor layer is inevitably determined by the structure of the organic thin film transistor. In a case of a bottom gate type which is a preferable embodiment of the present invention, after the gate insulating layer (film) is formed, the organic semiconductor layer is provided on the gate insulating layer.

The method of forming the coating film by using the composition of the present invention is not particularly limited, and a well-known coating method may be employed. Examples of the coating method include a bar coating method, a spin coating method, a dip coating method, a knife coating method, a doctor blade method, an ink jet printing method, a flexographic printing method, a gravure printing method, or a screen printing method. A method (so-called gap casting method) of forming the organic semiconductor film disclosed in JP2013-207085A, a method (so-called edge casting method or continuous edge casting method) of manufacturing the organic semiconductor thin film disclosed in WO2014/175351A, and the like may be appropriately used.

The film thickness of the organic semiconductor layer formed by this method is generally 10 to 500 nm and more preferably 20 to 200 nm.

<Method of forming organic semiconductor layer without using composition of the present invention>

Another embodiment of the manufacturing method of the present invention includes respectively applying an ink composition A obtained by dissolving (a) in a solvent and an ink composition B obtained by dissolving (b) in a solvent to form films and forming the organic semiconductor layer. The layer (layer that is in contact with the organic semiconductor layer and becomes a base of the organic semiconductor layer) on which the organic semiconductor layer is provided is inevitably determined according to the structure of the organic thin film transistor. In a case of a bottom gate type which is a preferable embodiment of the present invention, after a gate insulating layer (film) is formed, the ink composition A and the ink composition B are respectively (sequentially) applied to the gate insulating layer to form films, such that the organic semiconductor layer is formed.

(a) Organic semiconductor polymer having a weight-average molecular weight of 2,000 or more
(b) Insulating polymer having a weight-average molecular weight of 2,000 or more

Here, the weight-average molecular weight Mw1 of the organic semiconductor polymer (a) and the weight-average molecular weight Mw2 of the insulating polymer (b) satisfy Relational expression (1a).

$$0.1 \leq Mw1 / Mw2 \leq 10$$

In a case where Mw1 and Mw2 are in the above relationship, the both polymers are appropriately compatible with each other at a portion that is in contact with the both polymers or in the vicinity thereof, such that the array regularity of the organic semiconductor polymer in the organic semiconductor layer may be further improved.

In the forming of the organic semiconductor layer, a coating amount CT1 of the organic semiconductor polymer applied by applying the ink composition A and a coating amount CT2 of the insulating polymer applied by applying the ink composition B satisfy Relational expression (1c) by a mass ratio.

$$0.1 \leq CT1 / CT2 \leq 10$$

In a case where CT1 and CT2 are in the above relationship, while a desired interaction occurs between the insulating polymer and the organic semiconductor polymer, hopping inhibition of the carrier due to the insulating polymer may be suppressed.

Mw1 and Mw2 preferably satisfy Relational expression (2a) and more preferably satisfy Relational expression (3a).

Relational expression (2a) $$0.5 \leq Mw1 / Mw2 \leq 7$$

Relational expression (3a) $$1 \leq Mw1 / Mw2 \leq 5$$

CT1 and CT2 preferably satisfy Relational expression (2c) and more preferably satisfy Relational expression (3c).

$$\text{Relational expression (2c)} \qquad 0.5 \leq CT1/CT2 \leq 5$$

$$\text{Relational expression (3c)} \qquad 1 \leq CT1/CT2 \leq 3$$

In this method, the structure of the organic semiconductor polymer of (a) is the same as that of the organic semiconductor polymer of the component (a) in the composition of the present invention, and a preferable aspect thereof is also the same. The structure of the insulating polymer of (b) is the same as the structure of the insulating polymer of the component (b) in the composition of the present invention, and a preferable aspect thereof is also the same.

In this method, the preferable ranges of the weight-average molecular weight of the organic semiconductor polymer of (a) and the weight-average molecular weight of the insulating polymer of (b) are respectively the same as preferable ranges of the weight-average molecular weight of the organic semiconductor polymer of the component (a) included in the composition of the present invention and the weight-average molecular weight of the insulating polymer of (b).

In this method, it is preferable that, after the ink composition B is applied and dried if necessary, the ink composition A is applied. Specifically, it is preferable that, the coating film is formed by applying the ink composition B and drying the ink composition B if necessary, and then applying the ink composition A thereon, so as to form a coating film. At this point, the solubility of the insulating polymer included in the ink composition B with respect to the ink composition A is preferably 10 mg/100 g or more, more preferably 20 mg/100 g or more, and even more preferably 30 mg/100 g or more. In this manner, a portion or all of the insulating polymer formed by coating by using the ink composition B is dissolved in the ink composition A. As a result, in the obtained organic semiconductor layer, it is possible to form a state in which the insulating polymer and the organic semiconductor polymer are appropriately mixed, such that the carrier mobility may be increased. It is more preferable that the solvents used in the ink composition A and the ink composition B are the same.

The expression "solubility" according to the present invention means solubility at 20°C.

The method of applying the ink composition A and the ink composition B is not particularly limited, and a well-known method may be employed. Examples of the coating method include a bar coating method, a spin coating method, a dip coating method, a knife coating method, a doctor blade method, an ink jet printing method, a flexographic printing method, a gravure printing method, or a screen printing method. A method (so-called gap casting method) of forming the organic semiconductor film disclosed in JP2013-207085A, a method (so-called edge casting method or continuous edge casting method) of manufacturing the organic semiconductor thin film disclosed in WO2014/175351A, and the like may be appropriately used.

In the ink composition A, the content of the organic semiconductor polymer of (a) is preferably 0.001 to 10 mass%, more preferably 0.002 to 5 mass%, and even more preferably 0.003 to 2 mass%. In the ink composition B, the content of the insulating polymer of (b) is preferably 0.001 to 10 mass%, more preferably 0.002 to 5 mass%, and even more preferably 0.003 to 2 mass%.

It is more preferable that, after a film is formed on the gate insulating layer by using the ink composition A and the ink composition B as described above, the corresponding film is exposed at a temperature (preferably higher than Tg and Tg + 200°C or less and more preferably Tg + 20°C to Tg + 100°C) higher than the glass transition temperature (Tg, °C) of the insulating polymer included in the ink composition B, so as to form the organic semiconductor layer. In this manner, the organic semiconductor polymer and the insulating polymer are caused to be appropriately compatible with each other.

The film thickness of the organic semiconductor layer formed by this method is generally 10 to 500 nm and more preferably 10 to 200 nm.

In a case where the organic semiconductor polymer and the insulating polymer are caused to be copresent in the organic semiconductor layer of the organic thin film transistor, it is possible to effectively increase the carrier mobility of the obtained organic thin film transistor. The reason thereof is not certain, but it is considered that, one of the causes is increasing the array regularity of the organic semiconductor polymer compared with the case of using the organic semiconductor polymer singly, in a case where the organic semiconductor polymer and the insulating polymer are copresent. It is assumed that, according to the improvement of this array regularity, the carrier diffusion occurring due to the movement of the structure in a main chain of the organic semiconductor polymer is suppressed, and the hopping of the carrier in a side chain of the organic semiconductor polymer becomes satisfactory.

In a case where the amount of the insulating polymer is too much, it is not likely that a desired effect is obtained. It is considered that, one of the causes is the ease of inhibition of the hopping of the carrier between chains of the organic semiconductor polymer. The relationship of the weight-average molecular weights of the organic semiconductor polymer and the insulating polymer is important. There is a tendency in that the molecular weights of the both polymers are excessively decreased, the phase separation becomes remarkable, and it is not likely that the array regularity of the

organic semiconductor polymer is increased to a desired level.

<Organic thin film transistor>

Subsequently, the preferable aspect of the organic thin film transistor obtained by the manufacturing method of the present invention is described.

The organic thin film transistor (referred to as organic TFT) obtained by the manufacturing method of the present invention has the organic semiconductor layer of the present invention described above and may further have a source electrode, a drain electrode, and a gate electrode.

The organic TFT obtained in the manufacturing method of the present invention includes a gate electrode, an organic semiconductor layer, a gate insulating layer provided between the gate electrode and the organic semiconductor layer, and a source electrode and a drain electrode that are provided in contact with the organic semiconductor layer and are linked to each other via the organic semiconductor layer, on the substrate. In this organic TFT element, the organic semiconductor layer and the gate insulating layer are provided to be adjacent to each other.

The structure of the organic TFT obtained in the manufacturing method of the present invention is not particularly limited, as long as the above respective layers are provided. For example, the organic TFT may have any structures of a bottom contact type (a bottom gate-bottom contact type and a top gate-bottom contact type) or a top contact type (a bottom gate-top contact type and a top gate-top contact type). The organic TFT obtained by the manufacturing method of the present invention is more preferably a bottom gate-bottom contact type or a bottom gate-top contact type (these are collectively referred to as a bottom gate type).

Hereinafter, an example of the organic TFT that is obtained by the manufacturing method of the present invention is described with reference to the drawings.

(Bottom gate-bottom contact-type organic thin film transistor)

Fig. 1 is a schematic cross-sectional view of the bottom gate-bottom contact-type organic TFT 100 which is an example of the semiconductor element of the present invention.

As illustrated in Fig. 1, the organic TFT 100 has a substrate (base material) 10, a gate electrode 20, a gate insulating film 30, a source electrode 40, a drain electrode 42, an organic semiconductor film 50, and a sealing layer 60, in this order.

Hereinafter, a substrate (base material), a gate electrode, a gate insulating layer (film), a source electrode, a drain electrode, an organic semiconductor layer (film), a sealing layer, and a manufacturing method thereof are described above.

-Substrate-

The substrate achieves a role of supporting a gate electrode, a source electrode, a drain electrode, and the like described below.

The types of the substrate are not particularly limited, and examples thereof include a plastic substrate, a silicon substrate, a glass substrate, or a ceramic substrate. Among these, in view of applicability to each device and cost, a silicon substrate, a glass substrate, or a plastic substrate is preferable.

The thickness of the substrate is not particularly limited, and examples thereof is preferably 10 mm or less, more preferably 2 mm or less, and particularly preferably 1.5 mm or less. Meanwhile, the thickness is preferably 0.01 mm or more and more preferably 0.05 mm or more.

-Gate electrode-

As the gate electrode, a well-known electrode that is used as a gate electrode of an organic TFT element may be used without particular limitation.

A material (electrode material) for forming the gate electrode is not particularly limited, and examples thereof include metal such as gold, silver, aluminum, copper, chromium, nickel, cobalt, titanium, platinum, magnesium, calcium, barium, and sodium, conductive oxide such as $InO_2$, $SnO_2$, and indium tin oxide (ITO), a conductive polymer such as polyaniline, polypyrrole, polythiophene, polyacetylene, and polydiacetylene, semiconductor such as silicon, germanium, and gallium arsenide, and a carbon material such as fullerene, carbon nanotube, and graphite. Among these, the above metal is preferable, and silver or aluminum is more preferable.

The thickness of the gate electrode is not particularly limited, but is preferably 20 to 200 nm.

The gate electrode may function as the substrate as the silicon substrate, and in this case, the above substrate may not be provided.

The method of forming the gate electrode is not particularly limited, and examples thereof include a method of performing vacuum deposition (hereinafter, simply referred to as vapor deposition) or sputtering on the electrode material on the substrate and a method of applying or printing an electrode forming composition that contains the electrode material. In the case of patterning the electrode, examples of the patterning method include a printing method such as inkjet printing, screen printing, offset printing, or toppan printing (flexographic printing), a photolithography method, and a mask vapor deposition method.

-Gate insulating layer-

The gate insulating layer is not particularly limited, as long as the gate insulating film is a film provided between a gate electrode and an organic semiconductor layer and having insulating properties. The gate insulating film may be a film of a single layer or may be a film of multiple layers.

The gate insulating film is preferably formed of insulating materials. Examples of the insulating materials preferably include an organic material such as an organic polymer and an inorganic material such as inorganic oxide. In view of handleability, it is preferable that an organic material is used. In view of handleability, in a case where a plastic substrate or a glass substrate is used in the substrate, it is preferable to use an organic material.

The organic polymer, the inorganic oxide, and the like are not particularly limited, as long as the organic polymer, the inorganic oxide, and the like have insulating properties. It is preferable to form a thin film, for example, a thin film having a thickness of 1 μm or less.

The organic polymer and the inorganic oxide may be used singly or two or more kinds thereof may be used in combination. The gate insulating layer may be a hybrid layer in which an organic polymer described below and inorganic oxide described below are mixed.

The organic polymer is not particularly limited, and examples thereof include polyvinyl phenol, polystyrene (PS), poly(meth)acrylate represented by polymethyl methacrylate, polyvinyl alcohol, polyvinyl chloride (PVC), polyvinylidene fluoride (PVDF), polytetrafluoroethylene (PTFE), a cyclic fluoroalkyl polymer represented by CYTOP, polycycloolefin, polyester, polyethersulfone, polyether ketone, polyimide, poly(meth)acrylic acid, polybenzoxazole, an epoxy resin, polyorganosiloxane represented by polydimethylsiloxane (PDMS), polysilsesquioxane, or butadiene rubber. In addition to the above, examples thereof include a thermosetting resin such as a phenol resin, a novolak resin, a cinnamate resin, an acrylic resin, and a polyparaxylylene resin.

The organic polymer may be used in combination with a compound having a reactive substituent such as an alkoxysilyl group, a vinyl group, an acryloyloxy group, an epoxy group, and a methylol group.

In a case where the gate insulating layer is formed with an organic polymer, it is preferable to crosslinking and hardening the organic polymer for the purpose of increasing solvent resistance or insulation resistance of the gate insulating layer. The crosslinking is preferably performed by using light, heat, or both, so as to generate acid or radical.

In a case where crosslinking is performed with a radical, as a radical generating agent that generates radicals by light or heat, for example, thermal polymerization initiators (HI) and photopolymerization initiators (H2) disclosed in [0182] to [0186] of JP2013-214649A, photoradical generating agents disclosed in [0046] to [0051] of JP2011-186069A, photoradical polymerization initiators disclosed in [0042] to [0056] of JP2010-285518A can be suitably used, and the contents thereof are preferably incorporated in the present specification.

The "compound (G) having number-average molecular weight (Mn) of 140 to 5,000, having crosslinking functional groups, and not having a fluorine atom" disclosed in [0167] to [0177] of JP2013-214649A is preferably used, and the contents thereof are preferably incorporated to the present specification.

In the case of crosslinking with an acid, examples of the photo-acid generator that generates acid by light include photo cationic polymerization initiators disclosed in [0033] and [0034] of JP2010-285518A, acid generators disclosed in [0120] to [0136] of JP2012-163946A, particularly sulfonium salts, iodonium salts, and the like may be preferably used, and it is preferable that the contents thereof are incorporated into the present specification.

As a thermal acid generator (catalyst) that generates acid by heat, for example, thermal cation polymerization initiators and particularly onium salts disclosed in [0035] to [0038] of JP2010-285518A, catalysts disclosed in [0034] and [0035] of JP2005-354012A, particularly, sulfonic acids and sulfonic acid amine salts preferably can be used, and the contents thereof are preferably incorporated to the present specification.

Crosslinking agents, particularly difunctional or higher epoxy compounds and oxetane compounds disclosed in [0032] and [0033] of JP2005-354012A, crosslinking agents, particularly compounds, each of which has two or more crosslinking groups and in which at least one of these crosslinking groups is a methylol group or a NH group, disclosed in [0046] to [0062] of JP2006-303465A, and compounds, each of which has two or more of hydroxymethyl groups or alkoxymethyl groups in a molecule, disclosed in [0137] to [0145] of JP2012-163946A, are preferably used, and the contents thereof are preferably incorporated in the present specification.

Examples of the method forming a gate insulating layer with an organic polymer include a step of coating and curing the organic polymer. The coating method is not particularly limited, and examples thereof include the above

printing methods. Among these, a wet coating method such as a micro gravure coating method, a dip coating method, screen coating printing, a die coating method, or a spin coating method is preferable.

The inorganic oxide is not particularly limited, and examples thereof include oxide such as silicon oxide, silicon nitride ($SiN_Y$), hafnium oxide, titanium oxide, tantalum oxide, aluminum oxide, niobium oxide, zirconium oxide, copper oxide, and nickel oxide, perovskite such as $SrTiO_3$, $CaTiO_3$, $BaTiO_3$, $MgTiO_3$, and $SrNb_2O_6$, and composite oxide or mixture of these. Here, in addition to silicon oxide (SiOx), the silicon oxide includes Boron Phosphorus Silicon Glass (BPSG), Phosphorus Silicon Glass (PSG), borosilicate glass (BSG), arsenic silicate glass (AsSG), lead silicate glass (PbSG), silicon oxynitride (SiON), spin-on-glass (SOG), and a low dielectric constant $SiO_2$-based material (for example, polyaryl ether, a cycloperfluorocarbon polymer, benzocyclobutene, a cyclic fluororesin, polytetrafluoroethylene, fluoroaryl ether, fluorinated polyimide, amorphous carbon, and organic SOG).

As the method of forming a gate insulating layer with inorganic oxide, for example, a vacuum film forming method such as a vacuum deposition method, a sputtering method, ion plating, or a chemical vapor deposition (CVD) method can be used, and it is possible to perform assistance from plasma, an ion gun, a radical gun, and the like, by using any gas at the time of forming a film.

A film may be performed by causing a precursor corresponding to each of the metal oxide, specifically, metal halides such as chlorides and bromides, metal alkoxide, and metal hydroxide, to react with an acid such as hydrochloric acid, sulfuric acid, and nitric acid and a base such as sodium hydroxide or potassium hydroxide in alcohol or water so as to perform hydrolysis. In a case where such a solution-based process is used, a wet-coating method can be used.

In addition to the above method, the gate insulating layer can be prepared by combining any one of a lift-off method, a sol-gel method, an electrodeposition method, and shadow mask method, with a patterning method, if necessary.

A surface treatment such as a corona treatment, a plasma treatment, an ultraviolet (UV)/ozone treatment may be performed on the gate insulating layer. The carrier mobility may be improved by adjusting the phase separation of the organic semiconductor polymer and the insulating polymer by the surface treatment. As the method of adjusting the surface energy of the insulating film, an ultraviolet (UV)/ozone treatment is effective, and it is possible to hydrophilize the surface of the surface of the gate insulating film by appropriately selecting the treatment time.

The surface free energy in the gate insulating layer surface (surface on a side in which the organic semiconductor layer is formed) is preferably caused to be 50 mN/m to 75 mN/m.

It is preferable that the surface roughness of the gate insulating film is not rough. It is preferable that the arithmetic average roughness Ra or the root mean square roughness $R_{MS}$ of the surface of the gate insulating layer is 0.5 nm or less. In a case of performing the surface treatment, a treatment of not causing the insulating film surface to be rough is preferable.

-Source electrode and drain electrode-

In the organic TFT element obtained in the manufacturing method of the present invention, the source electrode is an electrode in which charges flow from the outside through wire. The drain electrode is an electrode in which charges are sent to the outside through wire.

As a material for forming the source electrode and the drain electrode, the same materials as the electrode material for forming the above gate electrode may be used. Among these, metal is preferable, and gold or silver is more preferable. It is preferable to promote the charge injection from a source to the organic semiconductor and improve the mobility by providing a charge injection layer between metal and the organic semiconductor.

The thicknesses of the source electrode and the drain electrode are not particularly limited, but each is preferably 1 nm or more and particularly preferably 10 nm or more. The thickness is preferably 500 nm or less and particularly preferably 300 nm or less.

The distance (gate length) between the source electrode and the drain electrode may be appropriately determined, but for example, the distance is preferably 200 $\mu$m or less and particularly preferably 100 $\mu$m or less. The gate width may be appropriately determined, but for example, the gate width is preferably 5,000 $\mu$m or less and particularly preferably 1,000 $\mu$m or less.

The method of forming the source electrode and the drain electrode is not particularly limited, and examples thereof include a method of performing vacuum deposition or sputtering on the electrode material on the substrate on which the gate electrode and the gate insulating film are formed or a method of applying or printing the electrode forming composition. In the case of patterning, the patterning method is the same as the method of the gate electrode described above.

-Organic semiconductor layer-

In the organic TFT obtained by the manufacturing method of the present invention, the organic semiconductor

layer is formed by the above method.

In the organic TFT obtained by the manufacturing method of the present invention, the organic semiconductor layer contains (a) and (b):

(a) an organic semiconductor polymer having a weight-average molecular weight of 2,000 or more, and
(b) an insulating polymer having a weight-average molecular weight of 2,000 or more;

the weight-average molecular weight Mw1 of the organic semiconductor polymer and the weight-average molecular weight Mw2 of the insulating polymer satisfy a relational expression below, and

$$0.1 \leq Mw1 / Mw2 \leq 10$$

a content C3 mass% of the organic semiconductor polymer and a content C4 mass% of the insulating polymer in the organic semiconductor layer satisfy a relational expression below.

$$0.1 \leq C3/C4 \leq 10$$

Preferable aspects of the organic semiconductor polymer of (a), the insulating polymer of (b), and Mw1 / Mw2, and C3 / C4 are respectively the same as the preferable aspects of the organic semiconductor polymer, the insulating polymer, Mw1 / Mw2, and C1 / C2 described in the composition of the present invention.

With respect to the organic semiconductor layer, in a case where the content of the (a) organic semiconductor polymer at an upper half of the organic semiconductor layer is set as UC1 mass%, the content of the (b) insulating polymer at an upper half of the organic semiconductor layer is set as UC2 mass%, the content of the (a) organic semiconductor polymer at a lower half of the organic semiconductor layer is set as LC1 mass%, and the content of the (b) insulating polymer at an upper half of the organic semiconductor layer is set as LC2 mass%, UC1, UC2, LC1, and LC2 preferably satisfy (UC1 / UC2) > (LC1 / LC2). In a case where the relational expression is satisfied, carrier mobility can be further increased. Although this carrier mobility enhancement is recognized regardless of the structure of the organic thin film transistor, it is particularly remarkable in a bottom gate-type transistor.

The reason of the enhancement of the carrier mobility by satisfying (UC1 / UC2) > (LC1 / LC2) is uncertain, but it is considered that, in the thickness direction of the organic semiconductor layer, the organic semiconductor polymer and the insulating polymer are compatible with each other and also unevenly distributed, so as to effectively increase the array regularity of the organic semiconductor polymer.

The expression an "upper half of the organic semiconductor layer" means an entire portion located on the side far from the substrate in the case where the organic semiconductor layer is equally divided into two layers at the center of the layer thickness, and the expression a "lower half of the organic semiconductor layer" means an entire portion located on the substrate side in the case where the organic semiconductor layer is equally divided into two layers at the center of the layer thickness. All of the "upper half of the organic semiconductor layer" and the "lower half of the organic semiconductor layer" include a boundary separating the upper and lower halves of the organic semiconductor layer.

UC1, UC2, LC1, and LC2 can be measured by time-of-flight secondary ion analysis (TOF-SIMS). That is, the concentration ratio of the organic semiconductor polymer and the insulating polymer in the organic semiconductor layer can be measured by performing element mapping by TOF-SIMS using an etching ion beam in combination. In the analysis by TOF-SIMS, an area of 100 $\mu$m $\times$ 100 $\mu$m is measured along the thickness direction.

(Sealing layer)

In view of durability, the organic TFT of the present invention preferably includes a sealing layer on an outermost layer. For the sealing layer, a sealing agent (composition for forming a sealing layer) generally used for an organic TFT can be used.

The thickness of the sealing layer is not particularly limited but is preferably 0.1 to 10 $\mu$m.

(Bottom gate-top contact-type organic thin film transistor element)

Fig. 2 is a schematic cross-sectional view indicating a bottom gate-top contact-type organic TFT 200 which is an example of the semiconductor element of the present invention.

As illustrated in Fig. 2, the organic TFT 200 includes a substrate 10, the gate electrode 20, a gate insulating layer (film) 30, an organic semiconductor layer (film) 50, the source electrode 40, the drain electrode 42, and the sealing

layer 60, in this order.

The organic TFT 200 is the same as the organic TFT 100 except that the layer configuration (lamination form) is different. Accordingly, the substrate, the gate electrode, the gate insulating layer, the source electrode, the drain electrode, the organic semiconductor layer, and the sealing layer are the same as those of the bottom gate-bottom contact-type organic TFT, and thus descriptions thereof are omitted.

## Examples

The present invention is more specifically described based on the examples, but the present invention is not limited to the following examples.

[Synthesis example]

Organic semiconductor polymers O-1 to O-9 used in this example are polymers consisting of structural units described below.

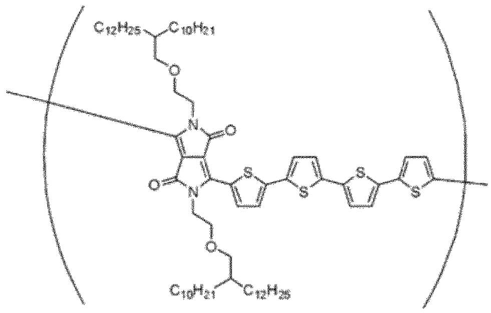

O-1

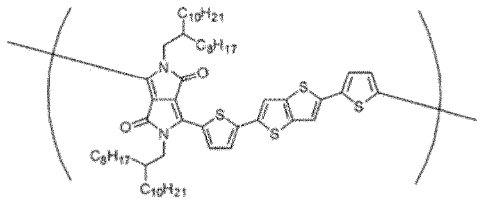

O-2

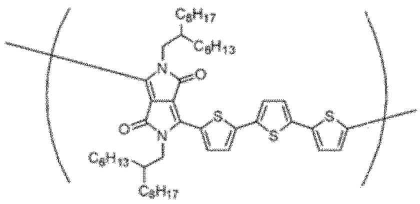

O-3

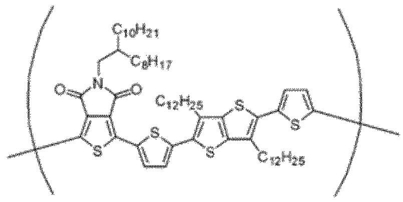

O-4

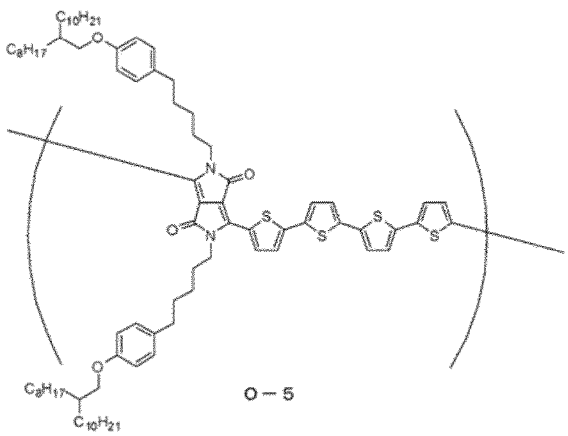

O-5

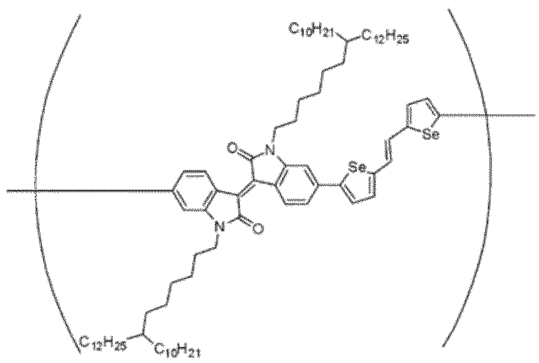

O-6

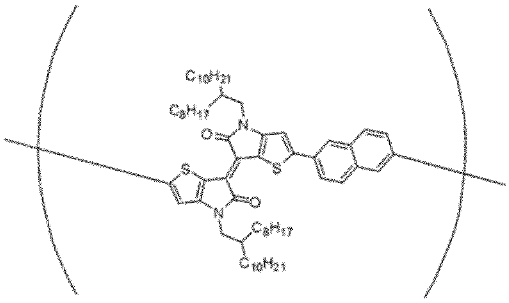

O−7

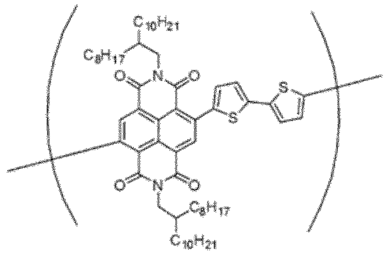

O−8

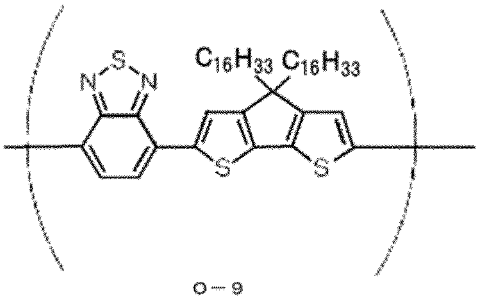

O−9

<Synthesis Example 1: Synthesis of organic semiconductor polymer O-1>

The organic semiconductor polymer O-1 was synthesized according to a scheme below. In the scheme below, DMF is N,N-dimethylformamide, NBS is N-bromosuccinimide, and dba is dibenzylidene acetone.

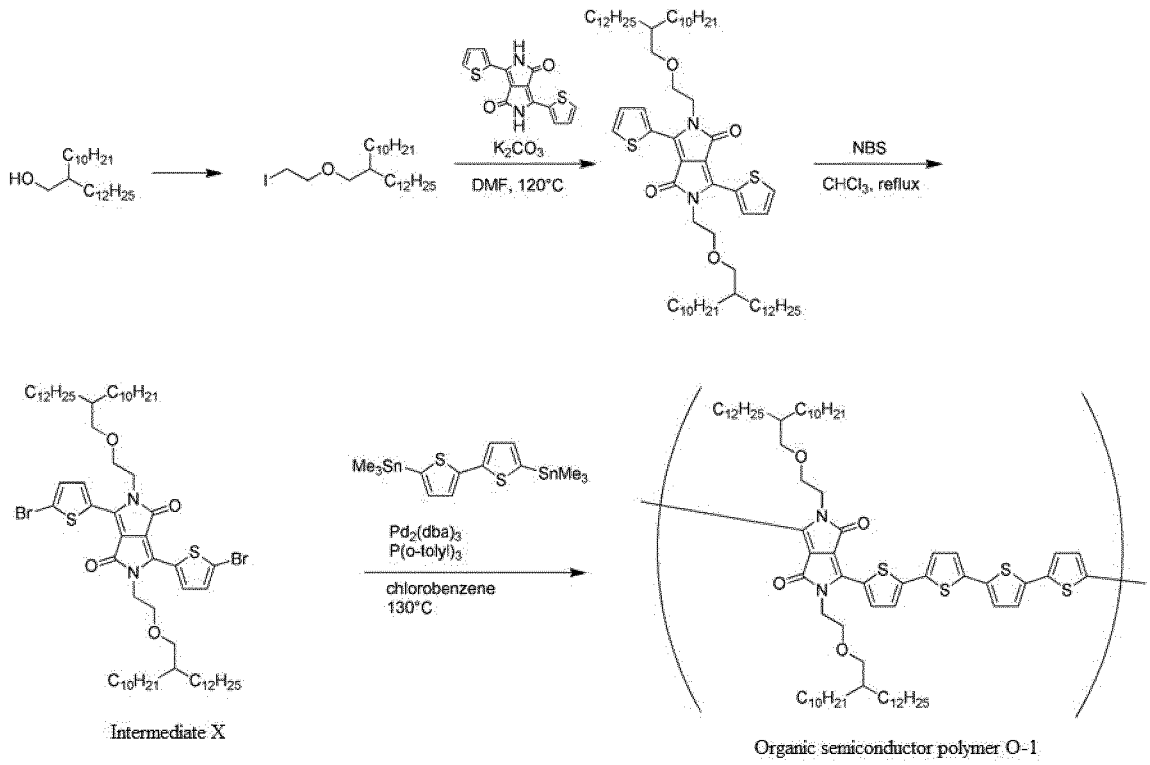


Intermediate X

Organic semiconductor polymer O-1

Intermediate X as a monomer was synthesized with reference to Tetrahedron, 2010, 66, 3173. and Organic Electronics, 2011, 12, 993.

Synthetic intermediate X (244 mg, 200 mmol), 5,5'-bis(trimethylstannyl)-2,2'-bithiophene (98.4 mg, 200 mmol), tri(o-tolyl) phosphine (9.8 mg, 32 mmol), tris(dibenzylideneacetone) dipalladium (3.7 mg, 4 mmol), and dehydrated

chlorobenzene (17 mL) were mixed and were stirred for 24 hours at 130°C under a nitrogen atmosphere. The reaction solution was cooled to room temperature, then was poured into a mixture of methanol (240 mL) / concentrated hydrochloric acid (10 mL), and stirred at room temperature for two hours. The precipitate was filtered, washed with methanol, and then sequentially soxhlet extracted with methanol, acetone, and ethyl acetate so as to remove soluble impurities. Subsequently, soxhlet extraction was performed with chloroform, and the obtained solution was concentrated under reduced pressure. Thereafter, methanol was added, and the precipitated solid content was filtered and washed with methanol. This was vacuum-dried at 80°C for 12 hours so as to obtain 201 mg of the organic semiconductor polymer O-1 (yield: 82%).

The number-average molecular weight of the obtained organic semiconductor polymer O-1 was $2.4 \times 10^4$, and the weight-average molecular weight thereof was $7.5 \times 10^4$.

In the synthesis of the organic semiconductor polymer O-1, the monomer concentration, reaction temperature, and the like were controlled so as to obtain an organic semiconductor polymer O-1 having a different molecular weight.

<Synthesis Examples 2 to 9: Synthesis of organic semiconductor polymers O-2 to O-9>

The monomer used in Synthesis Example 1 was changed so as to synthesize organic semiconductor polymers O-2 to O-9 based on Synthesis Example 1.

Insulating polymers In-1 to In-12 used in this example were polymers consisting of structural units represented below. In-9 was a random copolymer, and In-10 was a block copolymer consisting of one of the two kinds of blocks. In both of In-9 and 10, the molar ratio of the two repeating units was 1 : 1.

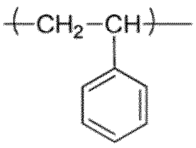

In-1

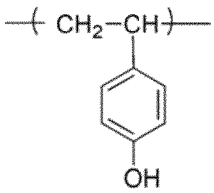

In-2

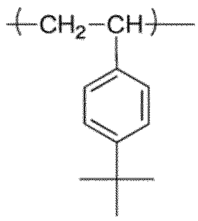

In-3

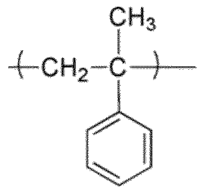

In-4

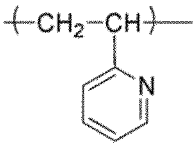

In-5

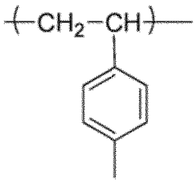

In-6

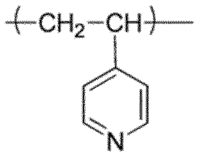

In-7

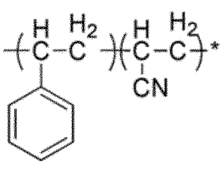

In-8

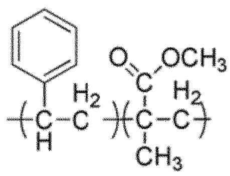

In-9 (co-polymer)

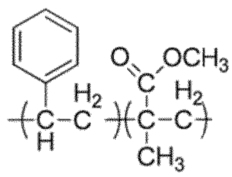

In-10 (block)

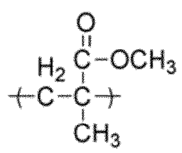

In-11

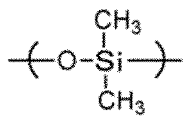

In-12

In-1 to In-12 were commercially available products, and the obtained site and Mw are presented in Table A below.

[Table 1]

Table A

| | Chemical name | Model No. | Manufacturer | Mw ($\times 10^3$) |
|---|---|---|---|---|
| In-1 | Polystyrene | A-2500 | Tosoh Corporation | 2.5 |
| | | A-5000 | Tosoh Corporation | 5.9 |
| | | F-1 | Tosoh Corporation | 10 |
| | | F-2 | Tosoh Corporation | 17 |
| | | F-4 | Tosoh Corporation | 37 |
| | | F-10 | Tosoh Corporation | 99 |
| | | F-40 | Tosoh Corporation | 397 |
| | | F-80 | Tosoh Corporation | 707 |
| | | F-128 | Tosoh Corporation | 1110 |
| In-2 | Poly(4-hydroxy styrene) | 436224 | Sigma Aldrich LLC. | 25 |
| In-3 | Poly(4-t-butyl styrene) | P1579-4tBuS | Polymer Source Inc. | 41 |
| In-4 | Poly($\alpha$-methyl styrene) | P74-MeS | Polymer Source Inc. | 32 |
| In-5 | Poly(2-vinyl pyridine) | P15016-2VP | Polymer Source Inc. | 39 |
| In-6 | Poly(4-methyl styrene) | P1346-4MeS | Polymer Source Inc. | 41 |
| In-7 | Poly(4-vinyl pyridine) | P1027-4VP | Polymer Source Inc. | 35 |
| In-8 | Poly(styrene-co-acrylonitrile) | 182869 | Sigma Aldrich LLC. | 185 |
| In-9 | Poly(styrene-co- methyl methacrylate) | 462896 | Sigma Aldrich LLC. | 100 |
| In-10 | Poly(styrene-block-methyl methacrylate) | P4007-SMMA | Polymer Source Inc. | 79 |
| In-11 | Poly(methyl methacrylate) | P14200-MMA | Polymer Source Inc. | 39 |
| In-12 | Poly(dimethyl siloxane) | P7280-DMS | Polymer Source Inc. | 77 |

All of the volume resistivity of the insulating polymers In-1 to In-12 was $10^6$ $\Omega$cm or more. All of the glass transition temperatures of In-1 to In-12 were 180°C or less.

[Preparation Example 1: Preparation of organic semiconductor composition using organic semiconductor polymer O-1]

<Preparation of organic semiconductor compositions 1-1 to 1-24 and comparative organic semiconductor composition c1-1 to c1-5>

The respective organic semiconductor polymers O-1 and the respective insulating polymers synthesized above were dissolved in chlorobenzene (SP value: 19.4 $MPa^{1/2}$), so as to have concentrations presented in Table 1, so as to prepare the organic semiconductor compositions 1-1 to 1-24 of the present invention and the organic semiconductor compositions c1-1 to c1-5 for comparison.

In all of the organic semiconductor compositions 1-1 to 1-24, P1 / P2 described above was 1 to 2. In all of the organic semiconductor compositions included in the organic semiconductor compositions of the present invention, which were used in examples subsequent to Example 2 below, P1 / P2 was 1 to 2.

[Example 1 and Comparative Example c1: Manufacturing of organic thin film transistors]

A bottom gate-top contact-type organic thin film transistor 300 illustrated in Fig. 3 was manufactured.

A 25 mm $\times$ 25 mm substrate on which a 350 nm thermal oxide film of SiO2 was formed on the surface of a conductive n-type silicon substrate (0.7 mm thickness) was used as a substrate 212. The surface of the thermal oxide film of the substrate 212 was washed with ultraviolet (UV) / ozone and treated with $\beta$-phenytiltrimethoxysilane. The surface free energy of the substrate after the treatment was 36 mN/m.

The organic semiconductor composition prepared above was spin-coated (2,000 rpm for 90 seconds) on the

β-phenytiltrimethoxysilane treated side of the substrate 212 and then dried on a hot plate at 200°C for one hour so as to form an organic semiconductor layer (film thickness of about 20 nm). The obtained organic semiconductor layer was masked, 1.5 nm of 7,7,8,8-tetracyanoquinodimethane (Tokyo Chemical Industry Co., Ltd.) and 50 nm of a gold electrode were vapor-deposited, so as to form a source electrode and a drain electrode, such that the organic thin film transistors 1-1 to 1-24 (Examples 1-1 to 1-24) of the present invention and the organic thin film transistors c1-1 to c1-5 (Comparative Examples c1-1 to c1-5) for comparison were manufactured.

The organic thin film transistors 1-1 to 1-24 were respectively obtained by using the organic semiconductor compositions 1-1 to 1-24, and the organic thin film transistors c1-1 to c1-5 were respectively obtained by using the organic semiconductor compositions c1-1 to c1-5.

[Test Example 1: Evaluation of carrier mobility]

In the manufactured respective organic thin film transistors, the following performance evaluation was performed at an atmosphere by using a semiconductor characteristics evaluation device 4155 C (trade name, manufactured by Agilent Technologies, Japan, Ltd.) The results thereof are presented in Table 1.

<Measurement of carrier mobility μ>

A voltage of-15V was applied between the source electrodes and the drain electrodes of the respective organic thin film transistors, a gate voltage was changed in the range of + 40 V to - 40 V, and the carrier mobility μ ($cm^2/Vs$) was calculated by using an equation below indicating a drain current $I_d$. The obtained carrier mobility μ was evaluated by the evaluation standard below. As the carrier mobility μ was higher, the carrier mobility μ is more preferable. In this test, "D" or more is preferable, "C" or more is more preferable, "B" or more is even more preferable, and "A" or more is still even more preferable.

$$I_d = (w / 2L)\, \mu C_i\, (V_g - V_{th})^2$$

In the equation, L is a gate length, w is a gate width, μ is carrier mobility, $C_i$ is the capacitance per unit area of the gate insulating layer, $V_g$ is a gate voltage, and $V_{th}$ is a threshold voltage.

With respect to the carrier mobility μ,

"A": 3 times or more of the organic thin film transistor c1-1.
"B": More than 1.5 times and 3 times or less of the organic thin film transistor c1-1.
"C": More than 1.2 and 1.5 times or less of the organic thin film transistor c1-1.
"D": More than 1.0 and 1.2 times or less of the organic thin film transistor c1-1.
"E": Equal to the organic thin film transistor c1-1.
"F": Less than the organic thin film transistor c1-1.

Results thereof are as presented in Table 1.

In the table below, a "difference in absolute value of SP value" is a difference between the SP value of the structural unit represented by Formula (1) and the SP value of the structural unit represented by Formula (I-1) (SP values of structural units indicated in the respective formulae with respect to In-11 and In-12) and is an index of compatibility between the organic semiconductor polymer and the insulating polymer.

"γ1" means surface free energy of the organic semiconductor polymer, and "y2" means surface free energy of the insulating polymer. In the column of "γ1 < y2", a case where γ1 < γ2 was satisfied is indicated as "Y", and a case where γ1 < γ2 was not satisfied is indicated as "N".

"UC1" is referred to as a content of the organic semiconductor polymer at the upper half of the organic semiconductor layer, and "UC2" is referred to as a content of the insulating polymer at the upper half of the organic semiconductor layer. "LC1" is referred to as a content of the organic semiconductor polymer at the lower half of the organic semiconductor layer, and "LC2" is referred to as a content of the insulating polymer at the lower half of the organic semiconductor layer. A case where (UC1 / UC2) > (LC1 / LC2) was satisfied is indicated as "Y", and a case where (UC1 / UC2) > (LC1 / LC2) was not satisfied is indicated as "N".

[Table 2]

Table 1

| | Organic semiconductor composition | | | | | | Mw1 / Mw2 | C1/C2 | Difference of absolute values of SP values ($MPa^{1/2}$) | γ1<γ2 | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 (×$10^3$) | Concentration in composition (C1 mg/mL) | Structure | Mw2 (×$10^3$) | Concentration in Composition (C2 mg/mL) | | | | | | |
| Example 1-1 | o-1 | 75 | 5 | In-1 | 37 | 5 | 2.0 | 1.0 | 0.5 | Y | Y | B |
| Example 1-2 | o-1 | 75 | 5 | In-1 | 37 | 2.5 | 2.0 | 2.0 | 0.5 | Y | Y | B |
| Example 1-3 | o-1 | 75 | 5 | In-1 | 37 | 1.7 | 2.0 | 2.9 | 0.5 | Y | Y | B |
| Example 1-4 | o-1 | 75 | 5 | In-1 | 37 | 10 | 2.0 | 0.5 | 0.5 | Y | Y | c |
| Example 1-5 | o-1 | 75 | 5 | In-1 | 37 | 1 | 2.0 | 5.0 | 0.5 | Y | Y | c |
| Example 1-6 | o-1 | 75 | 5 | In-1 | 37 | 0.5 | 2.0 | 10.0 | 0.5 | Y | Y | D |
| Example 1-7 | o-1 | 75 | 5 | In-1 | 37 | 50 | 2.0 | 0.10 | 0.5 | Y | Y | D |
| Example 1-8 | o-1 | 75 | 5 | In-1 | 10 | 5 | 7.5 | 1.0 | 0.5 | Y | Y | D |
| Example 1-9 | o-1 | 75 | 5 | In-1 | 17 | 5 | 4.4 | 1.0 | 0.5 | Y | Y | B |
| Example 1-10 | o-1 | 75 | 5 | In-1 | 99 | 5 | 0.8 | 1.0 | 0.5 | Y | Y | C |
| Example 1-11 | o-1 | 75 | 5 | In-1 | 707 | 5 | 0.11 | 1.0 | 0.5 | Y | Y | D |
| Example 1-12 | o-1 | 50 | 5 | In-1 | 37 | 5 | 1.4 | 1.0 | 0.5 | Y | Y | B |
| Example 1-13 | o-1 | 25 | 5 | In-1 | 37 | 5 | 0.7 | 1.0 | 0.5 | Y | Y | c |
| Example 1-14 | o-1 | 75 | 5 | In-2 | 25 | 5 | 3.0 | 1.0 | 1.6 | Y | Y | B |
| Example 1-15 | o-1 | 75 | 5 | In-3 | 41 | 5 | 1.8 | 1.0 | 1.1 | Y | Y | B |
| Example 1-16 | o-1 | 75 | 5 | In-4 | 32 | 5 | 2.3 | 1.0 | 0.1 | Y | Y | B |

(continued)

| | Organic semiconductor composition | | | | | | Mw1 / Mw2 | C1/C2 | Difference of absolute values of SP values ($MPa^{1/2}$) | $\gamma 1<\gamma 2$ | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 1-17 | o-1 | 75 | 5 | In-5 | 39 | 5 | 1.9 | 1.0 | 1.1 | Y | Y | C |
| Example 1-18 | o-1 | 75 | 5 | In-6 | 41 | 5 | 1.8 | 1.0 | 0.1 | Y | Y | B |
| Example 1-19 | o-1 | 75 | 5 | In-7 | 35 | 5 | 2.1 | 1.0 | 1.1 | Y | Y | C |
| Example 1-20 | o-1 | 75 | 5 | In-8 | 185 | 5 | 0.4 | 1.0 | 0.7 | Y | Y | B |
| Example 1-21 | o-1 | 75 | 5 | In-9 | 100 | 5 | 0.8 | 1.0 | 0.6 | Y | Y | B |
| Example 1-22 | o-1 | 75 | 5 | In-10 | 79 | 5 | 0.9 | 1.0 | 0.6 | Y | Y | B |
| Example 1-23 | o-1 | 75 | 5 | In-11 | 39 | 5 | 1.9 | 1.0 | 1.7 | Y | Y | c |
| Example 1-24 | o-1 | 75 | 5 | In-12 | 77 | 5 | 1.0 | 1.0 | 6.6 | N | N | D |
| Comparative Example c1-1 | o-1 | 75 | 5 | None | - | - | - | - | - | - | - | E |
| Comparative Example c1-2 | o-1 | 75 | 5 | In-1 | 37 | 0.25 | 2.0 | 20.0 | 0.5 | Y | Y | E |
| Comparative Example c1-3 | o-1 | 75 | 5 | In-1 | 37 | 100 | 2.0 | 0.05 | 0.5 | Y | Y | F |
| Comparative Example c1-4 | o-1 | 75 | 5 | In-1 | 5.9 | 5 | 12.7 | 1.0 | 0.5 | Y | Y | E |
| Comparative Example c1-5 | o-1 | 75 | 5 | In-1 | 1.110 | 5 | 0.07 | 1.0 | 0.5 | Y | Y | F |

As presented in Table 1, in a case where the organic semiconductor layer does not contain the insulating polymer, and even in a case where the organic semiconductor layer contains the insulating polymer, but the molecular weight or the content thereof is out of the range defined in the present invention, a result in which the carrier mobility was deteriorated was obtained (Comparative Examples c1-1 to c1-5).

In contrast, in a case where the organic semiconductor layer contains the insulating polymer, and the molecular weight and the content are out of the range defined in the present invention, a result in which the carrier mobility was increased was obtained (Examples 1-1 to 1-24).

That is, in a case where the organic semiconductor layer was formed by using the organic semiconductor composition of the present invention, the performances of the obtained organic thin film transistor were able to be increased.

[Example 2 and Comparative Example c2]

In Example 1 and Comparative Example c1, bottom gate-top contact-type organic thin film transistors 2-1 to 2-24 (Examples 2-1 to 2-24) and organic thin film transistors c2-1 to c2-5 (Comparative Examples c1-1 to c1-5) for comparison were respectively manufactured in the same manner as in Example 1 and Comparative Example c1 except that the organic semiconductor polymer O-1 contained in the organic semiconductor composition used was substituted with an organic semiconductor polymer O-2. With respect to the respective obtained organic thin film transistors, in the same manner as in Test Example 1, the carrier mobility was evaluated (carrier mobility of the organic thin film transistor c2-1 was evaluated as "E"). The results thereof are presented in Table 2.

[Table 3]

Table 2

| | Organic semiconductor composition | | | | | | Mw1 / Mw2 | C1/C2 | Difference of absolute values of SP values ($MPa^{1/2}$) | $\gamma1<\gamma2$ | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 ($\times10^3$) | Concentration in composition (C1 mg/mL) | Structure | Mw2 ($\times10^3$) | Concentration in Composition (C2 mg/mL) | | | | | | |
| Example 2-1 | o-2 | 89 | 0.5 | In-1 | 37 | 0.5 | 2.4 | 1.0 | 0.2 | Y | Y | B |
| Example 2-2 | o-2 | 89 | 0.5 | In-1 | 37 | 0.25 | 2.4 | 2.0 | 0.2 | Y | Y | B |
| Example 3-3 | o-2 | 89 | 0.5 | In-1 | 37 | 0.17 | 2.4 | 2.9 | 0.2 | Y | Y | B |
| Example 2-4 | o-2 | 89 | 0.5 | In-1 | 37 | 1 | 2.4 | 0.5 | 0.2 | Y | Y | c |
| Example 2-5 | o-2 | 89 | 0.5 | In-1 | 37 | 0.1 | 2.4 | 5.0 | 0.2 | Y | Y | B |
| Example 2-6 | o-2 | 89 | 0.5 | In-1 | 37 | 0.05 | 2.4 | 10.0 | 0.2 | Y | Y | c |
| Example 2-7 | o-2 | 89 | 0.5 | In-1 | 37 | 5 | 2.4 | 0.10 | 0.2 | Y | Y | D |
| Example 2-8 | o-2 | 89 | 0.5 | In-1 | 10 | 0.5 | 8.9 | 1.0 | 0.2 | Y | Y | D |
| Example 2-9 | o-2 | 89 | 0.5 | In-1 | 17 | 0.5 | 5.2 | 1.0 | 0.2 | Y | Y | B |
| Example 2-10 | o-2 | 89 | 0.5 | In-1 | 99 | 0.5 | 0.9 | 1.0 | 0.2 | Y | Y | C |
| Example 2-11 | o-2 | 89 | 0.5 | In-1 | 707 | 0.5 | 0.13 | 1.0 | 0.2 | Y | Y | D |
| Example 2-12 | o-2 | 70 | 0.5 | In-1 | 37 | 0.5 | 1.9 | 1.0 | 0.2 | Y | Y | B |
| Example 2-13 | o-2 | 50 | 0.5 | In-1 | 37 | 0.5 | 1.4 | 1.0 | 0.2 | Y | Y | c |
| Example 2-14 | o-2 | 89 | 0.5 | In-2 | 25 | 0.5 | 3.6 | 1.0 | 1.3 | Y | Y | B |
| Example 2-15 | o-2 | 89 | 0.5 | In-3 | 41 | 0.5 | 2.2 | 1.0 | 1.4 | Y | Y | B |
| Example 2-16 | o-2 | 89 | 0.5 | In-4 | 32 | 0.5 | 2.8 | 1.0 | 0.4 | Y | Y | B |

(continued)

| | Organic semiconductor composition | | | | | | Mw1 / Mw2 | C1/C2 | Difference of absolute values of SP values ($MPa^{1/2}$) | γ1<γ2 | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 (×$10^3$) | Concentration in composition (C1 mg/mL) | Structure | Mw2 (×$10^3$) | Concentration in Composition (C2 mg/mL) | | | | | | |
| Example 2-17 | o-2 | 89 | 0.5 | In-5 | 39 | 0.5 | 2.3 | 1.0 | 0.8 | Y | Y | C |
| Example 2-18 | o-2 | 89 | 0.5 | In-6 | 41 | 0.5 | 2.2 | 1.0 | 0.4 | Y | Y | B |
| Example 2-19 | o-2 | 89 | 0.5 | In-7 | 35 | 0.5 | 2.5 | 1.0 | 0.8 | Y | Y | C |
| Example 2-20 | o-2 | 89 | 0.5 | In-8 | 185 | 0.5 | 0.5 | 1.0 | 0.4 | Y | Y | B |
| Example 2-21 | o-2 | 89 | 0.5 | In-9 | 100 | 0.5 | 0.9 | 1.0 | 0.9 | Y | Y | B |
| Example 2-22 | o-2 | 89 | 0.5 | In-10 | 79 | 0.5 | 1.1 | 1.0 | 0.9 | Y | Y | B |
| Example 2-23 | o-2 | 89 | 0.5 | In-11 | 39 | 0.5 | 2.3 | 1.0 | 2.0 | Y | Y | c |
| Example 2-24 | o-2 | 89 | 0.5 | In-12 | 77 | 0.5 | 1.2 | 1.0 | 6.9 | N | N | D |
| Comparative Example c2-1 | o-2 | 89 | 0.5 | None | - | - | - | - | - | - | - | E |
| Comparative Example c2-2 | o-2 | 89 | 0.5 | In-1 | 37 | 0.025 | 2.4 | 20.0 | 0.2 | Y | Y | E |
| Comparative Example c2-3 | o-2 | 89 | 0.5 | In-1 | 37 | 10 | 2.4 | 0.05 | 0.2 | Y | Y | F |
| Comparative Example c2-4 | o-2 | 89 | 0.5 | In-1 | 5.9 | 0.5 | 15.1 | 1.0 | 0.2 | Y | Y | F |
| Comparative Example c2-5 | o-2 | 89 | 0.5 | In-1 | 1,110 | 0.5 | 0.08 | 1.0 | 0.2 | Y | Y | F |

As presented in Table 2, in a case where the organic semiconductor layer does not contain the insulating polymer and even in a case where the insulating polymer is contained, but the molecular weight or the content thereof was out of the range defined in the present invention, a result in which the carrier mobility was deteriorated was obtained (Comparative Examples c2-1 to c2-5).

In contrast, in a case where the organic semiconductor layer contains the insulating polymer and the molecular weight and the content thereof are in the range defined in the present invention, a result in which carrier mobility was increased was obtained (Examples 2-1 to 2-24).

That is, it is understood that, in a case where the organic semiconductor layer was formed by using the organic semiconductor composition of the present invention, the performances of the obtained organic thin film transistor were able to be increased.

[Example 3 and Comparative Example c3]

In Example 1 and Comparative Example c1, bottom gate-top contact-type organic thin film transistors 3-1 to 3-24 (Examples 3-1 to 3-24) and organic thin film transistors c3-1 to c3-5 (Comparative Examples c3-1 to c3-5) for comparison were respectively manufactured in the same manner as in Example 1 and Comparative Example c1, except that the organic semiconductor polymer O-1 contained in the organic semiconductor composition used was substituted with an organic semiconductor polymer O-3. With respect to the respective obtained organic thin film transistors, in the same manner as in Test Example 1, the carrier mobility was evaluated (carrier mobility of the organic thin film transistor c3-1 was evaluated as "E"). The results thereof are presented in Table 3.

[Table 4]

Table 3

| | Organic semiconductor composition | | | | | | Mw1 / Mw2 | C1/C2 | Difference of absolute values of SP values ($MPa^{1/2}$) | γ1<γ2 | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 (×$10^3$) | Concentration in composition (C1 mg/mL) | Structure | Mw2 (×$10^3$) | Concentration in Composition (C2 mg/mL) | | | | | | |
| Example 3-1 | o-3 | 78 | 1 | In-1 | 37 | 1 | 2.1 | 1.0 | 0.1 | Y | Y | B |
| Example 3-2 | o-3 | 78 | 1 | In-1 | 37 | 0.5 | 2.1 | 2.0 | 0.1 | Y | Y | B |
| Example 3-3 | o-3 | 78 | 1 | In-1 | 37 | 0.35 | 2.1 | 2.9 | 0.1 | Y | Y | B |
| Example 3-4 | o-3 | 78 | 1 | In-1 | 37 | 2 | 2.1 | 0.5 | 0.1 | Y | Y | c |
| Example 3-5 | o-3 | 78 | 1 | In-1 | 37 | 0.2 | 2.1 | 5.00 | 0.1 | Y | Y | D |
| Example 3-6 | o-3 | 78 | 1 | In-1 | 37 | 0.1 | 2.11 | 10.0 | 0.1 | Y | Y | D |
| Example 3-7 | o-3 | 78 | 1 | In-1 | 37 | 10 | 2.1 | 0.10 | 0.1 | Y | Y | D |
| Example 3-8 | o-3 | 78 | 1 | In-1 | 10 | 1 | 7.80 | 1.0 | 0.1 | Y | Y | D |
| Example 3-9 | o-3 | 78 | 1 | In-1 | 17 | 1 | 4.59 | 1.0 | 0.1 | Y | Y | C |
| Example 3-10 | o-3 | 78 | 1 | In-1 | 99 | 1 | 0.8 | 1.0 | 0.1 | Y | Y | c |
| Example 3-11 | o-3 | 78 | 1 | In-1 | 707 | 1 | 0.11 | 1.0 | 0.1 | Y | Y | D |
| Example 3-12 | o-3 | 70 | 1 | In-1 | 37 | 1 | 1.9 | 1.0 | 0.1 | Y | Y | B |
| Example 3-13 | o-3 | 60 | 1 | In-1 | 37 | 1 | 1.6 | 1.0 | 0.1 | Y | Y | B |
| Example 3-14 | o-3 | 78 | 1 | In-2 | 25 | 1 | 3.1 | 1.0 | 1.2 | Y | Y | B |
| Example 3-15 | o-3 | 78 | 1 | In-3 | 41 | 1 | 1.9 | 1.0 | 1.5 | Y | Y | B |
| Example 3-16 | o-3 | 78 | 1 | In-4 | 32 | 1 | 2.4 | 1.0 | 0.5 | Y | Y | B |

(continued)

| | Organic semiconductor composition | | | | | | Mw1 / Mw2 | C1/C2 | Difference of absolute values of SP values ($MPa^{1/2}$) | $\gamma1<\gamma2$ | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 3-17 | o-3 | 78 | 1 | In-5 | 39 | 1 | 2.0 | 1.0 | 0.7 | Y | Y | C |
| Example 3-18 | o-3 | 78 | 1 | In-6 | 41 | 1 | 1.90 | 1.0 | 0.5 | Y | Y | B |
| Example 3-19 | o-3 | 78 | 1 | In-7 | 35 | 1 | 2.23 | 1.0 | 0.7 | Y | Y | C |
| Example 3-20 | o-3 | 78 | 1 | In-8 | 185 | 1 | 0.4 | 1.0 | 0.3 | Y | Y | B |
| Example 3-21 | o-3 | 78 | 1 | In-9 | 100 | 1 | 0.8 | 1.0 | 1 | Y | Y | B |
| Example 3-22 | o-3 | 78 | 1 | In-10 | 79 | 1 | 1.0 | 1.0 | 1 | Y | Y | B |
| Example 3-23 | o-3 | 78 | 1 | In-11 | 39 | 1 | 2.0 | 1.0 | 2.1 | Y | Y | c |
| Example 3-24 | o-3 | 78 | 1 | In-12 | 77 | 1 | 1.0 | 1.0 | 7 | N | N | D |
| Comparative Example c3-1 | o-3 | 78 | 1 | None | - | - | - | - | - | - | - | E |
| Comparative Example c3-2 | o-3 | 78 | 1 | In-1 | 37 | 0.05 | 2.1 | 20.0 | 0.1 | Y | Y | E |
| Comparative Example c3-3 | o-3 | 78 | 1 | In-1 | 37 | 20 | 2.1 | 0.05 | 0.1 | Y | Y | F |
| Comparative Example c3-4 | o-3 | 78 | 1 | In-1 | 5.9 | 1 | 13.2 | 1.0 | 0.1 | Y | Y | F |
| Comparative Example c3-5 | o-3 | 78 | 1 | In-1 | 1.110 | 1 | 0.07 | 1.0 | 0.1 | Y | Y | F |

As presented in Table 3, in a case where the organic semiconductor layer does not contain the insulating polymer, and even in a case where the organic semiconductor layer contains the insulating polymer, but the molecular weight or the content thereof is out of the range defined in the present invention, a result in which the carrier mobility was deteriorated was obtained (Comparative Examples c3-1 to c3-5).

In contrast, in a case where the organic semiconductor layer contains the insulating polymer, and the molecular weight and the content are out of the range defined in the present invention, a result in which the carrier mobility was increased was obtained (Examples 3-1 to 3-24).

That is, in a case where the organic semiconductor layer was formed by using the organic semiconductor composition of the present invention, the performances of the obtained organic thin film transistor were able to be increased.

[Example 4 and Comparative Example c4]

In Example 1 and Comparative Example c1, bottom gate-top contact-type organic thin film transistors 4-1 to 4-24 (Examples 4-1 to 4-24) and organic thin film transistors c4-1 to c4-5 (Comparative Examples c4-1 to c4-5) for comparison were respectively manufactured in the same manner as in Example 1 and Comparative Example c1, except that the organic semiconductor polymer O-1 contained in the organic semiconductor composition used was substituted with an organic semiconductor polymer O-4. With respect to the respective obtained organic thin film transistors, in the same manner as in Test Example 1, the carrier mobility was evaluated (carrier mobility of the organic thin film transistor c4-1 was evaluated as "E"). The results thereof are presented in Table 4.

[Table 5]

Table 4

| | Organic semiconductor composition | | | | | | Mw1 / Mw2 | C1/C2 | Difference of absolute values of SP values ($MPa^{1/2}$) | $\gamma1 < \gamma2$ | (UC1 / UC2) > (LC1 / LC2) | Carrier mobility |
|---|---|---|---|---|---|---|---|---|---|---|---|---|
| | Organic semiconductor polymer | | | Insulating polymer | | | | | | | | |
| | Structure | Mw1 ($\times10^3$) | Concentration in composition (C1 mg/mL) | Structure | Mw2 ($\times10^3$) | Concentration in Composition (C2 mg/mL) | | | | | | |
| Example 4-1 | o-4 | 32 | 3 | In-1 | 37 | 3 | 0.9 | 1.0 | 0.5 | Y | Y | c |
| Example 4-2 | o-4 | 32 | 3 | In-1 | 37 | 1.5 | 0.9 | 2.0 | 0.5 | Y | Y | B |
| Example 4-3 | o-4 | 32 | 3 | In-1 | 37 | 1 | 0.9 | 3.0 | 0.5 | Y | Y | C |
| Example 4-4 | o-4 | 32 | 3 | In-1 | 37 | 6 | 0.9 | 0.5 | 0.5 | Y | Y | c |
| Example 4-5 | o-4 | 32 | 3 | In-1 | 37 | 0.6 | 0.9 | 5.00 | 0.5 | Y | Y | c |
| Example 4-6 | o-4 | 32 | 3 | In-1 | 37 | 0.3 | 0.86 | 10.0 | 0.5 | Y | Y | D |
| Example 4-7 | o-4 | 32 | 3 | In-1 | 37 | 30 | 0.9 | 0.10 | 0.5 | Y | Y | D |
| Example 4-8 | o-4 | 32 | 3 | In-1 | 10 | 3 | 3.20 | 1.0 | 0.5 | Y | Y | C |
| Example 4-9 | o-4 | 32 | 3 | In-1 | 17 | 3 | 1.9 | 1.0 | 0.5 | Y | Y | B |
| Example 4-10 | o-4 | 32 | 3 | In-1 | 99 | 3 | 0.3 | 1.0 | 0.5 | Y | Y | C |
| Example 4-11 | o-4 | 32 | 3 | In-1 | 5.9 | 3 | 5.4 | 1.0 | 0.5 | Y | Y | D |
| Example 4-12 | o-4 | 50 | 3 | In-1 | 37 | 3 | 1.4 | 1.0 | 0.5 | Y | Y | B |
| Example 4-13 | o-4 | 25 | 3 | In-1 | 37 | 3 | 0.7 | 1.0 | 0.5 | Y | Y | B |
| Example 4-14 | o-4 | 32 | 3 | In-2 | 25 | 3 | 1.3 | 1.0 | 1.6 | Y | Y | B |
| Example 4-15 | o-4 | 32 | 3 | In-3 | 41 | 3 | 0.8 | 1.0 | 1.1 | Y | Y | B |
| Example 4-16 | o-4 | 32 | 3 | In-4 | 32 | 3 | 1.0 | 1.0 | 0.1 | Y | Y | B |

(continued)

| | Organic semiconductor composition | | | | | | Mw1 / Mw2 | C1/C2 | Difference of absolute values of SP values ($MPa^{1/2}$) | $\gamma 1 < \gamma 2$ | (UC1 / UC2) > (LC1 / LC2) | Carrier mobility |
|---|---|---|---|---|---|---|---|---|---|---|---|---|
| | Organic semiconductor polymer | | | Insulating polymer | | | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 4-17 | o-4 | 32 | 3 | In-5 | 39 | 3 | 0.8 | 1.0 | 1.1 | Y | Y | C |
| Example 4-18 | o-4 | 32 | 3 | In-6 | 41 | 3 | 0.78 | 1.0 | 0.1 | Y | Y | B |
| Example 4-19 | o-4 | 32 | 3 | In-7 | 35 | 3 | 0.91 | 1.0 | 1.1 | Y | Y | C |
| Example 4-20 | o-4 | 32 | 3 | In-8 | 185 | 3 | 0.2 | 1.0 | 0.7 | Y | Y | B |
| Example 4-21 | o-4 | 32 | 3 | In-9 | 100 | 3 | 0.3 | 1.0 | 0.6 | Y | Y | B |
| Example 4-22 | o-4 | 32 | 3 | In-10 | 79 | 3 | 0.4 | 1.0 | 0.6 | Y | Y | B |
| Example 4-23 | o-4 | 32 | 3 | In-11 | 39 | 3 | 0.8 | 1.0 | 1.7 | Y | Y | c |
| Example 4-24 | o-4 | 32 | 3 | In-12 | 77 | 3 | 0.4 | 1.0 | 6.6 | N | N | D |
| Comparative Example c4-1 | o-4 | 32 | 3 | None | - | - | - | - | - | - | - | E |
| Comparative Example c4-2 | o-4 | 32 | 3 | In-1 | 37 | 0.15 | 0.9 | 20.0 | 0.5 | Y | Y | E |
| Comparative Example c4-3 | o-4 | 32 | 3 | In-1 | 37 | 60 | 0.9 | 0.05 | 0.5 | Y | Y | F |
| Comparative Example c4-4 | o-4 | 32 | 3 | In-1 | 2.5 | 3 | 12.8 | 1.0 | 0.5 | Y | Y | E |
| Comparative Example c4-5 | o-4 | 32 | 3 | In-1 | 1.110 | 3 | 0.03 | 1.0 | 0.5 | Y | Y | F |

As presented in Table 4, in a case where the organic semiconductor layer does not contain the insulating polymer, and even in a case where the organic semiconductor layer contains the insulating polymer, but the molecular weight or the content thereof is out of the range defined in the present invention, a result in which the carrier mobility was deteriorated was obtained (Comparative Examples c4-1 to c4-5).

In contrast, in a case where the organic semiconductor layer contains the insulating polymer, and the molecular weight and the content are out of the range defined in the present invention, a result in which the carrier mobility was increased was obtained (Examples 4-1 to 4-24).

That is, in a case where the organic semiconductor layer was formed by using the organic semiconductor composition of the present invention, the performances of the obtained organic thin film transistor were able to be increased.

[Example 5 and Comparative Example c5]

In Example 1 and Comparative Example c1, bottom gate-top contact-type organic thin film transistors 5-1 to 5-24 (Examples 5-1 to 5-24) and organic thin film transistors c5-1 to c5-5 (Comparative Examples c5-1 to c5-5) for comparison were respectively manufactured in the same manner as in Example 1 and Comparative Example cl, except that the organic semiconductor polymer O-1 contained in the organic semiconductor composition used was substituted with an organic semiconductor polymer O-5. With respect to the respective obtained organic thin film transistors, in the same manner as in Test Example 1, the carrier mobility was evaluated (carrier mobility of the organic thin film transistor c5-1 was evaluated as "E"). The results thereof are presented in Table 5.

[Table 6]

Table 5

| | Organic semiconductor composition | | | | | | Mw1 / Mw2 | C1 / C2 | Difference of absolute values of SP values ($MPa^{1/2}$) | $\gamma1 < \gamma2$ | (UC1 / UC2) > (LC1 / LC2) | Carrier mobility |
|---|---|---|---|---|---|---|---|---|---|---|---|---|
| | Organic semiconductor polymer | | | Insulating polymer | | | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 5-1 | o-5 | 50 | 1 | In-1 | 37 | 1 | 1.4 | 1.0 | 0.0 | Y | Y | B |
| Example 5-2 | o-5 | 50 | 1 | In-1 | 37 | 0.5 | 1.4 | 2.0 | 0.0 | Y | Y | B |
| Example 5-3 | o-5 | 50 | 1 | In-1 | 37 | 0.33 | 1.4 | 3.0 | 0.0 | Y | Y | B |
| Example 5-4 | o-5 | 50 | 1 | In-1 | 37 | 2 | 1.4 | 0.5 | 0.0 | Y | Y | C |
| Example 5-5 | o-5 | 50 | 1 | In-1 | 37 | 0.2 | 1.4 | 5.0 | 0.0 | Y | Y | C |
| Example 5-6 | o-5 | 50 | 1 | In-1 | 37 | 0.1 | 1.35 | 10 | 0.0 | Y | Y | D |
| Example 5-7 | o-5 | 50 | 1 | In-1 | 37 | 10 | 1.4 | 0.10 | 0.0 | Y | Y | D |
| Example 5-8 | o-5 | 50 | 1 | In-1 | 10 | 1 | 5.00 | 1.0 | 0.0 | Y | Y | C |
| Example 5-9 | o-5 | 50 | 1 | In-1 | 17 | 1 | 2.94 | 1.0 | 0.0 | Y | Y | B |
| Example 5-10 | o-5 | 50 | 1 | In-1 | 99 | 1 | 0.5 | 1.0 | 0.0 | Y | Y | C |
| Example 5-11 | o-5 | 50 | 1 | In-1 | 5.9 | 1 | 8.5 | 1.0 | 0.0 | Y | Y | D |
| Example 5-12 | o-5 | 40 | 1 | In-1 | 37 | 1 | 1.1 | 1.0 | 0.0 | Y | Y | B |
| Example 5-13 | o-5 | 30 | 1 | In-1 | 37 | 1 | 0.8 | 1.0 | 0.0 | Y | Y | C |
| Example 5-14 | o-5 | 50 | 1 | In-2 | 25 | 1 | 2.0 | 1.0 | 1.1 | Y | Y | B |
| Example 5-15 | o-5 | 50 | 1 | In-3 | 41 | 1 | 1.2 | 1.0 | 1.6 | Y | Y | B |
| Example 5-16 | o-5 | 50 | 1 | In-4 | 32 | 1 | 1.6 | 1.0 | 0.6 | Y | Y | B |

(continued)

| | Organic semiconductor composition | | | | | | Mw1 / Mw2 | C1 / C2 | Difference of absolute values of SP values ($MPa^{1/2}$) | $\gamma 1 < \gamma 2$ | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 5-17 | o-5 | 50 | 1 | In-5 | 39 | 1 | 1.3 | 1.0 | 0.6 | Y | Y | C |
| Example 5-18 | o-5 | 50 | 1 | In-6 | 41 | 1 | 1.22 | 1.0 | 0.6 | Y | Y | B |
| Example 5-19 | o-5 | 50 | 1 | In-7 | 35 | 1 | 1.43 | 1.0 | 0.6 | Y | Y | C |
| Example 5-20 | o-5 | 50 | 1 | In-8 | 185 | 1 | 0.3 | 1.0 | 0.2 | Y | Y | B |
| Example 5-21 | o-5 | 50 | 1 | In-9 | 100 | 1 | 0.5 | 1.0 | 1.1 | Y | Y | B |
| Example 5-22 | o-5 | 50 | 1 | In-10 | 79 | 1 | 0.6 | 1.0 | 1.1 | Y | Y | B |
| Example 5-23 | o-5 | 50 | 1 | In-11 | 39 | 1 | 1.3 | 1.0 | 2.2 | Y | Y | C |
| Example 5-24 | o-5 | 50 | 1 | In-12 | 77 | 1 | 0.6 | 1.0 | 7.1 | N | N | D |
| Comparative Example c5-1 | o-5 | 50 | 1 | None | - | - | - | - | - | - | - | E |
| Comparative Example c5-2 | o-5 | 50 | 1 | In-1 | 37 | 0.05 | 1.4 | 20.0 | 0.0 | Y | Y | E |
| Comparative Example c5-3 | o-5 | 50 | 1 | In-1 | 37 | 20 | 1.4 | 0.05 | 0.0 | Y | Y | F |
| Comparative Example c5-4 | o-5 | 50 | 1 | In-1 | 2.5 | 1 | 20.0 | 1.0 | 0.0 | Y | Y | E |
| Comparative Example c5-5 | o-5 | 50 | 1 | In-I | 1.110 | 1 | 0.05 | 1.0 | 0.0 | Y | Y | F |

As presented in Table 5, in a case where the organic semiconductor layer does not contain the insulating polymer, and even in a case where the organic semiconductor layer contains the insulating polymer, but the molecular weight or the content thereof is out of the range defined in the present invention, a result in which the carrier mobility was deteriorated was obtained (Comparative Examples c5-1 to c5-5).

In contrast, in a case where the organic semiconductor layer contains the insulating polymer, and the molecular weight and the content are out of the range defined in the present invention, a result in which the carrier mobility was increased was obtained (Examples 5-1 to 5-24).

That is, in a case where the organic semiconductor layer was formed by using the organic semiconductor composition of the present invention, the performances of the obtained organic thin film transistor were able to be increased.

[Example 6 and Comparative Example c6]

In Example 1 and Comparative Example cl, bottom gate-top contact-type organic thin film transistors 6-1 to 6-24 (Examples 6-1 to 6-24) and organic thin film transistors c6-1 to c6-5 (Comparative Examples c6-1 to c6-5) for comparison were respectively manufactured in the same manner as in Example 1 and Comparative Example cl, except that the organic semiconductor polymer 0-1 contained in the organic semiconductor composition used was substituted with an organic semiconductor polymer O-6. With respect to the respective obtained organic thin film transistors, in the same manner as in Test Example 1, the carrier mobility was evaluated (carrier mobility of the organic thin film transistor c6-1 was evaluated as "E"). The results thereof are presented in Table 6.

[Table 7]

Table 6

| | Organic semiconductor composition | | | | | | Mw1 / Mw2 | C1 / C2 | Difference of absolute values of SP values ($MPa^{1/2}$) | $\gamma1$ < $\gamma2$ | (UC1 / UC2) > (LC1 / LC2) | Carrier mobility |
|---|---|---|---|---|---|---|---|---|---|---|---|---|
| | Organic semiconductor polymer | | | Insulating | polymer | | | | | | | |
| | Structure | Mw1 ($\times10^3$) | Concentration in composition (C1 mg/mL) | Structure | Mw2 ($\times10^3$) | Concentration in Composition (C2 mg/mL) | | | | | | |
| Example 6-1 | o-6 | 98 | 0.5 | In-1 | 37 | 0.5 | 2.6 | 1.0 | 0.8 | Y | Y | C |
| Example 6-2 | o-6 | 98 | 0.5 | In-1 | 37 | 0.25 | 2.6 | 2.0 | 0.8 | Y | Y | C |
| Example 6-3 | o-6 | 98 | 0.5 | In-1 | 37 | 0.175 | 2.6 | 2.9 | 0.8 | Y | Y | C |
| Example 6-4 | o-6 | 98 | 0.5 | In-1 | 37 | 1 | 2.6 | 0.5 | 0.8 | Y | Y | C |
| Example 6-5 | o-6 | 98 | 0.5 | In-1 | 37 | 0.1 | 2.6 | 5.0 | 0.8 | Y | Y | C |
| Example 6-6 | o-6 | 98 | 0.5 | In-1 | 37 | 0.05 | 2.6 | 10.0 | 0.8 | Y | Y | D |
| Example 6-7 | o-6 | 98 | 0.5 | In-1 | 37 | 5 | 2.6 | 0.1 | 0.8 | Y | Y | D |
| Example 6-8 | o-6 | 98 | 0.5 | In-1 | 10 | 0.5 | 9.8 | 1.0 | 0.8 | Y | Y | D |
| Example 6-9 | o-6 | 98 | 0.5 | In-1 | 17 | 0.5 | 5.8 | 1.0 | 0.8 | Y | Y | C |
| Example 6-10 | o-6 | 98 | 0.5 | In-1 | 99 | 0.5 | 1.0 | 1.0 | 0.8 | Y | Y | C |
| Example 6-11 | o-6 | 98 | 0.5 | In-1 | 707 | 0.5 | 0.14 | 1.0 | 0.8 | Y | Y | D |
| Example 6-12 | o-6 | 70 | 0.5 | In-1 | 37 | 0.5 | 1.9 | 1.0 | 0.8 | Y | Y | C |
| Example 6-13 | o-6 | 40 | 0.5 | In-1 | 37 | 0.5 | 1.1 | 1.0 | 0.8 | Y | Y | C |
| Example 6-14 | o-6 | 98 | 0.5 | In-2 | 25 | 0.5 | 3.9 | 1.0 | 1.9 | Y | Y | C |
| Example 6-15 | o-6 | 98 | 0.5 | In-3 | 41 | 0.5 | 2.4 | 1.0 | 0.8 | Y | Y | B |
| Example 6-16 | o-6 | 98 | 0.5 | In-4 | 32 | 0.5 | 3.1 | 1.0 | 0.2 | Y | Y | B |

(continued)

| | Organic semiconductor composition | | | | | | Mw1 / Mw2 | C1 / C2 | Difference of absolute values of SP values ($MPa^{1/2}$) | $\gamma1 < \gamma2$ | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 ($\times10^3$) | Concentration in composition (C1 mg/mL) | Structure | Mw2 ($\times10^3$) | Concentration in Composition (C2 mg/mL) | | | | | | |
| Example 6-17 | o-6 | 98 | 0.5 | In-5 | 39 | 0.5 | 2.5 | 1.0 | 1.4 | Y | Y | D |
| Example 6-18 | o-6 | 98 | 0.5 | In-6 | 41 | 0.5 | 2.4 | 1.0 | 0.2 | Y | Y | B |
| Example 6-19 | o-6 | 98 | 0.5 | In-7 | 35 | 0.5 | 2.8 | 1.0 | 1.4 | Y | Y | D |
| Example 6-20 | o-6 | 98 | 0.5 | In-8 | 185 | 0.5 | 0.5 | 1.0 | 1 | Y | Y | C |
| Example 6-21 | o-6 | 98 | 0.5 | In-9 | 100 | 0.5 | 1.0 | 1.0 | 0.3 | Y | Y | C |
| Example 6-22 | o-6 | 98 | 0.5 | In-10 | 79 | 0.5 | 1.2 | 1.0 | 0.3 | Y | Y | C |
| Example 6-23 | o-6 | 98 | 0.5 | In-11 | 39 | 0.5 | 2.5 | 1.0 | 1.4 | Y | Y | C |
| Example 6-24 | o-6 | 98 | 0.5 | In-12 | 77 | 0.5 | 1.3 | 1.0 | 6.3 | N | N | D |
| Comparative Example c6-1 | o-6 | 98 | 0.5 | None | - | - | - | - | - | - | - | E |
| Comparative Example c6-2 | o-6 | 98 | 0.5 | In-1 | 37 | 0.025 | 2.6 | 20.0 | 0.8 | Y | Y | E |
| Comparative Example c6-3 | o-6 | 98 | 0.5 | In-1 | 37 | 10 | 2.6 | 0.05 | 0.8 | Y | Y | F |
| Comparative Example c6-4 | o-6 | 98 | 0.5 | In-1 | 5.9 | 0.5 | 16.6 | 1.0 | 0.8 | Y | Y | F |
| Comparative Example c6-5 | o-6 | 98 | 0.5 | In-1 | 1.110 | 0.5 | 0.09 | 1.0 | 0.8 | Y | Y | F |

As presented in Table 6, in a case where the organic semiconductor layer does not contain the insulating polymer, and even in a case where the organic semiconductor layer contains the insulating polymer, but the molecular weight or the content thereof is out of the range defined in the present invention, a result in which the carrier mobility was deteriorated was obtained (Comparative Examples c6-1 to c6-5).

In contrast, in a case where the organic semiconductor layer contains the insulating polymer, and the molecular weight and the content are out of the range defined in the present invention, a result in which the carrier mobility was increased was obtained (Examples 6-1 to 6-24).

That is, in a case where the organic semiconductor layer was formed by using the organic semiconductor composition of the present invention, the performances of the obtained organic thin film transistor were able to be increased.

[Example 7 and Comparative Example c7]

In Example 1 and Comparative Example cl, bottom gate-top contact-type organic thin film transistors 7-1 to 7-24 (Examples 7-1 to 7-24) and organic thin film transistors c7-1 to c7-5 (Comparative Examples c7-1 to c7-5) for comparison were respectively manufactured in the same manner as in Example 1 and Comparative Example cl, except that the organic semiconductor polymer O-1 contained in the organic semiconductor composition used was substituted with an organic semiconductor polymer O-7. With respect to the respective obtained organic thin film transistors, in the same manner as in Test Example 1, the carrier mobility was evaluated (carrier mobility of the organic thin film transistor c7-1 was evaluated as "E"). The results thereof are presented in Table 7.

[Table 8]

Table 7

| | Organic semiconductor composition | | | | | | Mw1 / Mw2 | C1 / C2 | Difference of absolute values of SP values ($MPa^{1/2}$) | $\gamma 1 < \gamma 2$ | (UC1 / UC2) > (LC1 / LC2) | Carrier mobility |
|---|---|---|---|---|---|---|---|---|---|---|---|---|
| | Organic semiconductor polymer | | | Insulating polymer | | | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 7-1 | o-7 | 70 | 2 | In-1 | 37 | 2 | 1.9 | 1.0 | 0.5 | Y | Y | C |
| Example 7-2 | o-7 | 70 | 2 | In-1 | 37 | 1 | 1.9 | 2.0 | 0.5 | Y | Y | C |
| Example 7-3 | o-7 | 70 | 2 | In-1 | 37 | 0.66 | 1.9 | 3.0 | 0.5 | Y | Y | C |
| Example 7-4 | o-7 | 70 | 2 | In-1 | 37 | 4 | 1.9 | 0.5 | 0.5 | Y | Y | C |
| Example 7-5 | o-7 | 70 | 2 | In-1 | 37 | 0.4 | 1.9 | 5.00 | 0.5 | Y | Y | C |
| Example 7-6 | o-7 | 70 | 2 | In-1 | 37 | 0.2 | 1.89 | 10.0 | 0.5 | Y | Y | D |
| Example 7-7 | o-7 | 70 | 2 | In-1 | 37 | 20 | 1.9 | 0.1 | 0.5 | Y | Y | D |
| Example 7-8 | o-7 | 70 | 2 | In-1 | 10 | 2 | 7.00 | 1.0 | 0.5 | Y | Y | D |
| Example 7-9 | o-7 | 70 | 2 | In-1 | 17 | 2 | 4.12 | 1.0 | 0.5 | Y | Y | C |
| Example 7-10 | o-7 | 70 | 2 | In-1 | 99 | 2 | 0.7 | 1.0 | 0.5 | Y | Y | C |
| Example 7-11 | o-7 | 70 | 2 | In-1 | 397 | 2 | 0.2 | 1.0 | 0.5 | Y | Y | D |
| Example 7-12 | o-7 | 60 | 2 | In-1 | 37 | 2 | 1.6 | 1.0 | 0.5 | Y | Y | C |
| Example 7-13 | o-7 | 45 | 2 | In-1 | 37 | 2 | 1.2 | 1.0 | 0.5 | Y | Y | C |
| Example 7-14 | o-7 | 70 | 2 | In-2 | 25 | 2 | 2.8 | 1.0 | 1.6 | Y | Y | C |
| Example 7-15 | o-7 | 70 | 2 | In-3 | 41 | 2 | 1.7 | 1.0 | 1.1 | Y | Y | B |
| Example 7-16 | o-7 | 70 | 2 | In-4 | 32 | 2 | 2.2 | 1.0 | 0.1 | Y | Y | B |

(continued)

| | Organic semiconductor composition | | | | | | Mw1 / Mw2 | C1 / C2 | Difference of absolute values of SP values ($MPa^{1/2}$) | $\gamma 1 < \gamma 2$ | (UC1 / UC2) > (LC1 / LC2) | Carrier mobility |
|---|---|---|---|---|---|---|---|---|---|---|---|---|
| | Organic semiconductor polymer | | | Insulating polymer | | | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 7-17 | o-7 | 70 | 2 | In-5 | 39 | 2 | 1.8 | 1.0 | 1.1 | Y | Y | D |
| Example 7-18 | o-7 | 70 | 2 | In-6 | 41 | 2 | 1.71 | 1.0 | 0.1 | Y | Y | B |
| Example 7-19 | o-7 | 70 | 2 | In-7 | 35 | 2 | 2.00 | 1.0 | 1.1 | Y | Y | D |
| Example 7-20 | o-7 | 70 | 2 | In-8 | 185 | 2 | 0.4 | 1.0 | 0.7 | Y | Y | C |
| Example 7-21 | o-7 | 70 | 2 | In-9 | 100 | 2 | 0.7 | 1.0 | 0.6 | Y | Y | C |
| Example 7-22 | o-7 | 70 | 2 | In-10 | 79 | 2 | 0.9 | 1.0 | 0.6 | Y | Y | C |
| Example 7-23 | o-7 | 70 | 2 | In-11 | 39 | 2 | 1.8 | 1.0 | 1.7 | Y | Y | C |
| Example 7-24 | o-7 | 70 | 2 | In-12 | 77 | 2 | 0.9 | 1.0 | 6.6 | N | N | D |
| Comparative Example c7-1 | o-7 | 70 | 2 | None | - | - | - | - | - | - | - | E |
| Comparative Example c7-2 | o-7 | 70 | 2 | In-1 | 37 | 0.1 | 1.9 | 20.0 | 0.5 | Y | Y | E |
| Comparative Example c7-3 | o-7 | 70 | 2 | In-1 | 37 | 40 | 1.9 | 0.05 | 0.5 | Y | Y | F |
| Comparative Example c7-4 | o-7 | 70 | 2 | In-1 | 2.5 | 2 | 28.0 | 1.0 | 0.5 | Y | Y | F |
| Comparative Example c7-5 | o-7 | 70 | 2 | In-1 | 1.110 | 2 | 0.06 | 1.0 | 0.5 | Y | Y | F |

As presented in Table 7, in a case where the organic semiconductor layer does not contain the insulating polymer, and even in a case where the organic semiconductor layer contains the insulating polymer, but the molecular weight or the content thereof is out of the range defined in the present invention, a result in which the carrier mobility was deteriorated was obtained (Comparative Examples c7-1 to c7-5).

In contrast, in a case where the organic semiconductor layer contains the insulating polymer, and the molecular weight and the content are out of the range defined in the present invention, a result in which the carrier mobility was increased was obtained (Examples 7-1 to 7-24).

That is, in a case where the organic semiconductor layer was formed by using the organic semiconductor composition of the present invention, the performances of the obtained organic thin film transistor were able to be increased.

[Example 8 and Comparative Example c8]

In Example 1 and Comparative Example cl, bottom gate-top contact-type organic thin film transistors 8-1 to 8-24 (Examples 8-1 to 8-24) and organic thin film transistors c8-1 to c8-5 (Comparative Examples c8-1 to c8-5) for comparison were respectively manufactured in the same manner as in Example 1 and Comparative Example cl, except that the organic semiconductor polymer O-1 contained in the organic semiconductor composition used was substituted with an organic semiconductor polymer O-8. With respect to the respective obtained organic thin film transistors, in the same manner as in Test Example 1, the carrier mobility was evaluated (carrier mobility of the organic thin film transistor c8-1 was evaluated as "E"). The results thereof are presented in Table 8.

[Table 9]

Table 8

| | Organic semiconductor composition | | | | | | Mw1 / Mw2 | C1 / C2 | Difference of absolute values of SP values ($MPa^{1/2}$) | $\gamma1 < \gamma2$ | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 8-1 | o-8 | 88 | 2 | In-1 | 37 | 2 | 2.4 | 1.0 | 0.3 | Y | Y | C |
| Example 8-2 | o-8 | 88 | 2 | In-1 | 37 | 1 | 2.4 | 2.0 | 0.3 | Y | Y | B |
| Example 8-3 | o-8 | 88 | 2 | In-1 | 37 | 0.66 | 2.4 | 3.0 | 0.3 | Y | Y | C |
| Example 8-4 | o-8 | 88 | 2 | In-1 | 37 | 4 | 2.4 | 0.5 | 0.3 | Y | Y | C |
| Example 8-5 | o-8 | 88 | 2 | In-1 | 37 | 0.4 | 2.4 | 5.00 | 0.3 | Y | Y | C |
| Example 8-6 | o-8 | 88 | 2 | In-1 | 37 | 0.2 | 2.4 | 10.0 | 0.3 | Y | Y | D |
| Example 8-7 | o-8 | 88 | 2 | In-1 | 37 | 20 | 2.4 | 0.1 | 0.3 | Y | Y | D |
| Example 8-8 | o-8 | 88 | 2 | In-1 | 10 | 2 | 8.8 | 1.0 | 0.3 | Y | Y | D |
| Example 8-9 | o-8 | 88 | 2 | In-1 | 17 | 2 | 5.2 | 1.0 | 0.3 | Y | Y | C |
| Example 8-10 | o-8 | 88 | 2 | In-1 | 99 | 2 | 0.9 | 1.0 | 0.3 | Y | Y | C |
| Example 8-11 | o-8 | 88 | 2 | In-1 | 707 | 2 | 0.12 | 1.0 | 0.3 | Y | Y | D |
| Example 8-12 | o-8 | 60 | 2 | In-1 | 37 | 2 | 1.6 | 1.0 | 0.3 | Y | Y | C |
| Example 8-13 | o-8 | 50 | 2 | In-1 | 37 | 2 | 1.4 | 1.0 | 0.3 | Y | Y | C |
| Example 8-14 | o-8 | 88 | 2 | In-2 | 25 | 2 | 3.5 | 1.0 | 1.4 | Y | Y | C |
| Example 8-15 | o-8 | 88 | 2 | In-3 | 41 | 2 | 2.1 | 1.0 | 1.3 | Y | Y | C |
| Example 8-16 | o-8 | 88 | 2 | In-4 | 32 | 2 | 2.8 | 1.0 | 0.3 | Y | Y | B |

(continued)

| | Organic semiconductor composition | | | | | | Mw1 / Mw2 | C1 / C2 | Difference of absolute values of SP values ($MPa^{1/2}$) | $\gamma1 < \gamma2$ | (UC1 / UC2) > (LC1 / LC2) | Carrier mobility |
|---|---|---|---|---|---|---|---|---|---|---|---|---|
| | Organic semiconductor polymer | | | Insulating polymer | | | | | | | | |
| | Structure | Mw1 ($\times10^3$) | Concentration in composition (C1 mg/mL) | Structure | Mw2 ($\times10^3$) | Concentration in Composition (C2 mg/mL) | | | | | | |
| Example 8-17 | o-8 | 88 | 2 | In-5 | 39 | 2 | 2.3 | 1.0 | 0.9 | Y | Y | D |
| Example 8-18 | o-8 | 88 | 2 | In-6 | 41 | 2 | 2.1 | 1.0 | 0.3 | Y | Y | B |
| Example 8-19 | o-8 | 88 | 2 | In-7 | 35 | 2 | 2.5 | 1.0 | 0.9 | Y | Y | D |
| Example 8-20 | o-8 | 88 | 2 | In-8 | 185 | 2 | 0.5 | 1.0 | 0.5 | Y | Y | C |
| Example 8-21 | o-8 | 88 | 2 | In-9 | 100 | 2 | 0.9 | 1.0 | 0.8 | Y | Y | C |
| Example 8-22 | o-8 | 88 | 2 | In-10 | 79 | 2 | 1.1 | 1.0 | 0.8 | Y | Y | C |
| Example 8-23 | o-8 | 88 | 2 | In-11 | 39 | 2 | 2.3 | 1.0 | 1.9 | Y | Y | C |
| Example 8-24 | o-8 | 88 | 2 | In-12 | 77 | 2 | 1.1 | 1.0 | 6.8 | N | N | D |
| Comparative Example c8-1 | o-8 | 88 | 2 | None | - | - | - | - | - | - | - | E |
| Comparative Example c8-2 | o-8 | 88 | 2 | In-1 | 37 | 0.1 | 2.4 | 20.0 | 0.3 | Y | Y | E |
| Comparative Example c8-3 | o-8 | 88 | 2 | In-1 | 37 | 40 | 2.4 | 0.05 | 0.3 | Y | Y | F |
| Comparative Example c8-4 | o-8 | 88 | 2 | In-1 | 5.9 | 2 | 15 | 1.0 | 0.3 | Y | Y | F |
| Comparative Example c8-5 | o-8 | 88 | 2 | In-1 | 1.110 | 2 | 0.08 | 1.0 | 0.3 | Y | Y | F |

As presented in Table 8, in a case where the organic semiconductor layer does not contain the insulating polymer, and even in a case where the organic semiconductor layer contains the insulating polymer, but the molecular weight or the content thereof is out of the range defined in the present invention, a result in which the carrier mobility was deteriorated was obtained (Comparative Examples c8-1 to c8-5).

In contrast, in a case where the organic semiconductor layer contains the insulating polymer, and the molecular weight and the content are out of the range defined in the present invention, a result in which the carrier mobility was increased was obtained (Examples 8-1 to 8-24).

That is, in a case where the organic semiconductor layer was formed by using the organic semiconductor composition of the present invention, the performances of the obtained organic thin film transistor were able to be increased.

[Example 9 and Comparative Example c9]

In Example 1 and Comparative Example cl, bottom gate-top contact-type organic thin film transistors 9-1 to 9-24 (Examples 9-1 to 9-24) and organic thin film transistors c9-1 to c9-5 (Comparative Examples c9-1 to c9-5) for comparison were respectively manufactured in the same manner as in Example 1 and Comparative Example cl, except that the organic semiconductor polymer O-1 contained in the organic semiconductor composition used was substituted with an organic semiconductor polymer O-9. With respect to the respective obtained organic thin film transistors, in the same manner as in Test Example 1, the carrier mobility was evaluated (carrier mobility of the organic thin film transistor c9-1 was evaluated as "E"). The results thereof are presented in Table 9.

[Table 10]

Table 9

| | Organic semiconductor composition | | | | | | Mw1 / Mw2 | C1 / C2 | Difference of absolute values of SP values ($MPa^{1/2}$) | $\gamma 1 < \gamma 2$ | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 9-1 | o-9 | 28 | 4 | In-1 | 37 | 4 | 0.8 | 1.0 | 0.6 | Y | Y | B |
| Example 9-2 | o-9 | 28 | 4 | In-1 | 37 | 2 | 0.8 | 2.0 | 0.6 | Y | Y | B |
| Example 9-3 | o-9 | 28 | 4 | In-1 | 37 | 1.32 | 0.8 | 3.0 | 0.6 | Y | Y | B |
| Example 9-4 | o-9 | 28 | 4 | In-1 | 37 | 8 | 0.8 | 0.5 | 0.6 | Y | Y | C |
| Example 9-5 | o-9 | 28 | 4 | In-1 | 37 | 0.8 | 0.8 | 5.00 | 0.6 | Y | Y | C |
| Example 9-6 | o-9 | 28 | 4 | In-1 | 37 | 0.4 | 0.76 | 10.0 | 0.6 | Y | Y | D |
| Example 9-7 | o-9 | 28 | 4 | In-1 | 37 | 40 | 0.8 | 0.1 | 0.6 | Y | Y | D |
| Example 9-8 | o-9 | 28 | 4 | In-1 | 10 | 4 | 2.80 | 1.0 | 0.6 | Y | Y | C |
| Example 9-9 | o-9 | 28 | 4 | In-1 | 7 | 4 | 1.65 | 1.0 | 0.6 | Y | Y | B |
| Example 9-10 | o-9 | 28 | 4 | In-1 | 99 | 4 | 0.3 | 1.0 | 0.6 | Y | Y | C |
| Example 9-11 | o-9 | 28 | 4 | In-1 | 5.9 | 4 | 4.7 | 1.0 | 0.6 | Y | Y | C |
| Example 9-12 | o-9 | 35 | 4 | In-1 | 37 | 4 | 0.9 | 1.0 | 0.6 | Y | Y | B |
| Example 9-13 | o-9 | 50 | 4 | In-1 | 37 | 4 | 1.4 | 1.0 | 0.6 | Y | Y | B |
| Example 9-14 | o-9 | 28 | 4 | In-2 | 25 | 4 | 1.1 | 1.0 | 1.7 | Y | Y | B |
| Example 9-15 | o-9 | 28 | 4 | In-3 | 41 | 4 | 0.7 | 1.0 | 1.0 | Y | Y | B |
| Example 9-16 | o-9 | 28 | 4 | In-4 | 32 | 4 | 0.9 | 1.0 | 0.0 | Y | Y | B |

(continued)

| | Organic semiconductor composition | | | | | | Mw1 / Mw2 | C1 / C2 | Difference of absolute values of SP values ($MPa^{1/2}$) | $\gamma1 < \gamma2$ | (UC1 / UC2) > (LC1 / LC2) | Carrier mobility |
|---|---|---|---|---|---|---|---|---|---|---|---|---|
| | Organic semiconductor polymer | | | Insulating polymer | | | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 9-17 | o-9 | 28 | 4 | In-5 | 39 | 4 | 0.7 | 1.0 | 1.2 | Y | Y | C |
| Example 9-18 | o-9 | 28 | 4 | In-6 | 41 | 4 | 0.68 | 1.0 | 0.0 | Y | Y | B |
| Example 9-19 | o-9 | 28 | 4 | In-7 | 35 | 4 | 0.80 | 1.0 | 1.2 | Y | Y | C |
| Example 9-20 | o-9 | 28 | 4 | In-8 | 185 | 4 | 0.2 | 1.0 | 0.8 | Y | Y | B |
| Example 9-21 | o-9 | 28 | 4 | In-9 | 100 | 4 | 0.3 | 1.0 | 0.5 | Y | Y | B |
| Example 9-22 | o-9 | 28 | 4 | In-10 | 79 | 4 | 0.4 | 1.0 | 0.5 | Y | Y | B |
| Example 9-23 | o-9 | 28 | 4 | In-11 | 39 | 4 | 0.7 | 1.0 | 1.6 | Y | Y | C |
| Example 9-24 | o-9 | 28 | 4 | In-12 | 77 | 4 | 0.4 | 1.0 | 6.5 | N | N | D |
| Comparative Example c9-1 | o-9 | 28 | 4 | None | - | - | - | - | - | - | - | E |
| Comparative Example c9-2 | o-9 | 28 | 4 | In-1 | 37 | 0.2 | 0.8 | 20.0 | 0.6 | Y | Y | E |
| Comparative Example c9-3 | o-9 | 28 | 4 | In-1 | 37 | 80 | 0.8 | 0.05 | 0.6 | Y | Y | F |
| Comparative Example c9-4 | o-9 | 28 | 4 | In-1 | 2.5 | 4 | 11.2 | 1.0 | 0.6 | Y | Y | E |
| Comparative Example c9-5 | o-9 | 28 | 4 | In-1 | 1.110 | 4 | 0.03 | 1.0 | 0.6 | Y | Y | F |

As presented in Table 9, in a case where the organic semiconductor layer does not contain the insulating polymer, and even in a case where the organic semiconductor layer contains the insulating polymer, but the molecular weight or the content thereof is out of the range defined in the present invention, a result in which the carrier mobility was deteriorated was obtained (Comparative Examples c9-1 to c9-5).

In contrast, in a case where the organic semiconductor layer contains the insulating polymer, and the molecular weight and the content are out of the range defined in the present invention, a result in which the carrier mobility was increased was obtained (Examples 9-1 to 9-24).

That is, in a case where the organic semiconductor layer was formed by using the organic semiconductor composition of the present invention, the performances of the obtained organic thin film transistor were able to be increased.

[Example 10 and Comparative Example c10]

In Example 1-1 and Comparative Example cl-1, a bottom gate-top contact-type organic thin film transistor 10-1 (Example 10-1) and an organic thin film transistor c10-1 (Comparative Example c10-1) for comparison were respectively manufactured in the same manner as in Example 1-1 and Comparative Example c1-1, except that the solvent used in the organic semiconductor composition: chlorobenzene was substituted with tetralin (SP value: 19.6 $MPa^{1/2}$), and the forming of the organic semiconductor layer by spin coating was replaced by flexographic printing.

In the flexographic printing, a flexographic suitability tester F1 (trade name, manufactured by IGT Testing Systems) was used, and AFD DSH1.70% (trade name, manufactured by Asahi Kasei Corporation) / solid image was used as the flexographic resin plate. Printing was performed with the pressure between a flexographic resin plate and a substrate for forming the organic semiconductor layer of 60 N and the transportation speed of 0.4 m/sec.

Drying after flexographic printing was performed for one hour at 200°C.

With respect to the respective obtained organic thin film transistors, in the same manner as in Test Example 1, the carrier mobility was evaluated (carrier mobility of the organic thin film transistor c10-1 was evaluated as "E"). Carrier mobility of the organic thin film transistor of Example 10-1 was evaluated as "B" in the same manner as in Example 1-1.

[Example 11 and Comparative Example c11: Manufacturing of organic thin film transistors]

A bottom gate-bottom contact-type organic thin film transistor 400 illustrated in Fig. 4 was manufactured by using the organic semiconductor compositions 1-1 to 1-24 and the comparative organic semiconductor compositions c1-1 to cl-5 prepared in Preparation Example 1.

A 25 mm × 25 mm substrate on which a 350 nm thermal oxide film of $SiO_2$ was formed on the surface of a conductive n-type silicon substrate (0.7 mm thickness) was used as a substrate 212. The surface of the thermal oxide film of the substrate 212 was washed with ultraviolet (UV) / ozone and treated with β-phenytiltrimethoxysilane.

A mask was applied to a β-phenylene trimethoxysilane-treated surface of the substrate 212, and a gold electrode of 30 nm was vapor-deposited, so as to form a source electrode and a drain electrode. The respective organic semiconductor compositions prepared above were spin-coated (2,000 rpm for 90 seconds), and drying was performed at 200°C on the hot plate for one hour so as to form organic semiconductor layers (film thickness of about 20 nm), such that the organic thin film transistors 11-1 to 11-24 (Examples 11-1 to 11-24) of the present invention and the organic thin film transistors c11-1 to c11-5 (Comparative Examples c11-1 to c11-5) for comparison were manufactured.

The carrier mobility of the respective organic thin film transistors obtained above was measured in the same manner as in Test Example 1 and was evaluated (carrier mobility of the organic thin film transistor c11-1 was evaluated as "E") by the evaluation standard which is the same as Test Example 1.

The results thereof are presented in a table below.

[Table 11]

Table 10

| | Organic semiconductor composition | | | | | | Mw1 / Mw2 | C1 / C2 | Difference of absolute values of SP values ($MPa^{1/2}$) | $\gamma 1 < \gamma 2$ | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 11-1 | o-1 | 75 | 5 | In-1 | 37 | 5 | 2.0 | 1.0 | 0.5 | Y | Y | B |
| Example 11-2 | o-1 | 75 | 5 | In-1 | 37 | 2.5 | 2.0 | 2.0 | 0.5 | Y | Y | B |
| Example 11-3 | o-1 | 75 | 5 | In-1 | 37 | 1.7 | 2.0 | 2.9 | 0.5 | Y | Y | B |
| Example 11-4 | o-1 | 75 | 5 | In-1 | 37 | 10 | 2.0 | 0.5 | 0.5 | Y | Y | C |
| Example 11-5 | o-1 | 75 | 5 | In-1 | 37 | 1 | 2.0 | 5.0 | 0.5 | Y | Y | C |
| Example 11-6 | o-1 | 75 | 5 | In-1 | 37 | 0.5 | 2.0 | 10.0 | 0.5 | Y | Y | D |
| Example 11-7 | o-1 | 75 | 5 | In-1 | 37 | 50 | 2.0 | 0.10 | 0.5 | Y | Y | D |
| Example 11-8 | o-1 | 75 | 5 | In-1 | 10 | 5 | 7.5 | 1.0 | 0.5 | Y | Y | D |
| Example 11-9 | o-1 | 75 | 5 | In-1 | 17 | 5 | 4.4 | 1.0 | 0.5 | Y | Y | B |
| Example 11-10 | o-1 | 75 | 5 | In-1 | 99 | 5 | 0.8 | 1.0 | 0.5 | Y | Y | C |
| Example 11-11 | o-1 | 75 | 5 | In-1 | 707 | 5 | 0.11 | 1.0 | 0.5 | Y | Y | D |
| Example 11-12 | o-1 | 50 | 5 | In-1 | 37 | 5 | 1.4 | 1.0 | 0.5 | Y | Y | B |
| Example 11-13 | o-1 | 25 | 5 | In-1 | 37 | 5 | 0.7 | 1.0 | 0.5 | Y | Y | C |

(continued)

| | Organic semiconductor composition | | | | | | Mw1 / Mw2 | C1 / C2 | Difference of absolute values of SP values ($MPa^{1/2}$) | $\gamma$1 < $\gamma$2 | (UC1 / UC2) > (LC1 / LC2) | Carrier mobility |
|---|---|---|---|---|---|---|---|---|---|---|---|---|
| | Organic semiconductor polymer | | | Insulating | | polymer | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Example 11-14 | o-1 | 75 | 5 | In-2 | 25 | 5 | 3.0 | 1.0 | 1.6 | Y | Y | B |
| Example 11-15 | o-1 | 75 | 5 | In-3 | 41 | 5 | 1.8 | 1.0 | 1.1 | Y | Y | B |
| Example 11-16 | o-1 | 75 | 5 | In-4 | 32 | 5 | 2.3 | 1.0 | 0.1 | Y | Y | B |
| Example 11-17 | o-1 | 75 | 5 | In-5 | 39 | 5 | 1.9 | 1.0 | 1.1 | Y | Y | C |
| Example 11-18 | o-1 | 75 | 5 | In-6 | 41 | 5 | 1.8 | 1.0 | 0.1 | Y | Y | B |
| Example 11-19 | o-1 | 75 | 5 | In-7 | 35 | 5 | 2.1 | 1.0 | 1.1 | Y | Y | C |
| Example 11-20 | o-1 | 75 | 5 | In-8 | 185 | 5 | 0.4 | 1.0 | 0.7 | Y | Y | B |
| Example 11-21 | o-1 | 75 | 5 | In-9 | 100 | 5 | 0.8 | 1.0 | 0.6 | Y | Y | B |
| Example 11-22 | o-1 | 75 | 5 | In-10 | 79 | 5 | 0.9 | 1.0 | 0.6 | Y | Y | B |
| Example 11-23 | o-1 | 75 | 5 | In-11 | 39 | 5 | 1.9 | 1.0 | 1.7 | Y | Y | C |
| Example 11-24 | o-1 | 75 | 5 | In-12 | 77 | 5 | 1.0 | 1.0 | 6.6 | N | N | D |
| Comparative Example c11-1 | o-1 | 75 | 5 | None | - | - | - | - | - | - | - | E |

(continued)

| | Organic semiconductor composition | | | | | | Mw1 / Mw2 | C1 / C2 | Difference of absolute values of SP values ($MPa^{1/2}$) | $\gamma 1 < \gamma 2$ | (UC1 / UC2) > (LC1 / LC2) | Carrier mobility |
|---|---|---|---|---|---|---|---|---|---|---|---|---|
| | Organic semiconductor polymer | | | Insulating | polymer | | | | | | | |
| | Structure | Mw1 ($\times 10^3$) | Concentration in composition (C1 mg/mL) | Structure | Mw2 ($\times 10^3$) | Concentration in Composition (C2 mg/mL) | | | | | | |
| Comparative Example c11-2 | o-1 | 75 | 5 | In-1 | 37 | 0.25 | 2.0 | 20.0 | 0.5 | Y | Y | E |
| Comparative Example c11-3 | o-1 | 75 | 5 | In-1 | 37 | 100 | 2.0 | 0.05 | 0.5 | Y | Y | F |
| Comparative Example c11-4 | o-1 | 75 | 5 | In-1 | 5.9 | 5 | 12.7 | 1.0 | 0.5 | Y | Y | E |
| Comparative Example c11-5 | o-1 | 75 | 5 | In-1 | 1.110 | 5 | 0.07 | 1.0 | 0.5 | Y | Y | F |

As presented in Table 10, in a case where the organic semiconductor layer does not contain the insulating polymer and even in a case where the insulating polymer is contained, but the molecular weight or the content thereof was out of the range defined in the present invention, a result in which the carrier mobility was deteriorated was obtained (Comparative Examples c11-1 to c11-5).

In contrast, in a case where the organic semiconductor layer contains the insulating polymer and the molecular weight and the content thereof are in the range defined in the present invention, it was known that carrier mobility was excellent (Examples 11-1 to 11-24).

[Example 12 and Comparative Example c12: Manufacturing of organic thin film transistors]

A bottom gate-bottom contact-type organic thin film transistor 100 in the structure illustrated in Fig. 1 was manufactured.

A1 to be a gate electrode (thickness: 50 nm) was vapor-deposited on a glass substrate (EAGLE XG manufactured by Corning Incorporated). A propylene glycol monomethyl ether acetate (PGMEA) solution (concentration of solid content: 2 mass%)) of a gate insulating film forming composition (polyvinyl phenol / melamine = 1 part by weight / 1 part by weight (w/w) was spin-coated and was baked at 150°C for 60 minutes, so as to form a gate insulating film having a thickness of 400 nm. The surface energy of the insulating film was 45 mN/m.

Shapes of a source electrode and a drain electrode (thickness: about 100 nm, gate length: 60 μm, and gate width: 200 μm) were drawn thereon, with silver ink (silver nano-colloid H-1 (trade name), manufactured by Mitsubishi Materials Corporation) by using an ink jet device DMP-2831 (trade name, manufactured by FUJIFILM Dimatix, Inc.). Thereafter, baking was performed at 180°C in the oven for 30 minutes and sintered, so as to form a source electrode and a drain electrode. In this manner, the element precursor was obtained.

An ultraviolet (UV) / ozone treatment (manufactured by Jelight Company Inc., UVO-CLEANER Model No.42 (trade name)) was performed on an element precursor, and the surface energy of the insulating film was adjusted as presented in a table below. A bottom gate-bottom contact-type organic thin film transistor 100 illustrated in Fig. 1 was manufactured by treating an electrode surface with pentafluorothiophenol and forming organic semiconductor layers by using the organic semiconductor compositions 1-1 to 1-24 and the comparative organic semiconductor compositions c1-1 to c1-5.

[Table 12]

Table 11

| | Surface free energy of insulating film (mN/m) | Composition | Organic semiconductor composition | | | | | | Mw1 / Mw2 | C1 / C2 | Difference of absolute values of SP values ($MPa^{1/2}$) | $\gamma1 < \gamma2$ | (UC1 / UC2) > (LC1 / LC2) | Carrier mobility |
|---|---|---|---|---|---|---|---|---|---|---|---|---|---|---|
| | | | Organic semiconductor polymer | | | Insulating polymer | | | | | | | | |
| | | | Structure | Mw1 ($\times 10^3$) | Concentration in composition (C1 mg/mL) | Structure | Mw2 ($\times 10^3$) | Concentration in Composition (C2 mg/mL) | | | | | | |
| Example 12-1 | 45 | 1-1 | o-1 | 75 | 5 | In-1 | 37 | 5 | 2.0 | 1.0 | 0.5 | Y | Y | B |
| Example 12-2 | 50 | 1-1 | o-1 | 75 | 5 | In-1 | 37 | 5 | 2.0 | 1.0 | 0.5 | Y | Y | A |
| Example 12-3 | 65 | 1-1 | o-1 | 75 | 5 | In-1 | 37 | 5 | 2.0 | 1.0 | 0.5 | Y | Y | A |
| Example 12-4 | 70 | 1-1 | o-1 | 75 | 5 | In-1 | 37 | 5 | 2.0 | 1.0 | 0.5 | Y | Y | A |
| Example 12-5 | 75 | 1-1 | o-1 | 75 | 5 | In-1 | 37 | 5 | 2.0 | 1.0 | 0.5 | Y | Y | A |
| Example 12-6 | 70 | 1-2 | o-1 | 75 | 5 | In-1 | 37 | 2.5 | 2.0 | 2.0 | 0.5 | Y | Y | A |
| Example 12-7 | 70 | 1-3 | o-1 | 75 | 5 | In-1 | 37 | 1.7 | 2.0 | 2.9 | 0.5 | Y | Y | A |
| Example 12-8 | 70 | 1-4 | o-1 | 75 | 5 | In-1 | 37 | 10 | 2.0 | 0.5 | 0.5 | Y | Y | C |
| Example 12-9 | 70 | 1-5 | o-1 | 75 | 5 | In-1 | 37 | 1 | 2.0 | 5.0 | 0.5 | Y | Y | B |
| Example 12-10 | 70 | 1-6 | o-1 | 75 | 5 | In-1 | 37 | 0.5 | 2.0 | 10.0 | 0.5 | Y | Y | D |
| Example 12-11 | 70 | 1-7 | o-1 | 75 | 5 | In-1 | 37 | 50 | 2.0 | 0.10 | 0.5 | Y | Y | D |
| Example 12-12 | 70 | 1-8 | o-1 | 75 | 5 | In-1 | 10 | 5 | 7.5 | 1.0 | 0.5 | Y | Y | D |
| Example 12-13 | 70 | 1-9 | o-1 | 75 | 5 | In-1 | 17 | 5 | 4.4 | 1.0 | 0.5 | Y | Y | B |

(continued)

| | Surface free energy of insulating film (mN/m) | Composition | Organic semiconductor composition | | | | | | Mw1 / Mw2 | C1 / C2 | Difference of absolute values of SP values ($MPa^{1/2}$) | γ1 < γ2 | (UC1 / UC2) > (LC1 / LC2) | Carrier mobility |
|---|---|---|---|---|---|---|---|---|---|---|---|---|---|---|
| | | | Organic semiconductor polymer | | | Insulating polymer | | | | | | | | |
| | | | Structure | Mw1 ($\times 10^3$) | Concentration in composition (C1 mg/mL) | Structure | Mw2 ($\times 10^3$) | Concentration in Composition (C2 mg/mL) | | | | | | |
| Example 12-14 | 70 | 1-10 | o-1 | 75 | 5 | In-1 | 99 | 5 | 0.8 | 1.0 | 0.5 | Y | Y | B |
| Example 12-15 | 70 | 1-11 | o-1 | 75 | 5 | In-1 | 707 | 5 | 0.11 | 1.0 | 0.5 | Y | Y | D |
| Example 12-16 | 70 | 1-12 | o-1 | 50 | 5 | In-1 | 37 | 5 | 1.4 | 1.0 | 0.5 | Y | Y | B |
| Example 12-17 | 70 | 1-13 | o-1 | 25 | 5 | In-1 | 37 | 5 | 0.7 | 1.0 | 0.5 | Y | Y | B |
| Example 12-18 | 70 | 1-14 | o-1 | 75 | 5 | In-2 | 25 | 5 | 3.0 | 1.0 | 1.6 | Y | Y | A |
| Example 12-19 | 70 | 1-15 | o-1 | 75 | 5 | In-3 | 41 | 5 | 1.8 | 1.0 | 1.1 | Y | Y | A |
| Example 12-20 | 70 | 1-16 | o-1 | 75 | 5 | In-4 | 32 | 5 | 2.3 | 1.0 | 0.1 | Y | Y | A |
| Example 12-21 | 70 | 1-17 | o-1 | 75 | 5 | In-5 | 39 | 5 | 1.9 | 1.0 | 1.1 | Y | Y | C |
| Example 12-22 | 70 | 1-18 | o-1 | 75 | 5 | In-6 | 41 | 5 | 1.8 | 1.0 | 0.1 | Y | Y | A |
| Example 12-23 | 70 | 1-19 | o-1 | 75 | 5 | In-7 | 35 | 5 | 2.1 | 1.0 | 1.1 | Y | Y | c |
| Example 12-24 | 70 | 1-20 | o-1 | 75 | 5 | In-8 | 185 | 5 | 0.4 | 1.0 | 0.7 | Y | Y | B |

[Table 13]

Table 11 (continued)

| | Surface free energy of insulating film (mN/m) | Composition | Organic semiconductor composition | | | | | | Mw1 / Mw2 | C1 / C2 | Difference of absolute values of SP values ($MPa^{1/2}$) | $\gamma 1 < \gamma 2$ | (UC1 / UC2)> (LC1 / LC2) | Carrier mobility |
|---|---|---|---|---|---|---|---|---|---|---|---|---|---|---|
| | | | Organic semiconductor polymer | | | Insulating polymer | | | | | | | | |
| | | | Structure | Mw1 ($\times 10^3$) | Concentration in composition (C1 mg/mL) | Structure | Mw2 ($\times 10^3$) | Concentration in Composition (C2 mg/mL) | | | | | | |
| Example 12-25 | 70 | 1-21 | o-1 | 75 | 5 | In-9 | 100 | 5 | 0.8 | 1.0 | 0.6 | Y | Y | B |
| Example 12-26 | 70 | 1-22 | o-1 | 75 | 5 | In-10 | 79 | 5 | 0.9 | 1.0 | 0.6 | Y | Y | B |
| Example 12-27 | 70 | 1-23 | o-1 | 75 | 5 | In-11 | 39 | 5 | 1.9 | 1.0 | 1.7 | Y | Y | c |
| Example 12-28 | 70 | 1-24 | o-1 | 75 | 5 | In-12 | 77 | 5 | 1.0 | 1.0 | 6.6 | N | N | D |
| Comparative Example c12-1 | 45 | c1-1 | o-1 | 75 | 5 | None | - | - | - | - | - | - | - | E |
| Comparative Example c12-2 | 70 | c1-2 | o-1 | 75 | 5 | In-1 | 37 | 0.25 | 2.0 | 20.0 | 0.5 | Y | Y | E |
| Comparative Example c12-3 | 70 | c1-3 | o-1 | 75 | 5 | In-1 | 37 | 100 | 2.0 | 0.05 | 0.5 | Y | Y | F |
| Comparative Example c12-4 | 70 | c1-4 | o-1 | 75 | 5 | In-1 | 5.9 | 5 | 12.7 | 1.0 | 0.5 | Y | Y | E |
| Comparative Example c12-5 | 70 | cl-5 | o-1 | 75 | 5 | In-1 | 1.110 | 5 | 0.7 | 1.0 | 0.5 | Y | Y | F |

As presented in Table 11, in a case where the organic semiconductor layer does not contain the insulating polymer and even in a case where the insulating polymer is contained, but the molecular weight or the content thereof was out of the range defined in the present invention, a result in which the carrier mobility was deteriorated was obtained (Comparative Examples c12-1 to c12-5).

In contrast, in a case where the organic semiconductor layer contains the insulating polymer and the molecular weight and the content thereof are in the range defined in the present invention, it was known that carrier mobility was excellent (Examples 12-1 to 12-28).

[Example 13 and Comparative Example c13: Manufacturing of organic thin film transistors]

A bottom gate-bottom contact-type organic thin film transistor 100 in the structure illustrated in Fig. 1 was manufactured.

A1 to be a gate electrode (thickness: 50 nm) was vapor-deposited on a glass substrate (EAGLE XG manufactured by Corning Incorporated). A propylene glycol monomethyl ether acetate (PGMEA) solution (concentration of solid contents: 2 mass%)) of a gate insulating film forming composition (poly(styrene-co-methyl methacrylate) / pentaerythritol tetraacrylate / 1,2-octanedione, 1-[4-(phenylthio)-, 2-(O-benzoyloxime)] = 1 part by weight / 1 part by weight / 0.01 parts by weight (w/w) was spin-coated, was pre-baked at 110°C for 5 minutes, was exposed (365 nm, 100 mJ/cm2), and was posed-baked at 200°C for 60 minutes, so as to form a gate insulating film having a thickness of 400 nm. The surface energy of the insulating film was 42 mN/m.

Shapes of a source electrode and a drain electrode (thickness: about 100 nm, gate length: 60 μm, and gate width: 200 μm) were drawn thereon, with silver ink (silver nano-colloid H-1 (trade name), manufactured by Mitsubishi Materials Corporation) by using an ink jet device DMP-2831 (trade name, manufactured by FUJIFILM Dimatix, Inc.). Thereafter, baking was performed at 180°C in the oven for 30 minutes and sintered, so as to form a source electrode and a drain electrode. In this manner, the element precursor was obtained.

An ultraviolet (UV) / ozone treatment (manufactured by Jelight Company Inc., UVO-CLEANER Model No. 42) was performed on an element precursor, and the surface energy of the insulating film was adjusted. A bottom gate-bottom contact-type organic thin film transistor 100 illustrated in Fig. 1 was manufactured by treating an electrode surface with pentafluorothiophenol and forming organic semiconductor layers by using the organic semiconductor compositions 1-1 to 1-24 and the comparative organic semiconductor compositions c1-1 to cl-5.

[Table 14]

Table 12

| | Surface free energy of insulating film (mN/m) | Composition | Organic semiconductor composition | | | | | | Mw1 / Mw2 | C1 / C2 | Difference of absolute values of SP values ($MPa^{1/2}$) | $\gamma1 < \gamma2$ | (UC1 / UC2) > (LC1 / LC2) | Carrier mobility |
|---|---|---|---|---|---|---|---|---|---|---|---|---|---|---|
| | | | Organic semiconductor polymer | | | Insulating polymer | | | | | | | | |
| | | | Structure | Mw1 ($\times 10^3$) | Concentration in composition (C1 mg/mL) | Structure | Mw2 ($\times 10^3$) | Concentration in Composition (C2 mg/mL) | | | | | | |
| Example 13-1 | 42 | 1-1 | o-1 | 75 | 5 | In-1 | 37 | 5 | 2.0 | 1.0 | 0.5 | Y | Y | B |
| Example 13-2 | 50 | 1-1 | o-1 | 75 | 5 | In-1 | 37 | 5 | 2.0 | 1.0 | 0.5 | Y | Y | A |
| Example 13-3 | 70 | 1-1 | o-1 | 75 | 5 | In-1 | 37 | 5 | 2.0 | 1.0 | 0.5 | Y | Y | A |
| Example 13-4 | 75 | 1-1 | o-1 | 75 | 5 | In-1 | 37 | 5 | 2.0 | 1.0 | 0.5 | Y | Y | A |
| Example 13-5 | 70 | 1-2 | o-1 | 75 | 5 | In-1 | 37 | 2.5 | 2.0 | 2.0 | 0.5 | Y | Y | A |
| Example 13-6 | 70 | 1-3 | o-1 | 75 | 5 | In-1 | 37 | 1.7 | 2.0 | 2.9 | 0.5 | Y | Y | A |
| Example 13-7 | 70 | 1-4 | o-1 | 75 | 5 | In-1 | 37 | 10 | 2.0 | 0.5 | 0.5 | Y | Y | C |
| Example 13-8 | 70 | 1-5 | o-1 | 75 | 5 | In-1 | 37 | 1 | 2.0 | 5.0 | 0.5 | Y | Y | B |
| Example 13-9 | 70 | 1-6 | o-1 | 75 | 5 | In-1 | 37 | 0.5 | 2.0 | 10.0 | 0.5 | Y | Y | D |
| Example 13-10 | 70 | 1-7 | o-1 | 75 | 5 | In-1 | 37 | 50 | 2.0 | 0.10 | 0.5 | Y | Y | D |
| Example 13-11 | 70 | 1-8 | o-1 | 75 | 5 | In-1 | 10 | 5 | 7.5 | 1.0 | 0.5 | Y | Y | D |
| Example 13-12 | 70 | 1-9 | o-1 | 75 | 5 | In-1 | 17 | 5 | 4.4 | 1.0 | 0.5 | Y | Y | B |
| Example 13-13 | 70 | 1-10 | o-1 | 75 | 5 | In-1 | 99 | 5 | 0.8 | 1.0 | 0.5 | Y | Y | B |

(continued)

| | Surface free energy of insulating film (mN/m) | Composition | Organic semiconductor composition | | | | | | Mw1 / Mw2 | C1 / C2 | Difference of absolute values of SP values ($MPa^{1/2}$) | γ1 < γ2 | (UC1 / UC2) > (LC1 / LC2) | Carrier mobility |
|---|---|---|---|---|---|---|---|---|---|---|---|---|---|---|
| | | | Organic semiconductor polymer | | | Insulating polymer | | | | | | | | |
| | | | Structure | Mw1 ($\times 10^3$) | Concentration in composition (C1 mg/mL) | Structure | Mw2 ($\times 10^3$) | Concentration in Composition (C2 mg/mL) | | | | | | |
| Example 13-14 | 70 | 1-11 | o-1 | 75 | 5 | In-1 | 707 | 5 | 0.11 | 1.0 | 0.5 | Y | Y | D |
| Example 13-15 | 70 | 1-12 | o-1 | 50 | 5 | In-1 | 37 | 5 | 1.4 | 1.0 | 0.5 | Y | Y | B |
| Example 13-16 | 70 | 1-13 | o-1 | 25 | 5 | In-1 | 37 | 5 | 0.7 | 1.0 | 0.5 | Y | Y | B |
| Example 13-17 | 70 | 1-14 | o-1 | 75 | 5 | In-2 | 25 | 5 | 3.0 | 1.0 | 1.6 | Y | Y | A |
| Example 13-18 | 70 | 1-15 | o-1 | 75 | 5 | In-3 | 41 | 5 | 1.8 | 1.0 | 1.1 | Y | Y | A |
| Example 13-19 | 70 | 1-16 | o-1 | 75 | 5 | In-4 | 32 | 5 | 2.3 | 1.0 | 0.1 | Y | Y | A |
| Example 13-20 | 70 | 1-17 | o-1 | 75 | 5 | In-5 | 39 | 5 | 1.9 | 1.0 | 1.1 | Y | Y | c |
| Example 13-21 | 70 | 1-18 | o-1 | 75 | 5 | In-6 | 41 | 5 | 1.8 | 1.0 | 0.1 | Y | Y | A |
| Example 13-22 | 70 | 1-19 | o-1 | 75 | 5 | In-7 | 35 | 5 | 2.1 | 1.0 | 1.1 | Y | Y | C |
| Example 13-23 | 70 | 1-20 | o-1 | 75 | 5 | In-8 | 185 | 5 | 0.4 | 1.0 | 0.7 | Y | Y | B |
| Example 13-24 | 70 | 1-21 | o-1 | 75 | 5 | In-9 | 100 | 5 | 0.8 | 1.0 | 0.6 | Y | Y | B |

[Table 15]

Table 12 (continued)

| | Surface free energy of insulating film (mN/m) | Composition | Organic semiconductor composition | | | | | | Mw1 / Mw2 | C1 / C2 | Difference of absolute values of SP values ($MPa^{1/2}$) | $\gamma 1 < \gamma 2$ | (UC1 / UC2)> (LC1 / LC2) | Carrier mobility |
|---|---|---|---|---|---|---|---|---|---|---|---|---|---|---|
| | | | Organic semiconductor polymer | | | Insulating polymer | | | | | | | | |
| | | | Structure | Mw1 ($\times 10^3$) | Concentration in composition (C1 mg/mL) | Structure | Mw2 ($\times 10^3$) | Concentration in Composition (C2 mg/mL) | | | | | | |
| Example 13-25 | 70 | 1-22 | o-1 | 75 | 5 | In-10 | 79 | 5 | 0.9 | 1.0 | 0.6 | Y | Y | B |
| Example 13-26 | 70 | 1-23 | o-1 | 75 | 5 | In-11 | 39 | 5 | 1.9 | 1.0 | 1.7 | Y | Y | C |
| Example 13-27 | 70 | 1-24 | o-1 | 75 | 5 | In-12 | 77 | 5 | 1.0 | 1.0 | 6.6 | N | N | D |
| Comparative Example c13-1 | 45 | c1-1 | o-1 | 75 | 5 | None | - | - | - | - | - | - | - | E |
| Comparative Example c13-2 | 70 | c1-2 | o-1 | 75 | 5 | In-1 | 37 | 0.25 | 2.0 | 20.0 | 0.5 | Y | Y | E |
| Comparative Example c13-3 | 70 | c1-3 | o-1 | 75 | 5 | In-1 | 37 | 100 | 2.0 | 0.05 | 0.5 | Y | Y | F |
| Comparative Example c13-4 | 70 | c1-4 | o-1 | 75 | 5 | In-1 | 5.9 | 5 | 12.7 | 1.0 | 0.5 | Y | Y | E |
| Comparative Example c13-5 | 70 | c1-5 | o-1 | 75 | 5 | In-1 | 1.110 | 5 | 0.07 | 1.0 | 0.5 | Y | Y | F |

As presented in Table 12, in a case where the organic semiconductor layer does not contain the insulating polymer and even in a case where the insulating polymer is contained, but the molecular weight or the content thereof was out of the range defined in the present invention, a result in which the carrier mobility was deteriorated was obtained (Comparative Examples c13-1 to cl3-5).

In contrast, in a case where the organic semiconductor layer contains the insulating polymer and the molecular weight and the content thereof are in the range defined in the present invention, it was known that carrier mobility was excellent (Examples 13-1 to 13-27).

[Preparation Example 2: Preparation of ink compositions A and B]

The organic semiconductor polymer 0-1 synthesized above in chlorobenzene was dissolved at a concentration of 5 mg/mL, so as to obtain an ink composition A-1.

The insulating polymer I-1 synthesized above was dissolved in toluene at a concentration of 5 mg/mL, so as to obtain an ink composition B-1.

The solubility (25°C) of the insulating polymer I-1 in the ink composition A-1 was 1 mg/mL or more.

[Example 14 and Comparative Example c14: Manufacturing of organic thin film transistor]

Bottom gate-top contact-type organic thin film transistors 14-1 to 14-24 (Examples 14-1 to 14-24) and organic thin film transistors c14-1 to cl4-5 (Comparative Examples c14-1 to cl4-5) for comparison were manufactured in the same manner as in Example 1, except that the method of forming an organic semiconductor layer is changed as described below.

<Forming of organic semiconductor layers in Example 14 and Comparative Example cl4>

On the gate insulating layer, 250 μL of the ink composition B was dropwise added, and a coating film was formed by spin coating and dried at 200°C for one hour.

Subsequently, 250 μL of the ink composition A was dropwise added to the insulating polymer layer, and a coating film was formed by spin coating and dried at 200°C for one hour.

The carrier mobility of the respective organic thin film transistors obtained above was measured in the same manner as in Test Example 1 and was evaluated (carrier mobility of the organic thin film transistor c14-1 was evaluated as "E") by the evaluation standard which is the same as Test Example 1.

The results thereof are presented in a table below.

In the table below, "CT1" means a coating amount of the organic semiconductor polymer of the gate insulating layer (on the insulating polymer layer), and "CT2" means a coating amount of the insulating polymer to the gate insulating layer. That is, in practice, CT1 / CT2 is effectively matched the mass ratio (that is, C3 / C4 defined in the present invention) of the organic semiconductor polymer and the insulating polymer in the organic semiconductor layer.

[Table 16]

Table 13

| | Ink composition A (Organic semiconductor polymer) | | Ink composition B (Insulating polymer) | | Mw1 / Mw2 | CT1 / CT2 | Difference of absolute values of SP values ($MPa^{1/2}$) | $\gamma1 < \gamma2$ | (UC1 / UC2) > (LC1 / LC2) | Carrier mobility |
|---|---|---|---|---|---|---|---|---|---|---|
| | Structure | Mw1 ($\times 10^3$) | Structure | Mw2 ($\times 10^3$) | | | | | | |
| Example 14-1 | o-1 | 75 | In-1 | 37 | 2.0 | 1.0 | 0.5 | Y | Y | B |
| Example 14-2 | o-1 | 75 | In-1 | 37 | 2.0 | 2.0 | 0.5 | Y | Y | B |
| Example 14-3 | o-1 | 75 | In-1 | 37 | 2.0 | 2.9 | 0.5 | Y | Y | B |
| Example 14-4 | o-1 | 75 | In-1 | 37 | 2.0 | 0.5 | 0.5 | Y | Y | C |
| Example 14-5 | o-1 | 75 | In-1 | 37 | 2.0 | 5.0 | 0.5 | Y | Y | C |
| Example 14-6 | o-1 | 75 | In-1 | 37 | 2.0 | 10.0 | 0.5 | Y | Y | D |
| Example 14-7 | o-1 | 75 | In-1 | 37 | 2.0 | 0.10 | 0.5 | Y | Y | D |
| Example 14-8 | o-1 | 75 | In-1 | 10 | 7.5 | 1.0 | 0.5 | Y | Y | D |
| Example 14-9 | o-1 | 75 | In-1 | 17 | 4.4 | 1.0 | 0.5 | Y | Y | B |
| Example 14-10 | o-1 | 75 | In-1 | 99 | 0.8 | 1.0 | 0.5 | Y | Y | C |
| Example 14-11 | o-1 | 75 | In-1 | 707 | 0.11 | 1.0 | 0.5 | Y | Y | D |
| Example 14-11 | o-1 | 50 | In-1 | 37 | 1.35 | 1.0 | 0.5 | Y | Y | B |
| Example 14-11 | o-1 | 25 | In-1 | 37 | 0.68 | 1.0 | 0.5 | Y | Y | C |
| Comparative Example c14-1 | o-1 | 75 | None | - | - | - | - | - | - | E |
| Comparative Example c14-2 | o-1 | 75 | In-1 | 37 | 2.0 | 20.0 | 0.5 | Y | Y | E |
| Comparative Example c14-3 | o-1 | 75 | In-1 | 37 | 2.0 | 0.05 | 1.6 | Y | Y | F |
| Comparative Example c14-4 | o-1 | 75 | In-1 | 5.8 | 12.9 | 1.0 | 1.1 | Y | Y | E |
| Comparative Example c14-5 | o-1 | 75 | In-1 | 1.110 | 0.07 | 1.0 | 0.1 | Y | Y | F |

As presented in Table 13, even in a case where the organic semiconductor polymer and the insulating polymer were respectively applied to the gate insulating layer to form films, in a case where the ratio of molecular weights and the ratio of contents of the organic semiconductor polymer and the insulating polymer in the organic semiconductor layer are in the range defined in the present invention, it is considered that the carrier mobility increases.

[Example 15 and Comparative Example c15]

In Example 14-1 and Comparative Example c14-1, a bottom gate-top contact-type organic thin film transistor 15-1 (Example 15-1) and an organic thin film transistor c15-1 (Comparative Example c15-1) for comparison were respectively manufactured in the same manner as in Example 14-1 and Comparative Example c14-1, except that the solvent: toluene used in the ink composition B-1 was substituted with dichlorobenzene.

With respect to the respective obtained organic thin film transistors, as a result of evaluating the carrier mobility was (carrier mobility of the organic thin film transistor c15-1 was evaluated as "E") in the same manner as in Test Example 1, carrier mobility of the organic thin film transistor of Example 15-1 was evaluated as "B" in the same manner as in Example 14-1.

This application claims the priority based on JP2016-052066, which is filed in Japan on March 16, 2. 2016.

Explanation of References

| | |
|---|---|
| 10 | substrate |
| 20 | gate electrode |
| 30 | gate insulating layer (film) |
| 40 | source electrode |
| 42 | drain electrode |
| 50 | organic semiconductor layer (film) |
| 60 | sealing layer |
| 100, 200 | organic thin film transistor |
| 21 | silicon substrate (gate electrode) |
| 31 | thermal oxide film (gate insulating layer) |
| 41a | source electrode |
| 41b | drain electrode |
| 51 | organic semiconductor layer |
| 61 | sealing layer |
| 300, 400 | organic thin film transistor |

## Claims

**1.** An organic semiconductor composition comprising the following (a) to (c):

(a) an organic semiconductor polymer having a weight-average molecular weight of 2,000 or more;
(b) an insulating polymer having a weight-average molecular weight of 2,000 or more; and
(c) a solvent,

wherein a weight-average molecular weight Mw1 of the organic semiconductor polymer and a weight-average molecular weight Mw2 of the insulating polymer satisfy a relational expression below,

$$0.1 \leq \mathrm{Mw1} / \mathrm{Mw2} \leq 10$$

a content C1 mass% of the organic semiconductor polymer and a content C2 mass% of the insulating polymer in the organic semiconductor composition satisfy a relational expression below, and

$$0.1 \leq \mathrm{C1} / \mathrm{C2} \leq 10$$

the organic semiconductor polymer has a structural unit represented by Formula (1), and preferably has a structural unit represented by any one of Formula (2) to (5),

$$-(D-A)- \quad (1)$$

in Formula (1), D represents a group having an aromatic heterocyclic ring having a monocyclic structure or a condensed polycyclic structure which has at least one atom selected from a nitrogen atom, an oxygen atom, a sulfur atom, and a selenium atom as a ring-constituting atom or a group having a condensed polycyclic aromatic hydrocarbon ring, and preferably represents a group represented by Formula (D-1),

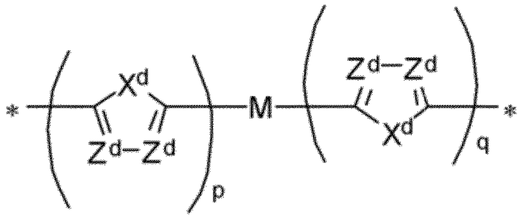

(D-1)

in Formula (D-1),

$X^d$ represents an oxygen atom, a sulfur atom, a selenium atom, or $NR^{D1}$, and $R^{D1}$ represents an organic group,
$Z^d$ represents a nitrogen atom or $CR^{D2}$, and $R^{D2}$ represents a hydrogen atom or an organic group,
M is a single bond or represents an aromatic heterocyclic group, an aromatic hydrocarbon group, an alkenylene group, an alkynylene group, or a divalent group obtained by combining two or more of these groups,
p and q each represent an integer of 0 to 4, and
* represents a bonding site to be incorporated into the structural unit represented by Formula (1), and

A represents a group having a structure represented by any one of Formulae (A-1) to (A-12),

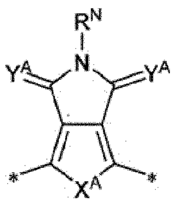
(A-1)

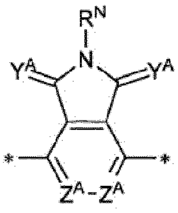
(A-2)

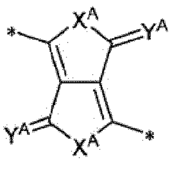
(A-3)

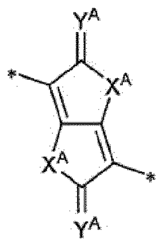
(A-4)

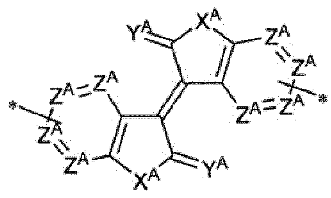
(A-5)

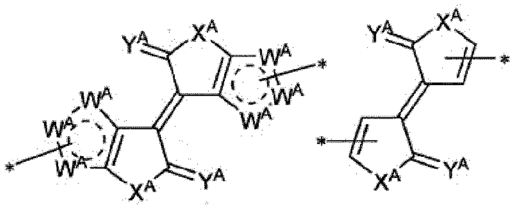
(A-6) (A-7)

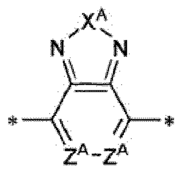
(A-8)

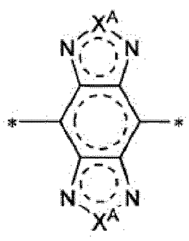
(A-9)

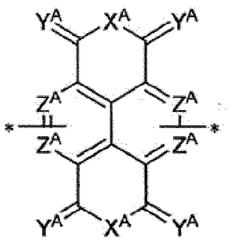

(A-10)

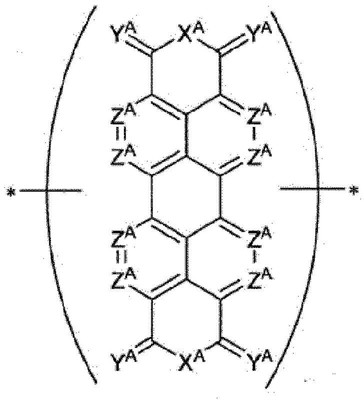

(A-11)

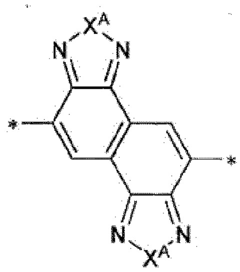

(A-12)

in Formulae (A-1) to (A-12),

$X^A$ represents an oxygen atom, a sulfur atom, a selenium atom, or $NR^X$, and $R^N$ and $R^X$ each represent an alkyl group that may include at least one of -O-, -S-, or $-NR^{A3}-$ in a carbon chain or a group represented by Formula (1-1),
$Y^A$ represents an oxygen atom or a sulfur atom,
$Z^A$ represents $CR^{A2}$ or a nitrogen atom,
$W^A$ represents $C(R^{A2})_2$, $NR^{A1}$, a nitrogen atom, $CR^{A2}$, an oxygen atom, a sulfur atom, or a selenium atom, $R^{A1}$ represents an alkyl group that may include at least one of -O-, -S-, or $-NR^{A3}-$ in a carbon chain, a group represented by Formula (1-1), or a single bond, $R^{A2}$ represents a hydrogen atom, a halogen atom, an alkyl group that may include at least one of -O-, -S-, or $-NR^{A3}-$ in a carbon chain, or a single bond, and $R^{A3}$ represents a hydrogen atom or a substituent, and
* represents a bonding site to be incorporated into A of Formula (1),

$$* - L_a - Ar - ( L_b )_l \qquad (1-1)$$

in Formula (1-1),

$L_a$ represents an alkylene group having 1 to 20 carbon atoms that may include at least one of -O-, -S-, or $-NR^{1S}-$ in a carbon chain,
Ar represents an aromatic heterocyclic group or an aromatic hydrocarbon group having 6 to 18 carbon atoms,
$L_b$ represents an alkyl group having 1 to 100 carbon atoms that may include at least one of -O-, -S-, or $-NR^{2S}-$ in the carbon chain,
$R^{1S}$ and $R^{2S}$ represent a hydrogen atom or a substituent,
1 is an integer of 1 to 5, and
* represents a bonding site,

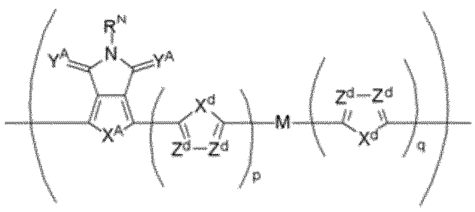

(2)

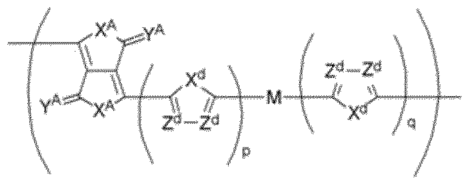

(3)

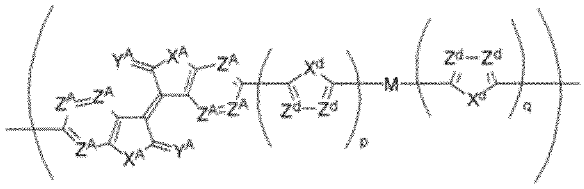

(4)

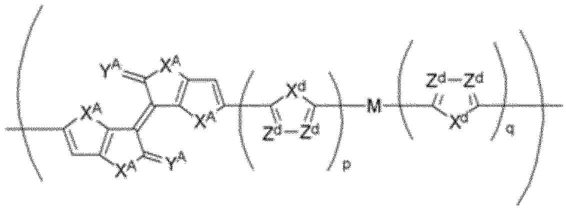

(5)

in Formulae (2) to (5),

$R^N$, $X^A$, $Y^A$, and $Z^A$ respectively have the same meaning as $R^N$, $X^A$, $Y^A$, and $Z^A$ described in Formulae (A-1) to (A-12), and
$X^d$, $Z^d$, M, p, and q respectively have the same meaning as $X^d$, $Z^d$, M, p, and q described in Formula (D-1).

**2.** The organic semiconductor composition according to claim 1,
wherein the insulating polymer has a structural unit represented by Formula (I-1),

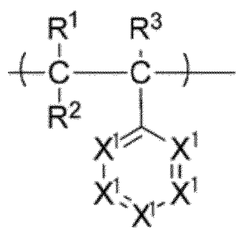

(I-1)

in Formula (I-1),

$R^1$ to $R^3$ each represent a hydrogen atom or a substituent,
$X^1$ represents $CR^{A4}$ or a nitrogen atom, and
$R^{A4}$ represents a hydrogen atom or a substituent.

**3.** The organic semiconductor composition according to claim 2,
wherein a portion or all of the structural unit represented by Formula (I-1) included in the insulating polymer is a structural unit represented by Formula (I-2),

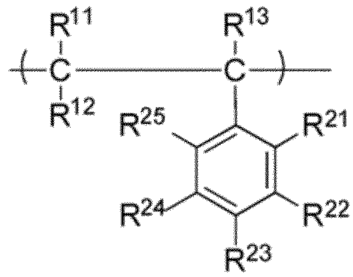

(I-2)

in Formula (1-2),

$R^{11}$ to $R^{13}$ each represent a hydrogen atom or an alkyl group, and
$R^{21}$ to $R^{25}$ each represent a hydrogen atom, a hydroxy group, an alkyl group, an alkenyl group, an alkynyl group, a cycloalkyl group, an aryl group, an aralkyl group, or a fluorine atom.

4. The organic semiconductor composition according to claim 2 or 3,
wherein an absolute value of a difference between a solubility parameter of the structural unit represented by Formula (1) and a solubility parameter of a structural unit represented by Formula (I-1) is 5.0 $MPa^{1/2}$ or less.

5. The organic semiconductor composition according to any one of claims 1 to 4,
wherein a solubility parameter of the solvent in the organic semiconductor composition is 15.0 to 30.0 $MPa^{1/2}$.

6. The organic semiconductor composition according to any one of claims 1 to 5,
wherein in a case where a viscosity of the organic semiconductor composition is set as p1, a viscosity of the composition having the composition excluding the insulating polymer from the organic semiconductor composition is set as p2, p1 / p2 < 5 is satisfied.

7. A method of manufacturing an organic thin film transistor, comprising:
forming an organic semiconductor layer by using the organic semiconductor composition according to any one of claims 1 to 6, and preferably comprising exposing a film formed by using the organic semiconductor composition according to any one of claims 1 to 6 to a temperature higher than a glass transition temperature of the insulating polymer in the composition so as to form the organic semiconductor layer .

8. The method of manufacturing an organic thin film transistor according to claim 7,
wherein the organic semiconductor layer is formed on a gate insulating layer having a surface energy of 50 mN/m to 75 mN/m.

9. A bottom gate-type organic thin film transistor,
wherein an organic semiconductor layer of the organic thin film transistor contains the following (a) and (b):

(a) an organic semiconductor polymer having a weight-average molecular weight of 2,000 or more; and
(b) an insulating polymer having a weight-average molecular weight of 2,000 or more,

a weight-average molecular weight Mw1 of the organic semiconductor polymer and a weight-average molecular weight Mw2 of the insulating polymer satisfy a relational expression below,

$$0.1 \leq Mw1 / Mw2 \leq 10$$

a content C3 mass% of the organic semiconductor polymer and a content C4 mass% of the insulating polymer in the organic semiconductor layer satisfy a relational expression below, and

$$0.1 \leq C3 / C4 \leq 10$$

the organic semiconductor polymer has a structural unit represented by Formula (1), and preferably has a structural unit represented by any one of Formula (2) to (5),

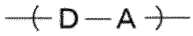

(1)

in Formula (1), D represents a group having an aromatic heterocyclic ring having a monocyclic structure or a condensed polycyclic structure which has at least one atom selected from N, O, S, and Se as a ring-constituting atom or a group having a condensed polycyclic aromatic hydrocarbon ring, and preferably represents a group represented by Formula (D-1),

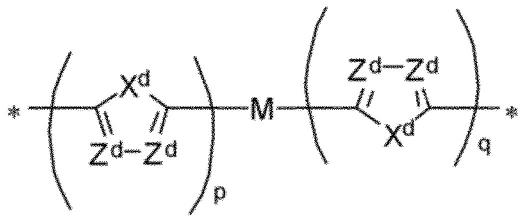

(D-1)

in Formula (D-1),

$X^d$ represents an oxygen atom, a sulfur atom, a selenium atom, or $NR^{D1}$, and $R^{D1}$ represents an organic group,
$Z^d$ represents a nitrogen atom or $CR^{D2}$, and $R^{D2}$ represents a hydrogen atom or an organic group,
M is a single bond or represents an aromatic heterocyclic group, an aromatic hydrocarbon group, an alkenylene group, an alkynylene group, or a divalent group obtained by combining two or more of these groups,
p and q each represent an integer of 0 to 4, and
* represents a bonding site to be incorporated into the structural unit represented by Formula (1), and

A represents a group having a structure represented by any one of Formulae (A-1) to (A-12),

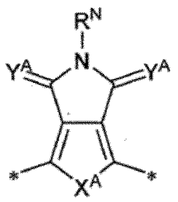

(A-1)

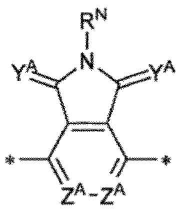

(A-2)

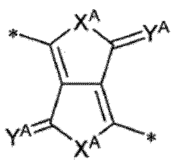

(A-3)

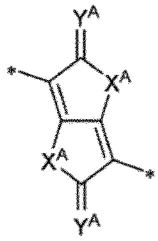

(A-4)

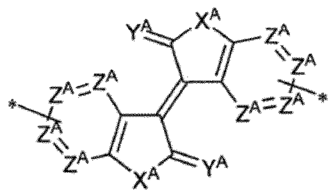

(A-5)

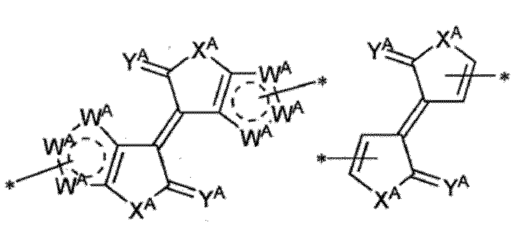

(A-6)

(A-7)

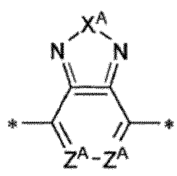

(A-8)

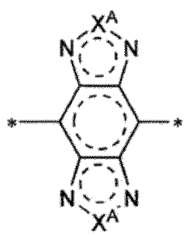

(A-9)

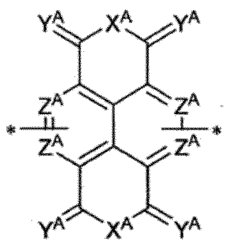

(A-10)

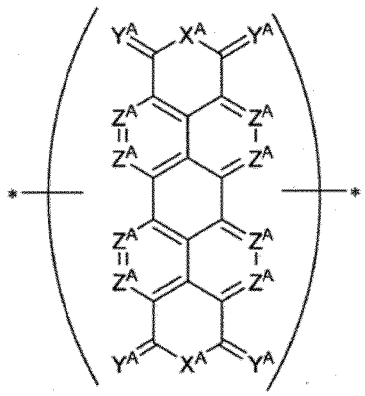

(A-11)

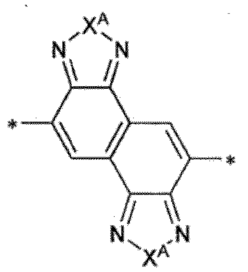

(A-12)

in Formulae (A-1) to (A-12),

$X^A$ represents an oxygen atom, a sulfur atom, a selenium atom, or $NR^X$, and $R^N$ and $R^X$ each represent an alkyl group that may include at least one of -O-, -S-, or $-NR^{A3}-$ in a carbon chain or a group represented by Formula (1-1),
$Y^A$ represents an oxygen atom or a sulfur atom,
$Z^A$ represents $CR^{A2}$ or a nitrogen atom,
$W^A$ represents $C(R^{A2})_2$, $NR^{A1}$, a nitrogen atom, $CR^{A2}$, an oxygen atom, a sulfur atom, or a selenium atom, $R^{A1}$ represents an alkyl group that may include at least one of -O-, -S-, or $-NR^{A3}-$ in a carbon chain, a group represented by Formula (1-1), or a single bond, $R^{A2}$ represents a hydrogen atom, a halogen atom, an alkyl group that may include at least one of -O-, -S-, or $-NR^{A3}-$ in a carbon chain, or a single bond, and $R^{A3}$ represents a hydrogen atom or a substituent, and
* represents a bonding site to be incorporated into A of Formula (1),

$$* - L_a - Ar - (L_b)_l \qquad (1\text{-}1)$$

in Formula (1-1),

$L_a$ represents an alkylene group having 1 to 20 carbon atoms that may include at least one of -O-, -S-, or $-NR^{1S}-$ in a carbon chain,
Ar represents an aromatic heterocyclic group or an aromatic hydrocarbon group having 6 to 18 carbon atoms,
$L_b$ represents an alkyl group having 1 to 100 carbon atoms that may include at least one of -O-, -S-, or $-NR^{2S}-$ in a carbon chain,
$R^{1S}$ and $R^{2S}$ represent a hydrogen atom or a substituent,
1 is an integer of 1 to 5, and
* represents a bonding site,

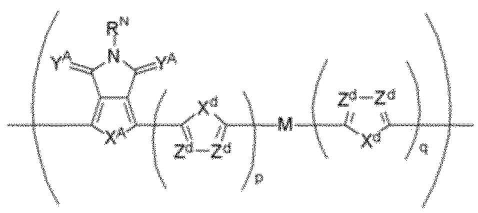

(2)

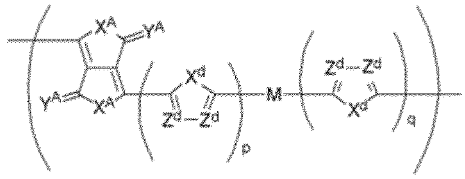

(3)

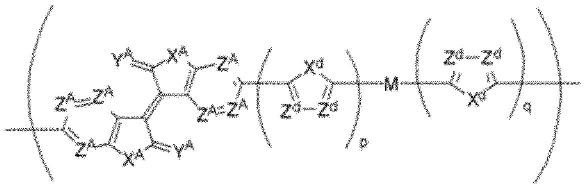

(4)

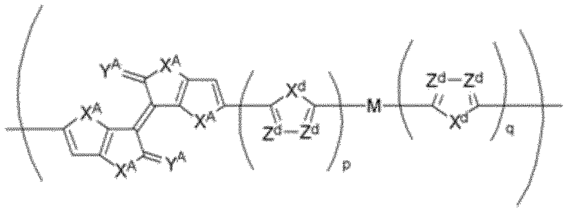

(5)

in Formulae (2) to (5),

$R^N$, $X^A$, $Y^A$, and $Z^A$ respectively have the same meaning as $R^N$, $X^A$, $Y^A$, and $Z^A$ described in Formulae (A-1) to (A-12), and
$X^d$, $Z^d$, M, p, and q respectively have the same meaning as $X^d$, $Z^d$, M, p, and q described in Formula (D-1).

**10.** The bottom gate-type organic thin film transistor according to claim 9, wherein the insulating polymer has a structural unit represented by Formula (I-1),

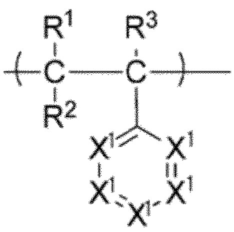

(I-1)

in Formula (I-1),

$R^1$ to $R^3$ each represent a hydrogen atom or a substituent,
$X^1$ represents $CR^{A4}$ or a nitrogen atom, and
$R^{A4}$ represents a hydrogen atom or a substituent.

**11.** The bottom gate-type organic thin film transistor according to claim 10, wherein a portion or all of the structural unit represented by Formula (I-1) included in the insulating polymer is a structural unit represented by Formula (I-2),

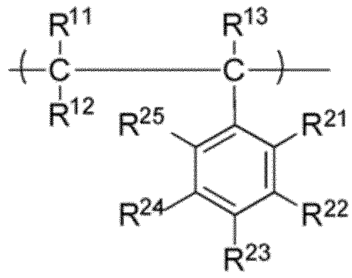

(I-2)

in Formula (1-2),

$R^{11}$ to $R^{13}$ each represent a hydrogen atom or an alkyl group, and
$R^{21}$ to $R^{25}$ each represent a hydrogen atom, a hydroxy group, an alkyl group, an alkenyl group, an alkynyl group, a cycloalkyl group, an aryl group, an aralkyl group, or a fluorine atom.

**12.** The bottom gate-type organic thin film transistor according to claim 10 or 11, wherein an absolute value of a difference between a solubility parameter of the structural unit represented by Formula (1) and a solubility parameter of a structural unit represented by Formula (I-1) is 5.0 $MPa^{1/2}$ or less.

**13.** The bottom gate-type organic thin film transistor according to any one of claims 9 to 12, wherein in a case where a surface free energy of the organic semiconductor polymer is set as $\gamma 1$ and a surface free energy of the insulating polymer is set as y2, $\gamma 1 \leq \gamma 2$ is satisfied.

**14.** The bottom gate-type organic thin film transistor according to any one of claims 9 to 13,

wherein, in a case where, at an upper half of the organic semiconductor layer, a content of the organic semiconductor polymer is set as UC1 mass% and a content of the insulating polymer is set as UC2 mass%, and at a lower half of the organic semiconductor layer, a content of the organic semiconductor polymer is set as LC1 mass% and a content of the insulating polymer is set as LC2 mass%, UC1, UC2, LC1, and LC2 satisfy (UC1 / UC2) > (LC1 / LC2).

**15.** The bottom gate-type organic thin film transistor according to any one of claims 9 to 14, wherein a surface energy of a gate insulating layer of the bottom gate-type organic thin film transistor is 50 mN/m to 75 mN/m.

**Patentansprüche**

**1.** Organische Halbleiterzusammensetzung, enthaltend die folgenden (a) bis (c):

(a) ein organisches Halbleiterpolymer mit einem Molekulargewicht im Gewichtsmittel von 2.000 oder mehr,
(b) ein isolierendes Polymer mit einem Molekulargewicht im Gewichtsmittel von 2.000 oder mehr und
(c) ein Lösungsmittel,

worin ein Molekulargewicht im Gewichtsmittel Mw1 des organischen Halbleiterpolymers und ein Molekulargewicht im Gewichtsmittel Mw2 des isolierenden Polymers folgende Beziehung erfüllen

$$0{,}1 \leq Mw1/Mw2 \leq 10$$

ein Gehalt C1 als Masse-% des organischen Halbleiterpolymers und ein Gehalt C2 als Masse-% des isolierenden Polymers in der organischen Halbleiterzusammensetzung die folgende Beziehung erfüllen

$$0{,}1 \leq C1/C2 \leq 10$$

und das organische Halbleiterpolymer eine strukturelle Einheit mit der Formel (1) und bevorzugt eine strukturelle Einheit mit einer der Formeln (2) bis (5) hat:

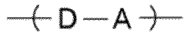 (1)

worin in der Formel(1) D eine Gruppe mit einem aromatischen heterocyclischen Ring mit einer monocyclischen Struktur oder einer kondensierten polycyclischen Struktur, die zumindest ein Atom hat, ausgewählt aus einem Stickstoffatom, Sauerstoffatom, Schwefelatom und Selenatom als Ring-konstituierendes Atom oder eine Gruppe mit einem kondensierten polycyclischen, aromatischen Kohlenwasserstoffring ist und bevorzugt eine Gruppe mit der Formel (D-1) ist

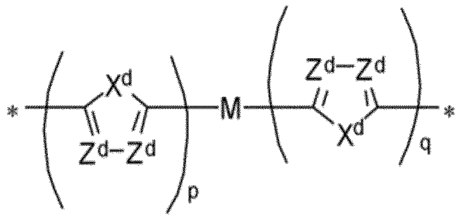 (D-1)

worin in der Formel (D-1)

$x^d$ ein Sauerstoffatom, Schwefelatom, Selenatom oder $NR^{D1}$ ist und $R^{D1}$ eine organische Gruppe ist,
$z^d$ ein Stickstoffatom oder $CR^{D2}$ ist und $R^{D2}$ ein Wasserstoffatom oder eine organische Gruppe ist,
M eine Einfachbindung ist oder eine aromatische heterocyclische Gruppe, aromatische Kohlenwasserstoffgruppe, Alkenylengruppe, Alkinylengruppe oder bivalente Gruppe ist, erhalten durch Kombinieren von zwei oder mehreren dieser Gruppen,
p und q jeweils eine ganze Zahl von 0 bis 4 sind und
* eine Bindestelle ist, die in die strukturelle Einheit mit der Formel (1) eingefügt wird und

A eine Gruppe mit einer Struktur mit einer der Formeln (A-1) bis (A-12) ist

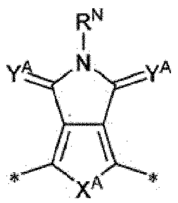
(A-1)

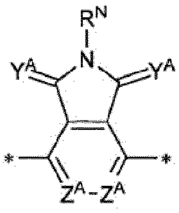
(A-2)

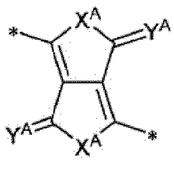
(A-3)

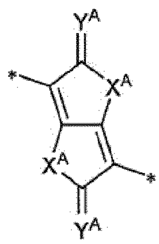
(A-4)

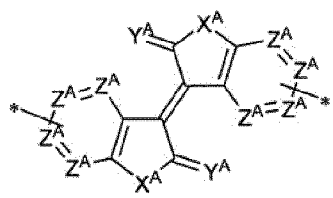
(A-5)

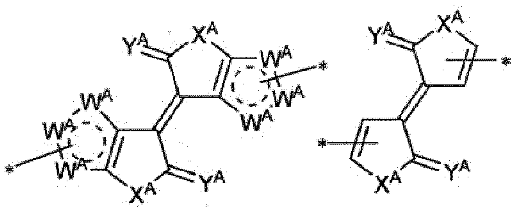
(A-6) (A-7)

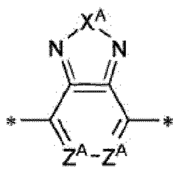
(A-8)

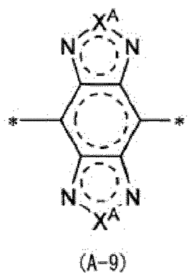
(A-9)

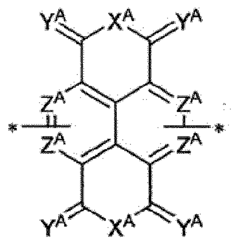

(A-10)

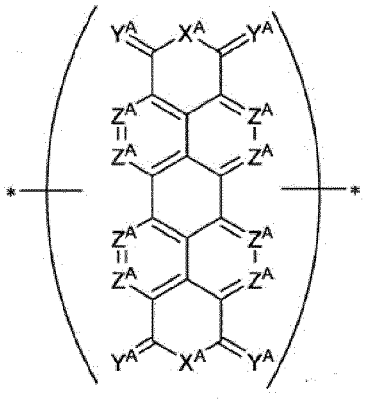

(A-11)

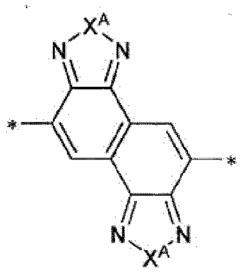

(A-12)

worin in den Formeln (A-1) bis (A-12)

$X^A$ ein Sauerstoffatom, Schwefelatom, Selenatom oder $NR^X$ ist und $R^N$ und $R^X$ jeweils eine Alkylgruppe, die zumindest eines von -O-, -S- oder $-NR^{A3}-$ in einer Kohlenstoffkette enthalten kann, oder eine Gruppe mit der Formel (1-1) sind,
$Y^A$ ein Sauerstoffatom oder Schwefelatom ist,
$Z^A$ $CR^{A2}$ oder ein Stickstoffatom ist,
$W^A$ $C(R^{A2})_2$, $NR^{A1}$, ein Stickstoffatom, $NR^{A2}$, Sauerstoffatom, Schwefelatom oder Selenatom ist, $R^{A1}$ eine Alkylgruppe, die zumindest eines von -O-, -S- oder $-NR^{A3}-$ in einer Kohlenstoffkette enthalten kann, eine Gruppe mit der Formel (1-1) oder eine Einfachbindung ist, $R^{A2}$ ein Wasserstoffatom, Halogenatom, eine Alkylgruppe, die zumindest eines
von -O-, -S- oder $-NR^{A3}-$ in einer Kohlenstoffkette enthalten kann, oder eine Einfachbindung ist und $R^{A3}$ ein Wasserstoffatom oder ein Substituent ist, und
* eine Bindestelle ist, die in A der Formel (1) eingefügt wird

$$* — L_a — Ar \left( L_b \right)_l \qquad (1\text{-}1)$$

worin in der Formel (1-1)

$L_a$ eine Alkylengruppe mit 1 bis 20 Kohlenstoffatomen ist, die zumindest eines von -O-, -S- oder $-NR^{1S}-$ in einer Kohlenstoffkette enthalten kann,
Ar eine aromatische heterocyclische Gruppe oder aromatische Kohlenwasserstoffgruppe mit 6 bis 18 Kohlenstoffatomen ist,
$L_b$ eine Alkylgruppe mit 1 bis 100 Kohlenstoffatomen ist, die zumindest eines von -O-, -S- oder $-NR^{2S}-$ in der Kohlenstoffkette enthalten kann,
$R^{1S}$ und $R^{2S}$ ein Wasserstoffatom oder ein Substituent sind,
1 eine ganze Zahl von 1 bis 5 ist und
* eine Bindestelle ist,

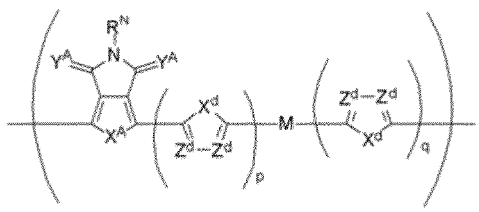

(2)

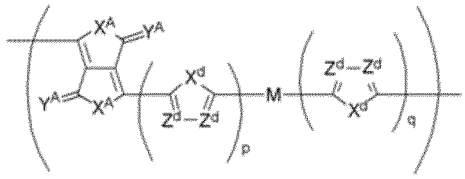

(3)

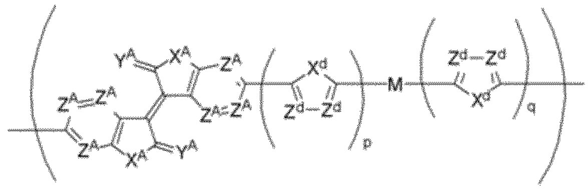

(4)

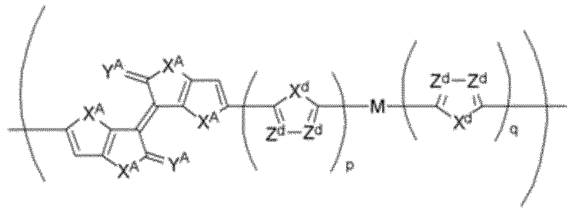

(5)

worin in den Formeln (2) bis (5)

$R^N$, $X^A$, $Y^A$ und $Z^A$ jeweils die gleichen Bedeutungen haben wie $R^N$, $X^A$, $Y^A$ und $Z^A$, die in den Formeln (A-1) bis (A-12) beschrieben sind, und
$x^d$, $z^d$, M, p und q jeweils die gleichen Bedeutungen haben wie $x^d$, $z^d$, M, p und q, die in der Formel (D-1) beschrieben sind.

**2.** Organische Halbleiterzusammensetzung gemäß Anspruch 1, worin das isolierende Polymer eine strukturelle Einheit mit der Formel (I-1) hat

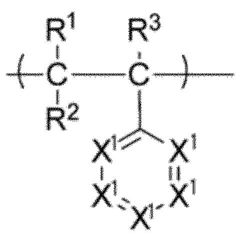

(I-1)

worin in der Formel (I-1)

$R^1$ bis $R^3$ jeweils ein Wasserstoffatom oder ein Substituent sind,
$x^1$ $CR^{A4}$ oder ein Stickstoffatom ist und
$R^{A4}$ ein Wasserstoffatom oder Substituent ist.

**3.** Organische Halbleiterzusammensetzung gemäß Anspruch 2, worin ein Bereich oder die gesamte strukturelle Einheit mit der Formel (I-1), die in dem isolierenden Polymer enthalten ist, eine strukturelle Einheit mit der Formel (I-2) ist

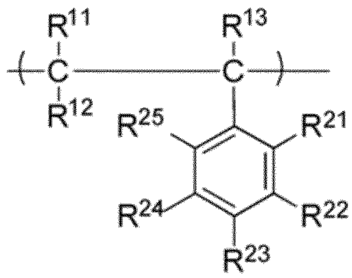

(I-2)

worin in der Formel (I-2)

$R^{11}$ bis $R^{13}$ jeweils ein Wasserstoffatom oder eine Alkylgruppe sind und
$R^{21}$ bis $R^{25}$ jeweils ein Wasserstoffatom, eine Hydroxygruppe, Alkylgruppe, Alkenylgruppe, Alkinylgruppe, Cycloalkylgruppe, Arylgruppe, Aralkylgruppe oder ein Fluoratom sind.

4. Organische Halbleiterzusammensetzung gemäß Anspruch 2 oder 3, worin ein Absolutwert eines Unterschiedes zwischen einem Löslichkeitsparameter der strukturellen Einheit mit der Formel (1) und einem Löslichkeitsparameter einer strukturellen Einheit mit der Formel (I-1) 5,0 $MPa^{1/2}$ oder weniger ist.

5. Organische Halbleiterzusammensetzung gemäß einem der Ansprüche 1 bis 4, worin ein Löslichkeitsparameter des Lösungsmittels in der organischen Halbleiterzusammensetzung 15,0 bis 30,0 $MPa^{1/2}$ ist.

6. Organische Halbleiterzusammensetzung gemäß einem der Ansprüche 1 bis 5, worin dann, wenn eine Viskosität der organischen Halbleiterzusammensetzung als p1, eine Viskosität der Zusammensetzung mit der Zusammensetzung ohne dem isolierenden Polymer von der organischen Halbleiterzusammensetzung als p2 verwendet wird, p1/p2 < 5 erfüllt ist.

7. Verfahren zur Herstellung eines organischen Dünnfilmtransistors, enthaltend:
Bilden einer organischen Halbleiterschicht durch Verwendung der organischen Halbleiterzusammensetzung gemäß einem der Ansprüche 1 bis 6 und bevorzugt enthaltend das Exponieren eines Filmes, gebildet durch Verwendung der organischen Halbleiterzusammensetzung gemäß einem der Ansprüche 1 bis 6, auf eine Temperatur, die höher ist als eine Glasübergangstemperatur des isolierenden Polymers in der Zusammensetzung, zur Bildung der organischen Halbleiterschicht.

8. Verfahren zur Herstellung eines organischen Dünnfilmtransistors gemäß Anspruch 7, worin die organische Halbleiterschicht auf einer Gate-isolierenden Schicht mit einer Oberflächenenergie von 50 mN/m bis 75 mN/m gebildet ist.

9. Organischer Dünnfilmtransistor vom Boden-Gate-Typ, worin eine organische Halbleiterschicht des organischen Dünnfilmtransistors folgendes (a) und (b) enthält:

(a) ein organisches Halbleiterpolymer mit einem Molekulargewicht im Gewichtsmittel von 2.000 oder mehr und
(b) ein isolierendes Polymer mit einem Molekulargewicht im Gewichtsmittel von 2.000 oder mehr,

wobei ein Molekulargewicht im Gewichtsmittel Mw1 des organischen Halbleiterpolymers und ein Molekulargewicht im Gewichtsmittel Mw2 des isolierenden Polymers die folgende Beziehung erfüllen

$$0{,}1 \leq Mw1/Mw2 \leq 10$$

ein Gehalt C3 als Masse-% des organischen Halbleiterpolymers und ein Gehalt C4 als Masse-% des isolierenden Polymers in der organischen Halbleiterschicht die Beziehung erfüllen

$$0{,}1 \leq C3/C4 \leq 10$$

und das organische Halbleiterpolymer eine strukturelle Einheit mit der Formel (1) und bevorzugt eine strukturelle Einheit mit einer der Formeln (2) bis (5) hat:

$$-(D-A)- \qquad (1)$$

worin in der Formel (1) D eine Gruppe mit einem aromatischen heterocyclischen Ring mit einer monocyclischen Struktur oder einer kondensierten polycyclischen Struktur, die zumindest ein Atom hat, ausgewählt aus N, O, S und Se als Ring-konstituierendes Atom oder eine Gruppe mit einem kondensierten polycyclischen, aromatischen Kohlenwasserstoffring ist und bevorzugt eine Gruppe mit der Formel (D-1) ist

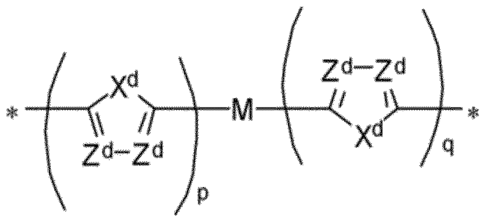

(D-1)

worin in der Formel (D-1)

$x^d$ ein Sauerstoffatom, Schwefelatom, Selenatom oder $NR^{D1}$ ist und $R^{D1}$ eine organische Gruppe ist,
$z^d$ ein Stickstoffatom oder $CR^{D2}$ ist und $R^{D2}$ ein Wasserstoffatom oder eine organische Gruppe ist,
M eine Einfachbindung ist oder eine aromatische heterocyclische Gruppe, aromatische Kohlenwasserstoffgruppe, Alkenylengruppe, Alkinylengruppe oder bivalente Gruppe ist, erhalten durch Kombinieren von zwei oder mehreren dieser Gruppen,
p und q jeweils eine ganze Zahl von 0 bis 4 sind und
* eine Bindestelle ist, die in die strukturelle Einheit mit der Formel (1) eingefügt ist, und

A eine Gruppe mit einer Struktur mit einer der Formeln (A-1) bis (A-12) ist

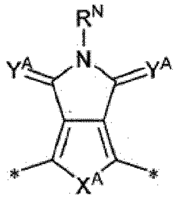

(A-1)

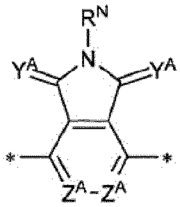

(A-2)

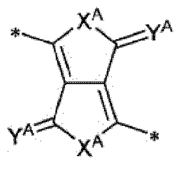

(A-3)

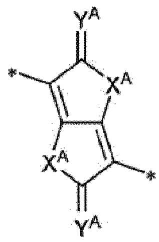

(A-4)

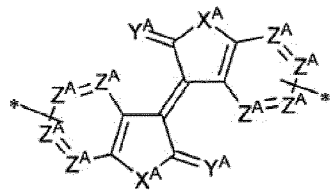

(A-5)

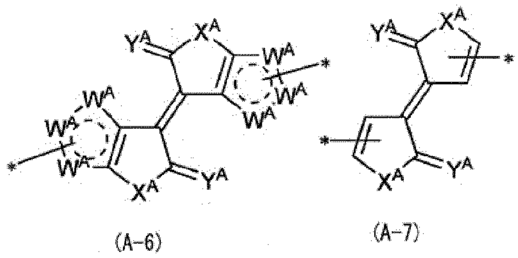

(A-6) (A-7)

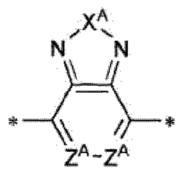

(A-8)

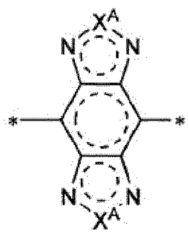

(A-9)

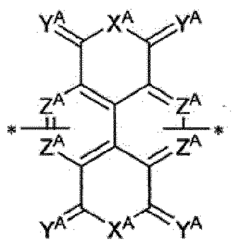

(A-10)

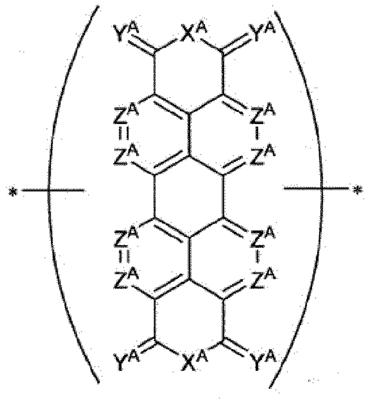

(A-11)

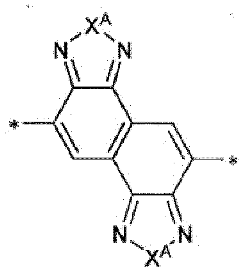

(A-12)

worin in den Formeln (A-1) bis (A-12)

$X^A$ ein Sauerstoffatom, Schwefelatom, Selenatom oder $NR^X$ ist und $R^N$ und $R^X$ jeweils eine Alkylgruppe, die zumindest eines von -O-, -S- oder $-NR^{A3}-$ in einer Kohlenstoffkette enthalten kann, oder eine Gruppe mit der Formel (1-1) sind,
$Y^A$ ein Sauerstoffatom oder Schwefelatom ist,
$Z^A$ $CR^{A2}$ oder ein Stickstoffatom ist,
$W^A$ $C(R^{A2})_2$, $NR^{A1}$, ein Stickstoffatom, $NR^{A2}$, Sauerstoffatom, Schwefelatom oder Selenatom ist, $R^{A1}$ eine Alkylgruppe, die zumindest eines von -O-, -S- oder $-NR^{A3}-$ in einer Kohlenstoffkette enthalten kann, eine Gruppe mit der Formel (1-1) oder eine Einfachbindung ist, $R^{A2}$ ein Wasserstoffatom, Halogenatom, eine Alkylgruppe, die zumindest eines von -O-, -S- oder $-NR^{A3}-$ in einer Kohlenstoffkette enthalten kann, oder eine Einfachbindung ist und $R^{A3}$ ein Wasserstoffatom oder ein Substituent ist, und
* eine Bindestelle ist, die in A der Formel (1) eingefügt ist

$$* - L_a - Ar - \left( L_b \right)_l \qquad (1\text{-}1)$$

worin in der Formel (1-1)

$L_a$ eine Alkylengruppe mit 1 bis 20 Kohlenstoffatomen ist, die zumindest eines von -O-, -S- oder $-NR^{1S}-$ in einer Kohlenstoffkette enthalten kann,
Ar eine aromatische heterocyclische Gruppe oder aromatische Kohlenwasserstoffgruppe mit 6 bis 18 Kohlenstoffatomen ist,
$L_b$ eine Alkylgruppe mit 1 bis 100 Kohlenstoffatomen ist, die zumindest eines von -O-, -S- oder $-NR^{2S}-$ in der Kohlenstoffkette enthalten kann,
$R^{1S}$ und $R^{2S}$ ein Wasserstoffatom oder ein Substituent sind,
1 eine ganze Zahl von 1 bis 5 ist und
* eine Bindestelle ist,

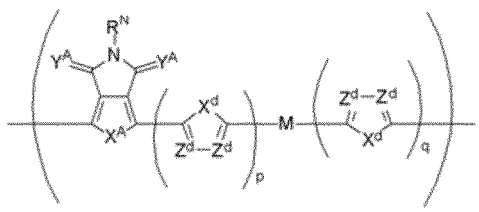

(2)

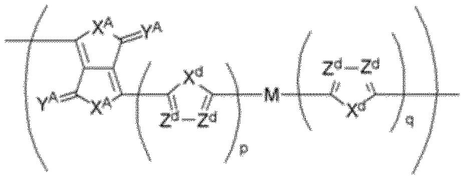

(3)

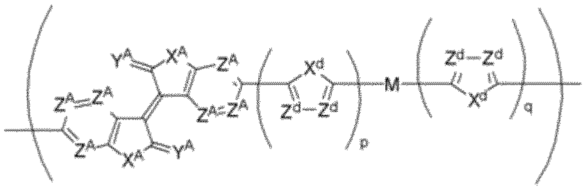

(4)

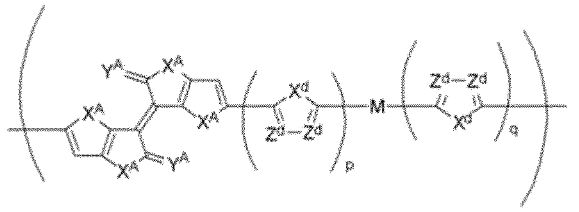

(5)

worin in den Formeln (2) bis (5)

$R^N$, $X^A$, $Y^A$ und $Z^A$ jeweils die gleichen Bedeutungen haben wie $R^N$, $X^A$, $Y^A$ und $Z^A$, die in den Formeln (A-1) bis (A-12) beschrieben sind, und
$X^d$, $Z^d$, M, p und q jeweils die gleichen Bedeutungen haben wie $X^d$, $Z^d$, M, p und q, die in der Formel (D-1) beschrieben sind.

**10.** Organischer Dünnfilmtransistor vom Boden-Gate-Typ gemäß Anspruch 9, worin das isolierende Polymer eine strukturelle Einheit mit der Formel (I-1) hat

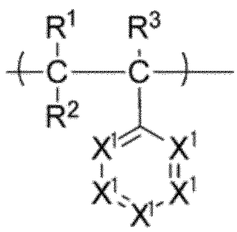

(I-1)

worin in der Formel (I-1)

$R^1$ bis $R^3$ jeweils ein Wasserstoffatom oder ein Substituent sind,
$X^1$ $CR^{A4}$ oder ein Stickstoffatom ist und
$R^{A4}$ ein Wasserstoffatom oder Substituent ist.

**11.** Organischer Dünnfilmtransistor vom Boden-Gate-Typ gemäß Anspruch 10, worin ein Bereich oder die gesamte strukturelle Einheit mit der Formel (I-1), die in dem isolierenden Polymer enthalten ist, eine strukturelle Einheit mit der Formel (I-2) ist

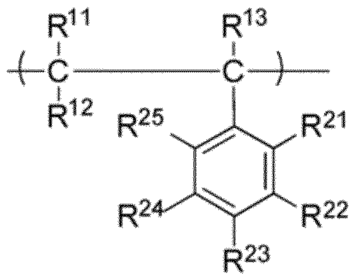

(I-2)

worin in der Formel (I-2)

$R^{11}$ bis $R^{13}$ jeweils ein Wasserstoffatom oder eine Alkylgruppe sind und
$R^{21}$ bis $R^{25}$ jeweils ein Wasserstoffatom, eine Hydroxygruppe, Alkylgruppe, Alkenylgruppe, Alkinylgruppe, Cycloalkylgruppe, Arylgruppe, Aralkylgruppe oder ein Fluoratom sind.

**12.** Organischer Dünnfilmtransistor vom Boden-Gate-Typ gemäß Anspruch 10 oder 11, worin ein Absolutwert eines Unterschiedes zwischen einem Löslichkeitsparameter der strukturellen Einheit mit der Formel (1) und einem Löslichkeitsparameter einer strukturellen Einheit mit der Formel (I-1) 5,0 $MPa^{1/2}$ oder weniger ist.

**13.** Organischer Dünnfilmtransistor vom Boden-Gate-Typ gemäß einem der Ansprüche 9 bis 12, worin dann, wenn eine freie Oberflächenenergie des organischen Halbleiterpolymers als $\gamma 1$ genommen wird und eine freie Oberflächenenergie des isolierendenden Polymers als $\gamma 2$ genommen wird, $\gamma 1 \leq \gamma 2$ erfüllt ist.

**14.** Organischer Dünnfilmtransistor vom Boden-Gate-Typ gemäß einem der Ansprüche 9 bis 13, worin dann, wenn bei einer oberen Hälfte der organischen Halbleiterschicht ein Gehalt des organischen Halbleiterpolymers als UC1-Masse-% und ein Gehalt des isolierenden Polymers als UC2-Masse-% verwendet werden und bei einer unteren Hälfte der organischen Halbleiterschicht ein Gehalt des organischen Halbleiterpolymers als LC1-Masse-% und ein Gehalt des isolierenden Polymers als LC2-Masse-% genommen werden, UC1, UC2, LC1 und LC2 (UC1/UC2)>(LC1/LC2) erfüllen.

**15.** Organischer Dünnfilmtransistor vom Boden-Gate-Typ gemäß einem der Ansprüche 9 bis 14, worin eine Oberflächenenergie einer Gate-isolierenden Schicht des organischen Dünnfilmtransistors vom Boden-Gate-Typ 50 bis 75 mN/m ist.

**Revendications**

**1.** Composition semi-conductrice organique comprenant les constituants (a) à (c) suivants :

(a) un polymère semi-conducteur organique présentant un poids moléculaire moyen en poids de 2 000 ou plus ;
(b) un polymère isolant présentant un poids moléculaire moyen en poids de 2 000 ou plus ; et
(c) un solvant,

dans lequel un poids moléculaire moyen en poids Mwl du polymère semi-conducteur organique et un poids moléculaire moyen en poids Mw2 du polymère isolant satisfont à une expression relationnelle ci-dessous,

$$0,1 \leq Mw1/Mw2 \leq 10$$

une teneur C1 en % en masse du polymère semi-conducteur organique et une teneur C2 en % en masse du polymère isolant dans la composition semi-conductrice organique satisfont à une expression relationnelle ci-dessous, et

$$0,1 \leq C1/C2 \leq 10$$

le polymère semi-conducteur organique présente une unité structurelle représentée par la formule (1), et

présente de préférence une unité structurelle représentée par l'une quelconque des formules (2) à (5),

$$-(D-A)- \qquad (1)$$

dans la formule (1), D représente un groupe présentant un cycle hétérocyclique aromatique présentant une structure monocyclique ou une structure polycyclique condensée qui présente au moins un atome choisi parmi un atome d'azote, un atome d'oxygène, un atome de soufre et un atome de sélénium en tant qu'atome constitutif de cycle ou un groupe présentant un cycle hydrocarboné aromatique polycyclique condensé, et représente de préférence un groupe représenté par la formule (D-1),

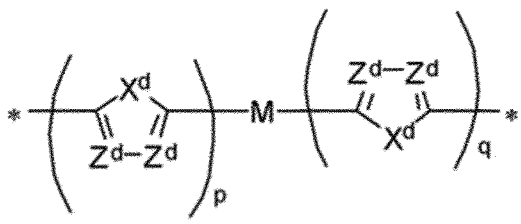
(D-1)

dans la formule (D-1),

- $X^d$ représente un atome d'oxygène, un atome de soufre, un atome de sélénium, ou $NR^{D1}$ et $R^{D1}$ représente un groupe organique,
- $Z^d$ représente un atome d'azote ou $CR^{D2}$, et $R^{D2}$ représente un atome d'hydrogène ou un groupe organique,
- M est une liaison simple ou représente un groupe hétérocyclique aromatique, un groupe hydrocarboné aromatique, un groupe alcénylène, un groupe alcynylène ou un groupe divalent obtenu en combinant deux de ces groupes ou plus,
- p et q représentent chacun un entier de 0 à 4, et
- * représente un site de liaison à incorporer dans l'unité structurelle représentée par la formule (1), et

A représente un groupe présentant une structure représentée par l'une quelconque des formules (A-1) à (A-12),

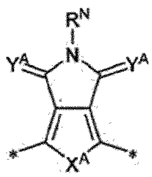
(A-1)

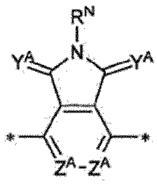
(A-2)

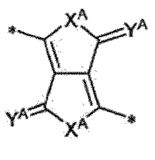
(A-3)

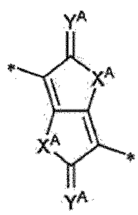
(A-4)

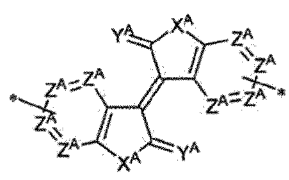
(A-5)

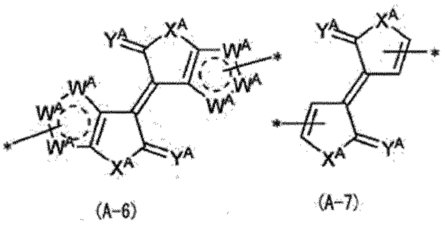
(A-6) (A-7)

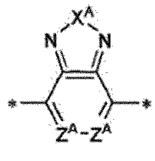
(A-8)

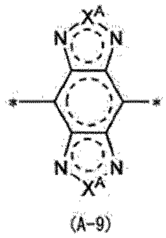
(A-9)

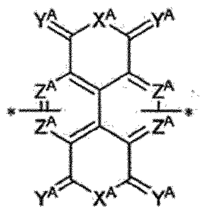

(A-10)

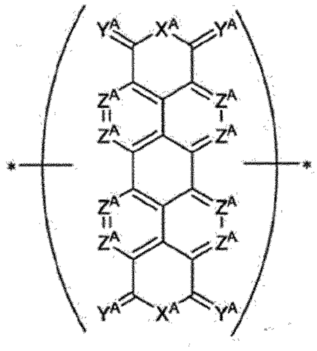

(A-11)

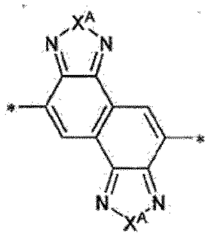

(A-12)

dans les formules (A-1) à (A-12),

$X^A$ représente un atome d'oxygène, un atome de soufre, un atome de sélénium ou $NR^X$, et $R^N$ et $R^X$ représentent chacun un groupe alkyle qui peut inclure au moins un de -O-, -S- ou $-NR^{A3}-$ dans une chaîne de carbone ou un groupe représenté par la formule (1-1), $Y^A$ représente un atome d'oxygène ou un atome de soufre,

$Z^A$ représente $CR^{A2}$ ou un atome d'azote,

$W^A$ représente $C(R^{A2})_2$, $NR^{A1}$, un atome d'azote, $CR^{A2}$, un atome d'oxygène, un atome de soufre ou un atome de sélénium, $R^{A1}$ représente un groupe alkyle qui peut inclure au moins un de -O-, -S- ou $-NR^{A3}-$ dans une chaîne de carbone, un groupe représenté par la formule (1-1) ou une liaison simple, $R^{A2}$ représente un atome d'hydrogène, un atome d'halogène, un groupe alkyle qui peut inclure au moins un de -O-, -S- ou $-NR^{A3}-$ dans une chaîne de carbone ou une liaison simple, et $R^{A3}$ représente un atome d'hydrogène ou un substituant, et

* représente un site de liaison à incorporer dans A de formule (1),

$$* — L_a — Ar -\!\!\left( L_b \right)_l \qquad (1\text{-}1)$$

dans la formule (1-1),

$L_a$ représente un groupe alkylène présentant de 1 à 20 atomes de carbone qui peut inclure au moins un de -O-, -S-, ou $-NR^{1S}-$ dans une chaîne de carbone,

Ar représente un groupe hétérocyclique aromatique ou un groupe hydrocarbure aromatique présentant de 6 à 18 atomes de carbone,

$L_b$ représente un groupe alkyle présentant de 1 à 100 atomes de carbone qui peut inclure au moins un de -O-, -S- ou $-NR^{2S}-$ dans la chaîne de carbone,

$R^{1S}$ et $R^{2S}$ représente un atome d'hydrogène ou un substituant,

1 est un entier de 1 à 5, et

* représente un site de liaison,

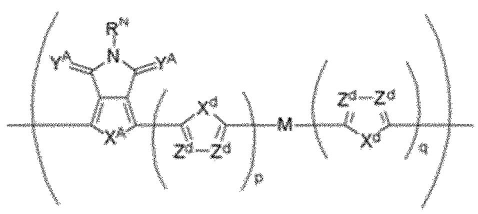

(2)

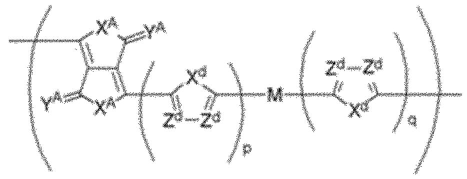

(3)

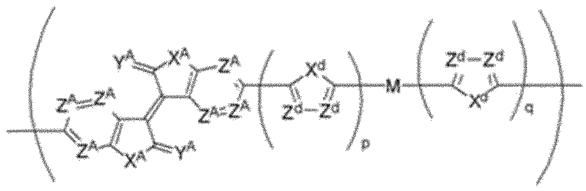

(4)

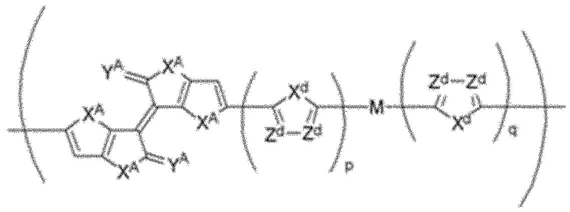

(5)

dans les formules (2) à (5),

$R^N$, $X^A$, $Y^A$ et $Z^A$ présentent respectivement la même signification que $R^N$, $X^A$, $Y^A$ et $Z^A$ décrits dans les formules (A-1) à (A-12), et
$X^d$, $Z^d$, M, p et q présentent respectivement la même signification que $X^d$, $Z^d$, M, p et q décrits dans la formule (D-1).

**2.** Composition semi-conductrice organique selon la revendication 1, dans laquelle le polymère isolant présente en outre une unité structurelle représentée par la formule (I-1),

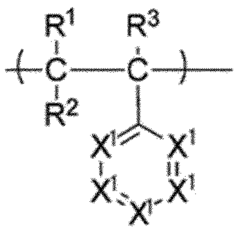

(I-1)

dans la formule (I-1),

$R^1$ à $R^3$ représentent chacun un atome d'hydrogène ou un substituant,
$X^1$ représente $CR^{A4}$ ou un atome d'azote, et
$R^{A4}$ représente un atome d'hydrogène ou un substituant.

**3.** Composition semi-conductrice organique selon la revendication 2, dans laquelle une partie ou la totalité de l'unité structurelle représentée par la formule (I-1) incluse dans le polymère isolant est une unité structurelle représentée par la formule (I-2),

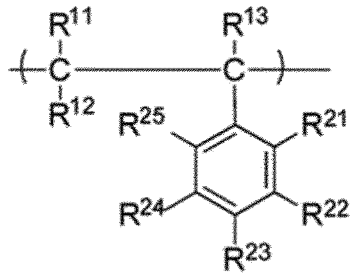

(I-2)

dans la formule (I-2),

$R^{11}$ à $R^{13}$ représentent chacun un atome d'hydrogène ou un groupe alkyle, et
$R^{21}$ à $R^{25}$ représentent chacun un atome d'hydrogène, un groupe hydroxy, un groupe alkyle, un groupe alcényle, un groupe alcynyle, un groupe cycloalkyle, un groupe aryle, un groupe aralkyle, ou un atome de fluor.

**4.** Composition semi-conductrice organique selon la revendication 2 ou 3,
dans laquelle une valeur absolue d'une différence entre un paramètre de solubilité de l'unité structurelle représentée par la formule (1) et un paramètre de solubilité d'une unité structurelle représentée par la formule (I-1) est de 5,0 $MPa^{1/2}$ ou moins.

**5.** Composition semi-conductrice organique selon l'une quelconque des revendications 1 à 4,
dans laquelle un paramètre de solubilité du solvant dans la composition semi-conductrice organique est de 15,0 à 30,0 $MPa^{1/2}$.

**6.** Composition semi-conductrice organique selon l'une quelconque des revendications 1 à 5,
dans laquelle dans un cas où une viscosité de la composition semi-conductrice organique est établie en tant que p1, une viscosité de la composition présentant la composition excluant le polymère isolant de la composition semi-conductrice organique est établie en tant que p2, $p1/p2 < 5$ est satisfaite.

**7.** Procédé de fabrication d'un transistor à couches minces organique, comprenant :
la formation d'une couche semi-conductrice organique en utilisant la composition semi-conductrice organique selon l'une quelconque des revendications 1 à 6, et comprenant de préférence une exposition d'un film formé en utilisant la composition semi-conductrice organique selon l'une quelconque des revendications 1 à 6 à une température supérieure à une température de transition vitreuse du polymère isolant dans la composition de manière à former la couche semi-conductrice organique.

**8.** Procédé de fabrication d'un transistor à couches minces organique selon la revendication 7,
dans lequel la couche semi-conductrice organique est formée sur une couche d'isolation de grille présentant une énergie de surface de 50 mN/m à 75 mN/m.

**9.** Transistor à couches minces organique du type à grille inférieure,
dans lequel une couche semi-conductrice organique du transistor à couches minces organique contient les constituants (a) et (b) suivants :

(a) un polymère semi-conducteur organique présentant un poids moléculaire moyen en poids de 2 000 ou plus ; et
(b) un polymère isolant présentant un poids moléculaire moyen en poids de 2 000 ou plus,

un poids moléculaire moyen en poids Mwl du polymère semi-conducteur organique et un poids moléculaire moyen en poids Mw2 du polymère isolant satisfont à une expression relationnelle ci-dessous,

$$0,1 \leq Mw1/Mw2 \leq 10$$

une teneur C3 en % en masse du polymère semi-conducteur organique et une teneur C4 en % en masse du polymère isolant dans la couche semi-conductrice organique satisfont à une expression relationnelle ci-dessous, et

$$0,1 \leq C3/C4 \leq 10$$

le polymère semi-conducteur organique présente une unité structurelle représentée par la formule (1), et présente de préférence une unité structurelle représentée par l'une quelconque des formules (2) à (5),

$$-(D-A)- \quad (1)$$

dans la formule (1), D représente un groupe présentant un cycle hétérocyclique aromatique présentant une structure monocyclique ou une structure polycyclique condensée qui présente au moins un atome choisi parmi N, O, S et Se en tant qu'atome constitutif de cycle ou un groupe présentant un cycle hydrocarboné aromatique polycyclique condensé, et représente de préférence un groupe représenté par la formule (D-1),

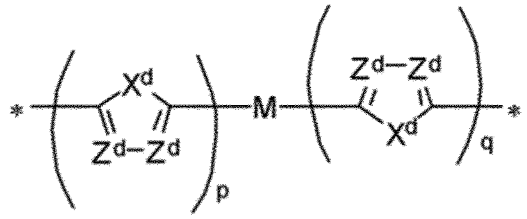

(D-1)

dans la formule (D-1),

$X^d$ représente un atome d'oxygène, un atome de soufre, un atome de sélénium, ou $NR^{D1}$ et $R^{D1}$ représente un groupe organique,
$Z^d$ représente un atome d'azote ou $CR^{D2}$, et $R^{D2}$ représente un atome d'hydrogène ou un groupe organique,
M est une liaison simple ou représente un groupe hétérocyclique aromatique, un groupe hydrocarboné aromatique, un groupe alcénylène, un groupe alcynylène ou un groupe divalent obtenu en combinant deux de ces groupes ou plus,
p et q représentent chacun un entier de 0 à 4, et
* représente un site de liaison à incorporer dans l'unité structurelle représentée par la formule (1), et

A représente un groupe présentant une structure représentée par l'une quelconque des formules (A-1) à (A-12),

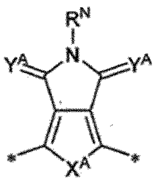

(A-1)

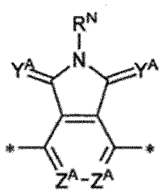

(A-2)

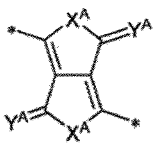

(A-3)

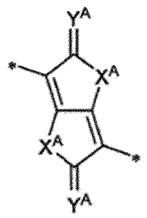

(A-4)

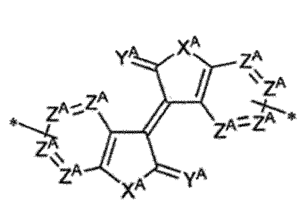

(A-5)

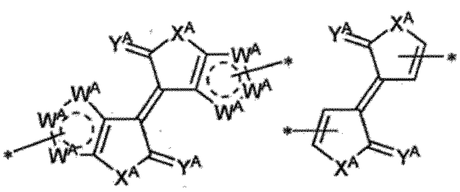

(A-6) (A-7)

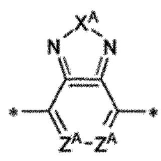

(A-8)

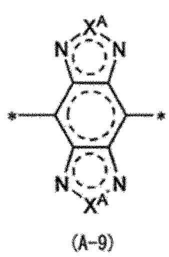

(A-9)

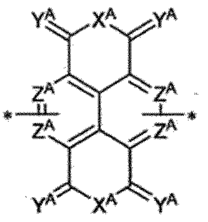

(A-10)

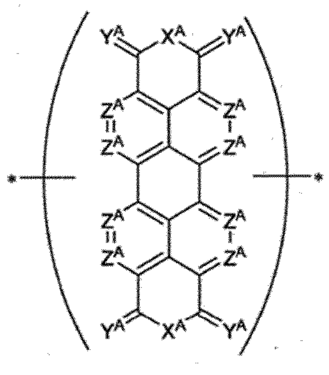

(A-11)

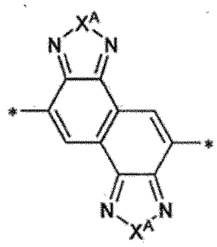

(A-12)

dans les formules (A-1) à (A-12),

$X^A$ représente un atome d'oxygène, un atome de soufre, un atome de sélénium ou $NR^X$, et $R^N$ et $R^X$ représentent chacun un groupe alkyle qui peut inclure au moins l'un de - O-, -S- ou $-NR^{A3}-$ dans une chaîne de carbone ou un groupe représenté par la formule (1-1),
$Y^A$ représente un atome d'oxygène ou un atome de soufre,
$Z^A$ représente $CR^{A2}$ ou un atome d'azote,
$W^A$ représente $C(R^{A2})_2$, $NR^{A1}$, un atome d'azote, $CR^{A2}$, un atome d'oxygène, un atome de soufre ou un atome de sélénium, $R^{A1}$ représente un groupe alkyle qui peut inclure au moins un de -O-, -S- ou $NR^{A3}-$ dans une chaîne de carbone, un groupe représenté par la formule (1-1) ou une liaison simple, $R^{A2}$ représente un atome d'hydrogène, un atome d'halogène, un groupe alkyle qui peut inclure au moins un de -O-, -S- ou $-NR^{A3}-$dans une chaîne de carbone, ou une liaison simple, et $R^{A3}$ représente un atome d'hydrogène ou un substituant, et
* représente un site de liaison à incorporer dans A de formule (1),

$$* \text{---} L_a \text{---} Ar \text{---}\left( L_b \right)_l \quad (1\text{-}1)$$

dans la formule (1-1),

$L_a$ représente un groupe alkylène présentant de 1 à 20 atomes de carbone qui peut inclure au moins un de -O-, -S-, ou $-NR^{1S}-$ dans une chaîne de carbone,
Ar représente un groupe hétérocyclique aromatique ou un groupe hydrocarboné aromatique présentant de 6 à 18 atomes de carbone,
$L_b$ représente un groupe alkyle présentant de 1 à 100 atomes de carbone qui peut inclure au moins un de -O-, -S- ou $-NR^{2S}-$ dans une chaîne de carbone,
$R^{1S}$ et $R^{2S}$ représentent un atome d'hydrogène ou un substituant, et
l est un entier de 1 à 5, et
* représente un site de liaison,

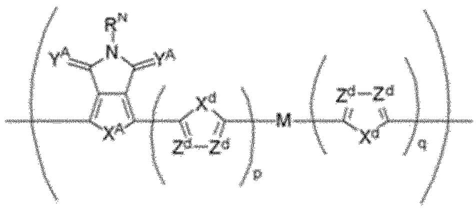

(2)

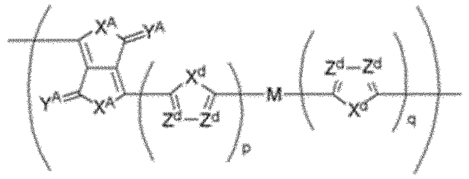

(3)

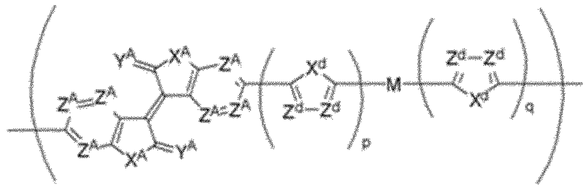

(4)

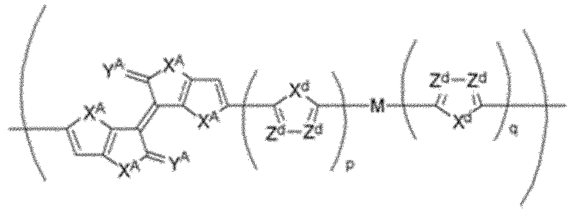

(5)

dans les formules (2) à (5),

$R^N$, $X^A$, $Y^A$ et $Z^A$ présentent respectivement la même signification que $R^N$, $X^A$, $Y^A$ et $Z^A$ décrits dans les formules (A-1) à (A-12), et
$X^d$, $Z^d$, M, p et q présentent respectivement la même signification que $X^d$, $Z^d$, M, p et q décrits dans la formule (D-1).

**10.** Transistor à couches minces organique du type à grille inférieure selon la revendication 9, dans lequel le polymère isolant présente une unité structurelle représentée par la formule (I-1),

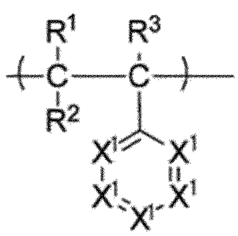

(I-1)

dans la formule (I-1),

$R^1$ à $R^3$ représentent chacun un atome d'hydrogène ou un substituant,
$X^1$ représente $CR^{A4}$ ou un atome d'azote, et
$R^{A4}$ représente un atome d'hydrogène ou un substituant.

**11.** Transistor à couches minces organique du type à grille inférieure selon la revendication 10, dans lequel une partie ou la totalité de l'unité structurelle représentée par la formule (I-1) incluse dans le polymère isolant est une unité structurelle représentée par la formule (I-2),

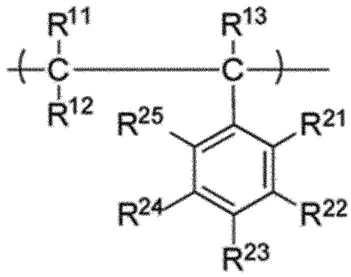

(I-2)

dans la formule (I-2),

$R^{11}$ à $R^{13}$ représentent chacun un atome d'hydrogène ou un groupe alkyle, et
$R^{21}$ à $R^{25}$ représentent chacun un atome d'hydrogène, un groupe hydroxy, un groupe alkyle, un groupe alcényle, un groupe alcynyle, un groupe cycloalkyle, un groupe aryle, un groupe aralkyle ou un atome de fluor.

**12.** Transistor à couches minces organique du type à grille inférieure selon la revendication 10 ou 11, dans lequel une valeur absolue d'une différence entre un paramètre de solubilité de l'unité structurelle représentée par la formule (1) et un paramètre de solubilité d'une unité structurelle représentée par la formule (I-1) est de 5,0 $MPa^{1/2}$ ou moins.

**13.** Transistor à couches minces organique du type à grille inférieure selon l'une quelconque des revendications 9 à 12, dans lequel dans le cas où une énergie libre de surface du polymère semi-conducteur organique est établie en tant que $\gamma 1$ et une énergie libre de surface du polymère isolant est établie en tant que $\gamma 2$, $\gamma 1 \leq \gamma 2$ est satisfaite.

**14.** Transistor à couches minces organique du type à grille inférieure selon l'une quelconque des revendications 9 à 13,

dans lequel, dans un cas où, au niveau d'une moitié supérieure de la couche semi-conductrice organique, une teneur du polymère semi-conducteur organique est établie en tant que UC1 en % en masse et une teneur du polymère isolant est établie en tant que UC2 en % en masse, et
au niveau d'une moitié inférieure de la couche semi-conductrice organique, une teneur du polymère semi-conducteur organique est établie en tant que LC1 en % de masse et une teneur du polymère isolant est établie en tant que LC2 en% de masse, UC1, UC2, LC1 et LC2 satisfont (UC1/UC2) > (LC1/LC2).

**15.** Transistor à couches minces organique du type à grille inférieure selon l'une quelconque des revendications 9 à 14, dans lequel une énergie de surface d'une couche d'isolation de grille du transistor à couches minces organique du type à grille inférieure est de 50 mN/m à 75 mN/m.

FIG. 1

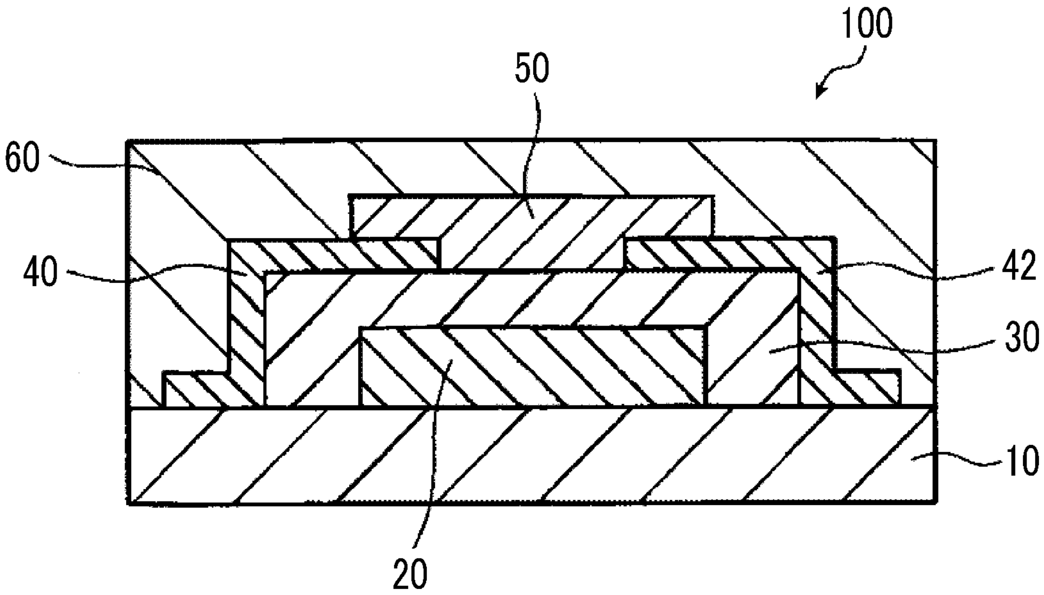


FIG. 2

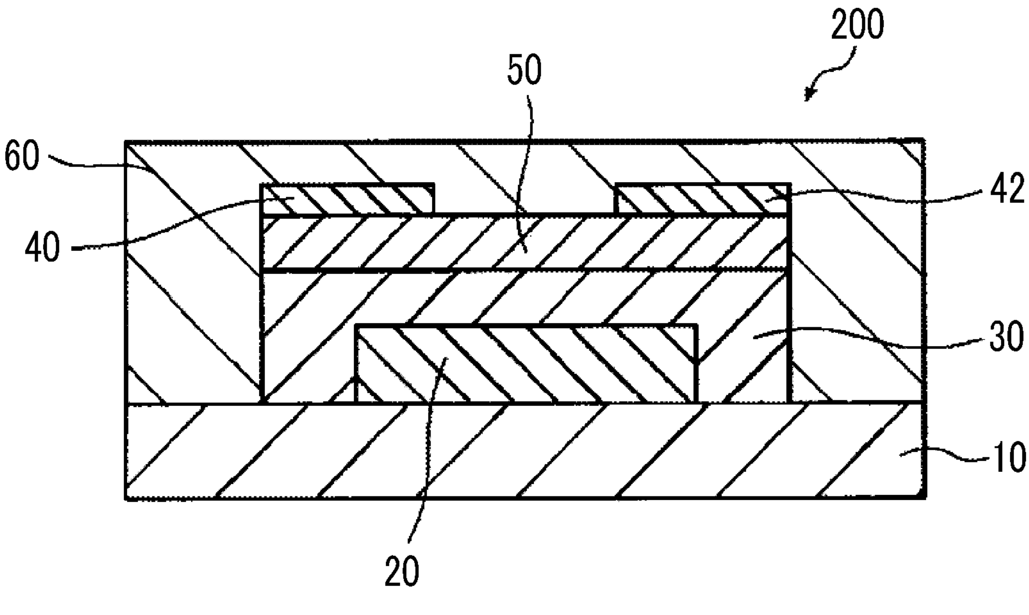

FIG. 3

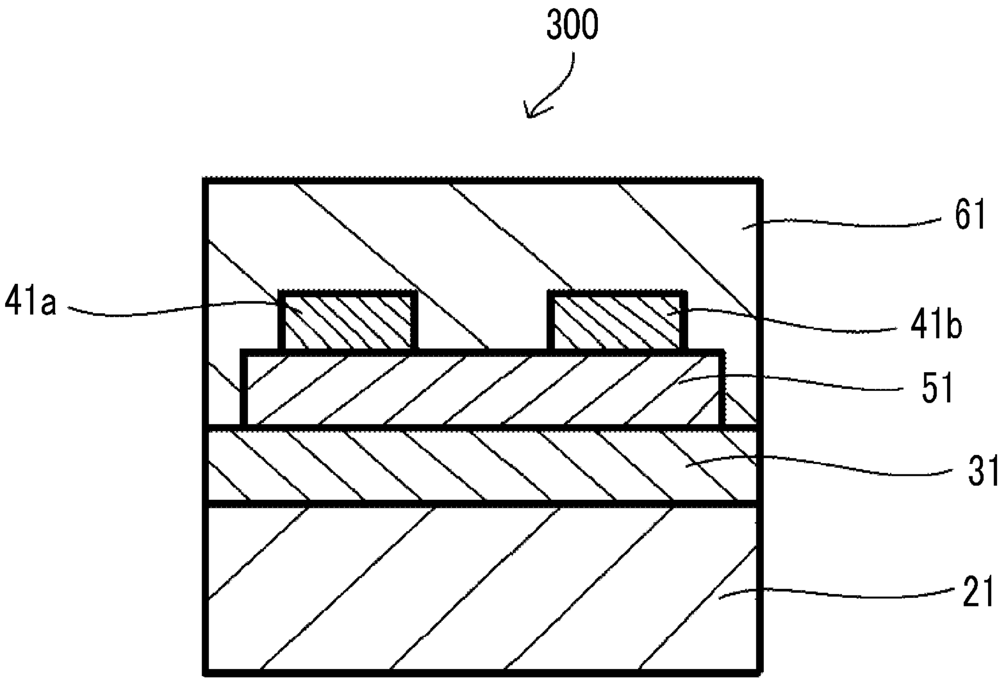


FIG. 4

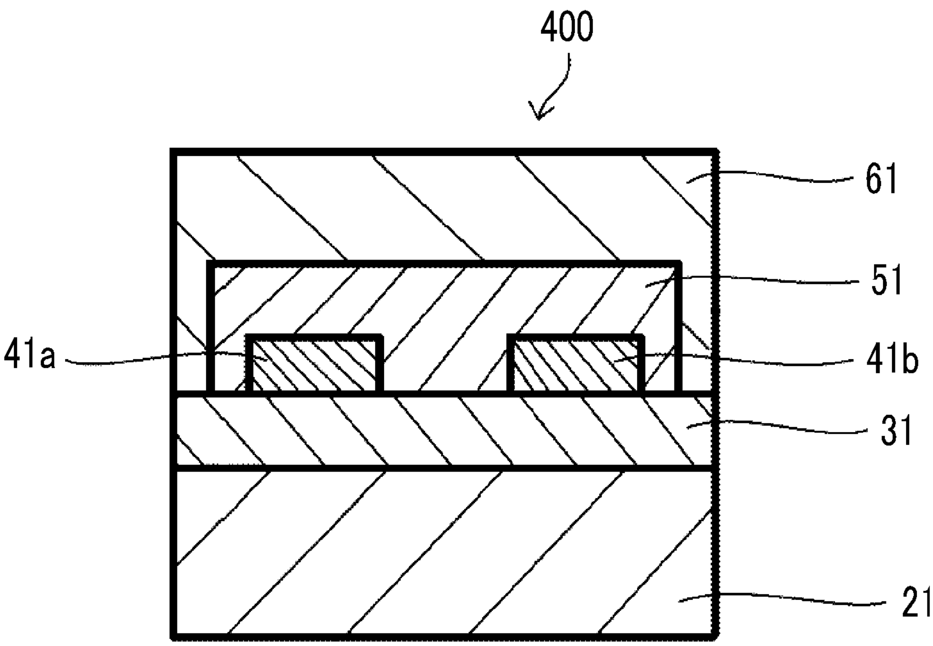

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013181071 A
- EP 2109161 A1
- WO 2011161078 A
- JP 2010527327 A
- JP 2007516315 A
- JP 2014515043 A
- JP 2014507488 A
- JP 2011501451 A
- JP 2010018790 A
- WO 2012174561 A
- JP 2011514399 A
- JP 2011514913 A
- JP 2013207085 A
- WO 2014175351 A
- JP 2013214649 A
- JP 2011186069 A
- JP 2010285518 A
- JP 2012163946 A
- JP 2005354012 A
- JP 2006303465 A
- JP 2016052066 A


### Non-patent literature cited in the description


- **C. M. HANSEN.** Hansen solubility parameter: A User's Handbook. Taylor and Francis Group, LLC, 2007
- *Tetrahedron,* 2010, vol. 66, 3173
- *Organic Electronics,* 2011, vol. 12, 993